# EUROPEAN PATENT APPLICATION

(11) **EP 4 641 299 A2**
(43) Date of publication of application: **29.10.2025**
(21) Application number: 25164397.9
(22) Date of filing: 18.03.2025
(51) Int. Cl.: G03F 7/09

(54) **COMPOSITION FOR FORMING ORGANIC FILM, METHOD FOR FORMING ORGANIC FILM, PATTERNING PROCESS, AND POLYMER**

(30) Priority: 23.04.2024 JP 2024069998
(71) Applicant: SHIN-ETSU CHEMICAL CO., LTD., Tokyo 1000005 (JP)
(72) Inventor: NIIDA, Keisuke, Niigata (JP); YAMAMOTO, Yasuyuki, Niigata (JP)
(74) Representative: Röthinger, Rainer

(57) **Abstract**

The present invention is a polymer having a repeating unit represented by the following formula (B1).

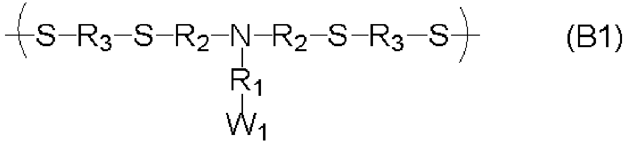

In the formula, R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group. The polymer can provide a composition for forming an organic film that has excellent film formability (in-plane uniformity) on a substrate (a wafer) and filling properties and excellent hump-reducing properties in an EBR process, and that can form an organic film having excellent process margin when used as an organic film for a multilayer resist.

## Description

### TECHNICAL FIELD

The present invention relates to a composition for forming an organic film, a method for forming an organic film, a patterning process using this composition, and a polymer.

### BACKGROUND ART

A finer pattern rule with higher integration and higher speed of semiconductor devices has been required in recent years. In such a circumstance, various technical developments have been made in lithography using light exposure, which is used as a common technology at present, about how finer and more accurate pattern is processed relative to the used light source.

As the light source for lithography used in the resist pattern formation, light exposure using a light source of g-line (436 nm) or i-line (365 nm) of a mercury lamp is widely used for portions having a low integration degree. Meanwhile, practically used for portions having a high integration degree requiring finer patterns are lithography using KrF excimer laser (248 nm) and ArF excimer laser (193 nm), which have a shorter wavelength. In the latest generation requiring a further finer pattern, lithography with extreme ultraviolet ray (EUV, 13.5 nm) is approaching the practical use.

It is well known that such a finer resist pattern increases a ratio of a pattern height to a pattern line width (an aspect ratio) in a single-layer resist method, which is used as a typical resist patterning process, leading to pattern collapse due to a surface tension of a developing liquid during development. A multilayer resist process, which stacks films having different dry-etching properties to form a pattern, is known to be excellent for forming a pattern with a high aspect ratio on a stepped substrate. There have been developments of a two-layer resist process combining: a photoresist layer (a resist upper layer film) of a silicon-containing photosensitive polymer; and a resist underlayer film of an organic polymer having carbon, hydrogen, and oxygen as major constituent elements, for example a novolac-type polymer (Patent Document 1). Also developed is a three-layer resist process combining: a photoresist layer of an organic photosensitive polymer used in the single-layer resist process; a resist middle film of a silicon-type polymer or a silicon-type CVD film; and a resist underlayer film of an organic polymer (Patent Document 2).

In this three-layer resist process, for example, an organic film such as novolac is uniformly formed on a substrate to be processed as a resist underlayer film, a silicon-containing resist middle film is formed thereon as a resist middle film, and a common organic photoresist film is formed thereon as a resist upper layer film. Since the organic resist upper layer film has good etching selectivity rate of dry etching with fluorine-type gas plasma to the silicon-containing resist middle film, the resist pattern is transferred to the silicon-containing resist middle film by using dry etching with the fluorine-type gas plasma. This method can transfer the pattern to the silicon-containing resist middle film even using a resist composition that is difficult to form a pattern having a sufficient film thickness for directly processing the substrate to be processed or even using a resist composition having insufficient dry-etching resistance for processing a substrate. A subsequent pattern transfer using dry etching with oxygen-type gas plasma can yield a pattern of an organic film (for example, a resist underlayer film such as a novolac film) having sufficient dry-etching resistance for processing.

Although many techniques about the aforementioned organic film (the organic underlayer film) have been already known (for example, Patent Document 3), excellent filling properties have been increasingly required in addition to the dry-etching properties with development of making finer in recent years. Required is an organic film material having filling properties that can uniformly form a film even on a material or base substrate to be processed having a complex shape, and that can fill an inside of the required pattern without a gap.

The organic film as noted above is formed in producing a semiconductor substrate, etc. by using a coater/developer that can perform treatments such as a spin-coating process, an edge bead removal (EBR) process, and a calcinating process. The EBR process is a process of removing a coating on an edge of the substrate (wafer) with a removing liquid after formation of the coating on the substrate by spin-coating for a purpose of preventing contamination of a substrate-conveyer arm of the coater/developer. Examples of the removing liquid used in the EBR process include a mixed liquid of propylene glycol monomethyl ether acetate and propylene glycol monomethyl ether (30 mass% : 70 mass%), and such a removing liquid is widely used in the EBR process for a resist upper layer film and a resist underlayer film (a silicon-containing resist middle film and an organic film).

The remover in the EBR process may affect an outer periphery of the organic film to form a thick state (humps). The humps cause defects in dry-etching process in the aforementioned substrate processing, and thereby an organic film having reduced humps has been required.

After the spin-coat film is formed, the organic film is subjected to a baking treatment for use in the multilayer resist process to form a cured film. The organic film is necessarily not dissolved and not melted because the silicon-containing resist middle film is applied thereon. On a surface of the organic film formed by the baking treatment, a hydrophobic surface is formed derived from a surfactant contained in the composition for forming an organic film, and coating abnormality of the silicon-containing resist middle film may be induced. To improve coatability of the silicon-containing resist middle film to broaden the process margin, controlling a contact angle of the surface of the organic film is required.

### CITATION LIST

### PATENT LITERATURE

Patent Document 1: JP H06-118651 A
Patent Document 2: JP 2005-128509 A
Patent Document 3: JP 2004-205685 A

### SUMMARY OF INVENTION

### TECHNICAL FIELD

The present invention has been made in view of the above circumstances. An object of the present invention is to provide: a composition for forming an organic film that has excellent film formability (in-plane uniformity) on a substrate (a wafer) and filling properties, excellent hump-reducing properties in an EBR process, and that can form an organic film having excellent process margin when used as an organic film for a multilayer resist; a method for forming an organic film and a patterning process that use this composition; and a polymer used for the above composition for forming an organic film.

### SOLUTION TO PROBLEM

To solve the above problem, the present invention provides a polymer including a repeating unit represented by the following formula (B1), 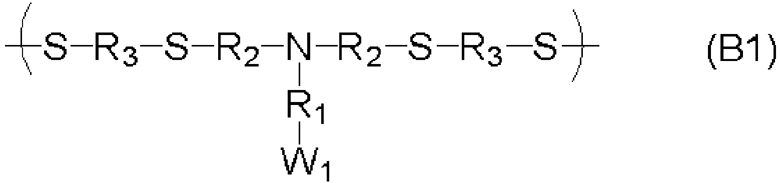 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 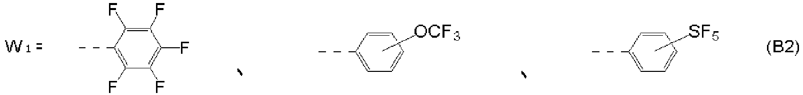 wherein a broken line represents an attachment point to R₁ in the formula (B1), and one of structures represented by the formula (B2) may be contained, or two or more of the structures may be contained.

The polymer as above is a favorable polymer for forming the organic film that has excellent in-plane uniformity and filling properties and that inhibits formation of humps due to an effect of a remover in the EBR process by combining the fluorine substituent such as the structure represented by the formula (B2).

In the present invention, R₃ in the (B1) preferably represents a group represented by the following formula (B3), 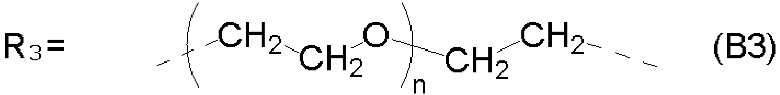 wherein a broken line represents an attachment point to a sulfur atom in the formula (B1), "n" represents 1 to 6, and one of structures represented by the formula (B3) may be contained, or two or more of the structures may be contained.

The composition for forming an organic film containing the polymer as above can further improve film formability during coating by having an appropriate amount of the fluorine content.

The polymer having the repeating unit represented by the formula (B1) is preferably a polymer represented by any one of the following general formulae (B4) to (B6), 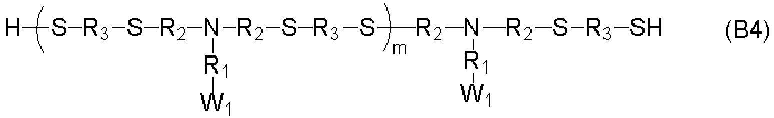 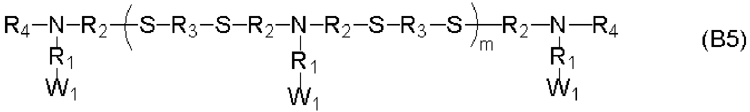 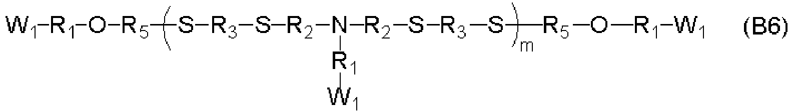 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.

The composition for forming an organic film containing the polymer as above is preferable because the organic film having more excellent in-plane uniformity can be formed.

The polymer preferably has a weight-average molecular weight of 1000 to 30000.

The weight-average molecular weight within the above range can form the organic film having excellent film formability and filling properties. Note that the weight-average molecular weight can be determined by a method described later.

Further, the present invention provides a composition for forming an organic film including:
(A) a material for forming an organic film;
(B) a polymer including a repeating unit represented by the following formula (B1); and
(C) a solvent, 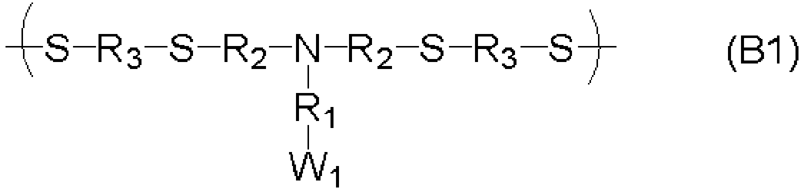 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 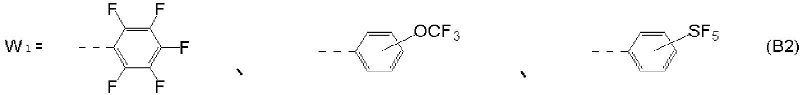 wherein a broken line represents an attachment point to R₁ in the formula (B1), and one of structures represented by the formula (B2) may be contained, or two or more of the structures may be contained.

The composition for forming an organic film can form the organic film that has excellent in-plane uniformity and filling properties and that inhibits formation of humps due to a remover in the EBR process.

In the present invention, R₃ in the formula (B1) preferably represents a group represented by the following formula (B3), 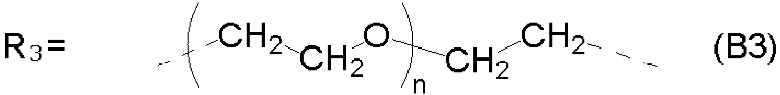 wherein a broken line represents an attachment point to a sulfur atom in the formula (B1), "n" represents 1 to 6, and one of structures represented by the formula (B3) may be contained, or two or more of the structures may be contained.

With the composition for forming an organic film as above, film formability during coating can be improved by having an appropriate fluorine content, decomposed products generated in baking do not impair the in-plane uniformity of the film, and insoluble products are not formed by a reaction, etc. between the decomposed products, etc. Thus, the above composition does not narrow the process margin when used as the organic film formation, and does not cause apparatus contamination and inconvenience.

In the present invention, (B) the polymer preferably includes one or more polymers represented by any one of the following general formulae (B4) to (B6), 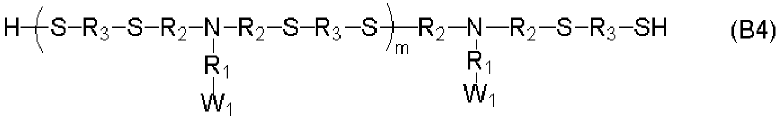 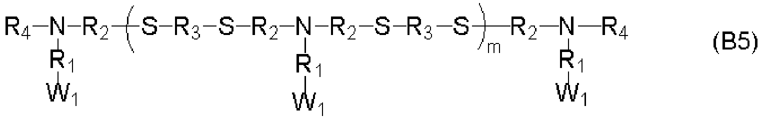 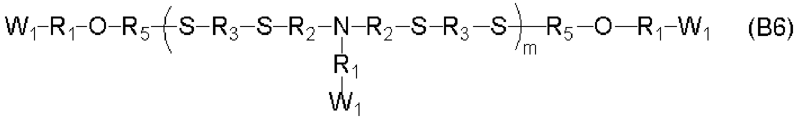 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.

The composition for forming an organic film containing the polymer as above is preferable because the organic film having more excellent in-plane uniformity can be formed.

The component (B) preferably has a weight-average molecular weight of 1000 to 30000.

The weight-average molecular weight within the above range enables to form the organic film having more excellent film formability and filling properties.

A content of the component (B) is preferably 0.01 part by mass to 5 parts by mass relative to a content of (A) the material for forming an organic film being 100 parts by mass.

The composition for forming an organic film containing the component (B) with a content as above is preferable because the in-plane uniformity of the formed organic film becomes more excellent.

In addition, the present invention provides a method for forming an organic film used in a production process of a semiconductor apparatus, the method including steps of:
applying the composition for forming an organic film of the present invention on a substrate to be processed by spin-coating to obtain a coating film; and
subjecting the coating film to a thermal treatment within a range of a temperature of 100°C or higher and 600°C or lower for 10 to 600 seconds for curing to form an organic film.

The composition for forming an organic film of the present invention is particularly useful in filling a pattern with a complex shape on the substrate to be processed by spin-coating, forming the organic film having excellent in-plane uniformity, and removing the organic film on the edge while reducing the humps in the EBR process. Therefore, the method for forming an organic film of the present invention can form the organic film having excellent film formability, excellent filling properties, and excellent hump-reducing properties in the EBR process, and further having excellent process margin when used as the organic film for the multilayer resist.

The present invention provides a patterning process including steps of:
forming an organic film on a body to be processed by using the composition for forming an organic film of the present invention;
forming a silicon-containing resist middle film on the organic film by using a silicon-containing resist middle film material;
forming a resist upper layer film on the silicon-containing resist middle film by using a resist upper layer film material including a photoresist composition;
forming a circuit pattern in the resist upper layer film, and transferring the pattern to the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

The present invention provides a patterning process including steps of:
forming an organic film on a body to be processed by using the composition for forming an organic film of the present invention;
forming a silicon-containing resist middle film on the organic film by using a silicon-containing resist middle film material, and forming an organic anti-reflective film or an adhesion film on the silicon-containing resist middle film;
forming a resist upper layer film on the organic anti-reflective film or the adhesion film by using a resist upper layer film material including a photoresist composition, and forming a circuit pattern in the resist upper layer film;
transferring the pattern to the organic anti-reflective film or the adhesion film and the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

The present invention provides a patterning process including steps of:
forming an organic film on a body to be processed by using the composition for forming an organic film of the present invention;
forming an inorganic hard mask middle film selected from the group consisting of a silicon oxide film, a silicon nitride film, and a silicon oxynitride film on the organic film;
forming a resist upper layer film on the inorganic hard mask middle film by using a resist upper layer film material including a photoresist composition;
forming a circuit pattern in the resist upper layer film;
transferring the pattern to the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask.

In addition, the present invention provides a patterning process including steps of:
forming an organic film on a body to be processed by using the composition for forming an organic film of the present invention;
forming an inorganic hard mask middle film selected from the group consisting of a silicon oxide film, a silicon nitride film, and a silicon oxynitride film on the organic film
forming an organic anti-reflective film or an adhesion film on the inorganic hard mask middle film, and forming a resist upper layer film on the organic anti-reflective film or the adhesion film by using a resist upper layer film material including a photoresist composition;
forming a circuit pattern in the resist upper layer film;
transferring the pattern to the organic anti-reflective film or the adhesion film and the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask.

As above, the composition for forming an organic film of the present invention can be suitably used for various patterning processes such as: the three-layer resist process using the silicon-containing resist middle film or the inorganic hard mask middle film; and the four-layer resist process additionally using the organic anti-reflective film or the adhesion film. The patterning process of the present invention as above can transfer and form the circuit pattern in the resist upper layer film to the body to be processed with high accuracy.

The inorganic hard mask middle film is preferably formed by a CVD method or an ALD method.

In the patterning process of the present invention, the inorganic hard mask middle film can be formed by such a method as above, for example.

The circuit pattern is preferably formed by lithography using light having a wavelength of 10 nm or longer and 300 nm or shorter, direct writing with electron beam, nanoimprinting, or a combination thereof.

In forming the circuit pattern, the circuit pattern is preferably developed with alkaline development or an organic solvent.

In the patterning process of the present invention, the forming means and the development means for the circuit pattern as above can be suitably used.

The body to be processed is preferably a semiconductor apparatus substrate, or a substrate in which any of a metal film, a metal carbide film, a metal oxide film, a metal nitride film, a metal oxycarbide film, and a metal oxynitride film is formed on the semiconductor apparatus substrate.

In this case, a body to be processed in which a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof is preferably used as the body to be processed.

With the patterning process of the present invention, the body to be processed as above can be processed to form a pattern.

### ADVANTAGEOUS EFFECTS OF INVENTION

As described above, the present invention can provides: the composition for forming an organic film that has excellent film formability (in-plane uniformity) on a substrate (a wafer) and filling properties, excellent film formability of the middle film on the organic film when used as the organic film, and excellent hump-reducing properties in an EBR process; and the polymer contained in this composition. The composition for forming an organic film of the present invention has excellent film formability and filling properties and excellent reducing properties of hump generation during the EBR process, and is thereby extremely useful as the organic film material or the material for forming an organic film for semiconductor apparatus production that are used for the multilayer resist process such as, for example: the two-layer resist process; the three-layer resist process using the silicon-containing resist middle film or the inorganic hard mask middle film; or the four-layer resist process using the silicon-containing resist middle film or the inorganic hard mask middle film and the organic anti-reflective film or the adhesion film. The method for forming an organic film of the present invention enables to form the organic film with reduced humps, and thereby the semiconductor devices, etc. can be efficiently produced. Setting the polymer of the present invention to have the PEG structure and have the specific fluorine substituent exhibits the above properties, and thereby the polymer of the present invention is useful for the composition for forming an organic film.

### BRIEF DESCRIPTION OF DRAWINGS

FIG. 1 is an explanatory view for an example of the patterning process with the three-layer resist process of the present invention;
FIG. 2 is an example of a graph for measuring a height of a hump by using a contact-type profiler in Example 2;
FIG. 3 is an example of a graph for measuring a height of a hump by using a contact-type profiler in Comparative Example 2; and
FIG. 4 is an explanatory view for a method for evaluating the filling properties in Example.

### DESCRIPTION OF EMBODIMENTS

As noted above, there has been a demand for development of: a composition for forming an organic film that has excellent film formability (in-plane uniformity) on a substrate (a wafer) and filling properties, and that can form an organic film having reduced humps during the EBR process; a method for forming an organic film and a patterning process that use this composition; and a polymer used for the above composition for forming an organic film.

Typically, in forming the organic film, a resin for forming an organic film and an additive are dissolved with an organic solvent to prepare a composition, this composition is applied with a coater and a developer on a substrate on which structure, wiring, etc. are formed, the substrate is rotated to spread the composition, and the composition on the edge is removed in the EBR process and then calcined to form the organic film.

It is considered that insufficient flowability of the composition causes gaps in filling holes or trenches with an extremely high aspect ratio, and if the resin for forming an organic film and the additive have poor solubility in a remover used in the EBR process, humps are generated on an outer periphery of the organic film.

The present inventors have earnestly studied the above problems, and consequently found that blending a thermally decomposable polymer having a specific repeating unit into a composition for forming an organic film yields a composition for forming an organic film that achieves both excellent film formability and high filling properties and that has excellent hump-reducing properties in the EBR process. This finding has led to completion of the present invention.

Specifically, the present invention is a polymer including a repeating unit represented by the following formula (B1), 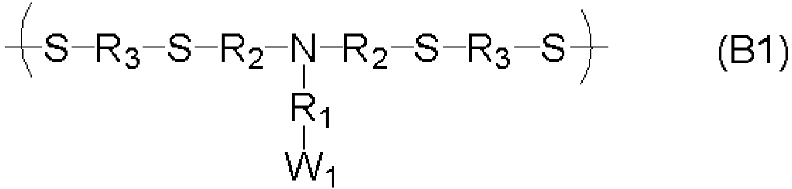 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 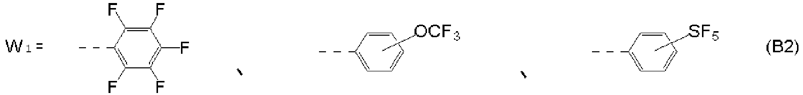 wherein a broken line represents an attachment point to R₁ in the formula (B1), and one of structures represented by the formula (B2) may be contained, or two or more of the structures may be contained.

In addition, the present invention is a composition for forming an organic film including:
(A) a material for forming an organic film;
(B) a polymer including a repeating unit represented by the following formula (B1); and
(C) a solvent, 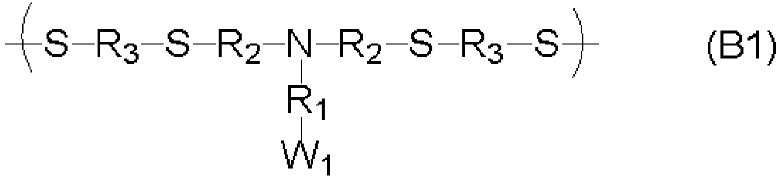 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 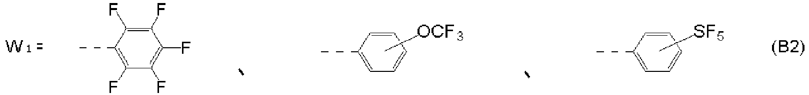 wherein a broken line represents an attachment point to R₁ in the formula (B1), and one of structures represented by the formula (B2) may be contained, or two or more of the structures may be contained.

Hereinafter, the present invention will be described in detail, but the present invention is not limited thereto.

### Composition for Forming Organic Film

The composition for forming an organic film of the present invention includes: (A) a material for forming an organic film; (B) a polymer including a repeating unit represented by the following formula (B1); and (C) a solvent, 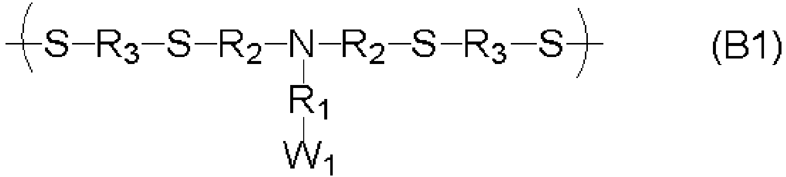 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 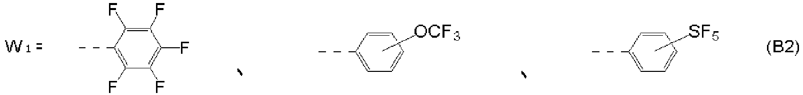 wherein a broken line represents an attachment point to R₁ in the formula (B1), and one of structures represented by the formula (B2) may be contained, or two or more of the structures may be contained.

In the composition for forming an organic film of the present invention, each of (B) the polymer, (A) the material for forming an organic film, and (C) the solvent may be used singly or in combination of two or more thereof.

Hereinafter, among the constituents of the above composition for forming an organic film, (B) the polymer, which is a feature of the present invention, will be described first, and then (A) the material for forming an organic film, (C) the solvent, and other components will be described.

### (B) Polymer

The component (B) in the composition for forming an organic film of the present invention is a polymer having a repeating unit represented by the above general formula (B1). This polymer is useful for forming the organic film by blending in the composition for forming an organic film.

(B) the polymer of the present invention is a compound having a tertiary amine having a fluorine atom and a thioether structure. The coating film formed with the composition for forming an organic film containing (A) the material for forming an organic film described later and (B) the polymer as above hardly causes humps during the EBR process. Introducing the substituent having the appropriate fluorine atom as the above formula (B2) enables to impart a function as a surfactant that has ability to reduce a surface tension and that yields excellently uniform coatability (leveling properties) of the organic film. Thus, when used as a surfactant, (B) the polymer of the present invention can be generally used for coating materials for photolithography, not limited to the organic film. Specific examples thereof include photosensitive resist materials and materials for forming a top coat to be formed on a resist film. As above, (B) the polymer of the present invention has the feature that can function as a surfactant.

That is, the composition for forming an organic film of the present invention containing (A) the material for forming an organic film and (B) the polymer can form the organic film that has excellent film formability on the substrate and filling properties, excellent hump-reducing properties during the EBR process, and that has excellent process margin when used as the organic film for the multilayer resist. For example, use of the composition for forming an organic film of the present invention can form the organic film that is excellent for the multilayer resist for fine processing in production of semiconductor apparatuses and that is excellent for planarization in production of semiconductor apparatuses, etc.

In the general formula (B1), R₁ represents a single bond or a divalent organic group having 1 to 6 carbon atoms. When R₁ represents the divalent organic group having 1 to 6 carbon atoms, examples of the divalent organic group include a methylene group, an ethanediyl group, a propanediyl group, a butanediyl group, a pentanediyl group, and a hexanediyl group.

Examples of the organic group represented by the R₁ preferably include a single bond or a methylene group from the viewpoint of availability of the raw material.

In the general formula (B1), examples of the divalent organic group represented by the R₂ having 1 to 6 carbon atoms include a methylene group, an ethanediyl group, a propanediyl group, a butanediyl group, a pentanediyl group, and a hexanediyl group.

Examples of the organic group represented by the R₂ preferably include a propanediyl group from the viewpoint of availability of the raw material.

In the general formula (B1), examples of the divalent organic group having 1 to 30 carbon atoms and optionally having an oxygen atom represented by R₃ include groups represented by the following formulae.

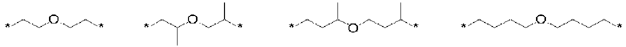

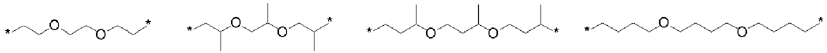

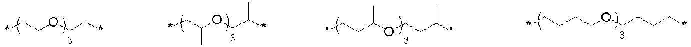

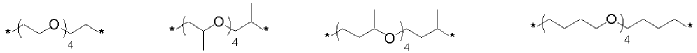

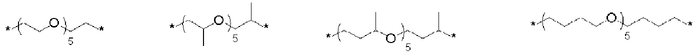

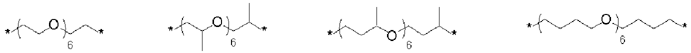

R₃ in (B) the polymer particularly preferably represents a group represented by the following formula (B3). 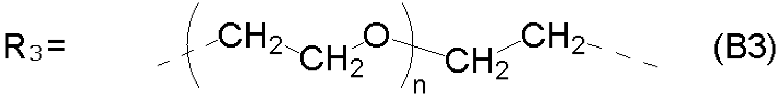 In the formula, a broken line represents an attachment point to a sulfur atom in the formula (B1), "n" represents 1 to 6, and one of structures represented by the formula (B3) may be contained, or two or more of the structures may be contained.

With the composition for forming an organic film containing the polymer as above, film formability during coating can be improved by having an appropriate fluorine content, decomposed products generated in baking do not impair the in-plane uniformity of the film, and insoluble products are not formed by a reaction, etc. between the decomposed products, etc. Thus, the above composition does not narrow the process margin when used as the organic film, and does not cause apparatus contamination and inconvenience.

Further, (B) the polymer is preferably any one or more of the following general formulae (B4) to (B6). 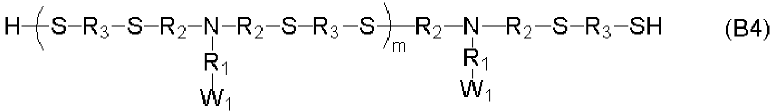 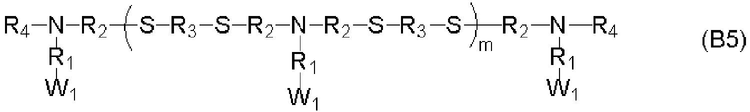 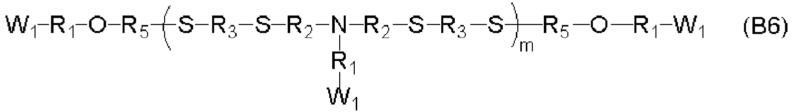 In the formulae, R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.

The composition for forming an organic film containing the polymer as above is preferable because the organic film having more excellent in-plane uniformity can be formed.

In the general formula (B5), examples of the saturated or unsaturated monovalent organic group having 1 to 30 carbon atoms represented by R₄ include a methyl group, an ethyl group, a vinyl group, a 2,2,2-trifluoroethyl group, a propyl group, an isopropyl group, an allyl group, a 1-propenyl group, an isopropenyl group, a butyl group, a s-butyl group, a t-butyl group, an isobutyl group, a pentyl group, a cyclopentyl group, a hexyl group, a cyclohexyl group, a cyclohexenyl group, a decyl group, a dodecyl group, an icosanyl group, a norbornyl group, an adamantyl group, a phenyl group, a toluyl group, a xylyl group, a naphthyl group, a phenanthrenyl group, an anthracenyl group, a benzyl group, a fluorenyl group, a naphthylmethyl group, a norbornenyl group, a triacontyl group, a 2-furanyl group, a 2-tetrahydrofuranyl group, a phenyl group, a toluyl group, a xylyl group, a naphthyl group, a phenanthrenyl group, an anthracenyl group, an anisyl group, an acryloyl group, a methacryloyl group, and an acetyl group. When having an aromatic ring, these R₄ may have a substituent on the aromatic ring, and examples of the substituent include halogen groups such as fluorine, chlorine, bromine, and iodine, alkyloxy groups such as a methoxy group and an ethoxy group, alkenyloxy groups such as an allyloxy group, and alkynyloxy groups such as a propargyloxy group. A hydrogen atom on methylene constituting these alkylene groups may be substituted with a fluorine atom.

Examples of the organic group represented by the R₄ preferably include an allyl group from the viewpoint of availability of the raw material.

In the general formula (B6), examples of the divalent organic group having 1 to 6 carbon atoms represented by R₅ include a methylene group, an ethylene group, a propylene group, an isopropylene group, a butylene group, a s-butylene group, a t-butylene group, an isobutylene group, a pentylene group, a cyclopentylene group, a hexylene group, and a cyclohexylene group. A hydrogen atom on methylene constituting these alkylene groups may be substituted with a fluorine atom.

Examples of the organic group represented by the R₅ preferably include a propylene group from the viewpoint of availability of the raw material.

"m", which represents an average number of repeating units, represents 3 to 2,000, preferably 3 to 500, and more preferably 3 to 300.

(B) the polymer may have only a single repeating unit or may have two or more types of repeating units in combination, as the repeating unit represented by the general formula (B1).

Specific examples of the repeating unit represented by the general formula (B1) include the following units, but the repeating unit is not limited thereto. In the following examples, R₁ represents a single bond or one or two or more types of the divalent organic group having 1 to 6 carbon atoms. W₁ represents one or two or more types of the fluorine-containing group represented by the formula (B2).

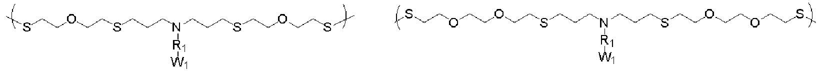

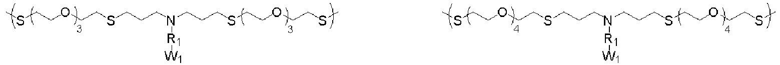

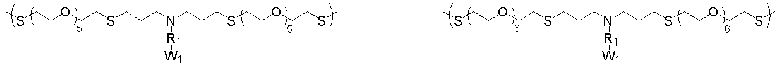

Specific examples of the repeating unit represented by the general formula (B4) include the following units, but the repeating unit is not limited thereto. In the following examples, R₁ represents a single bond or one or two or more types of the divalent organic group having 1 to 6 carbon atoms. W1 represents one or two or more types of the fluorine-containing group represented by the formula (B2).

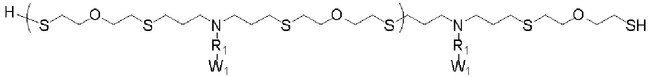

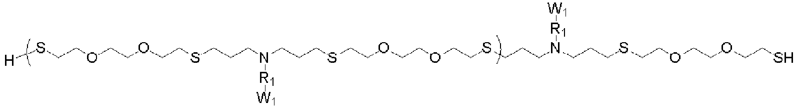

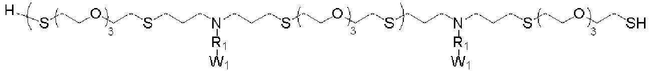

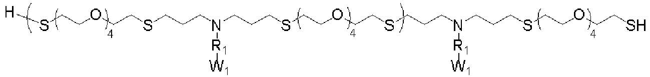

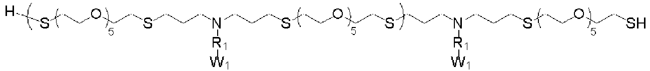

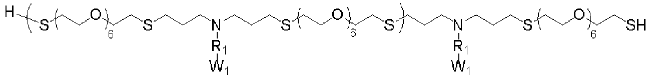

Specific examples of the repeating unit represented by the general formula (B5) include the following units, but the repeating unit is not limited thereto. In the following examples, R₁ represents a single bond or one or two or more types of the divalent organic group having 1 to 6 carbon atoms. W1 represents one or two or more types of the fluorine-containing group represented by the formula (B2).

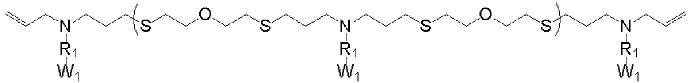

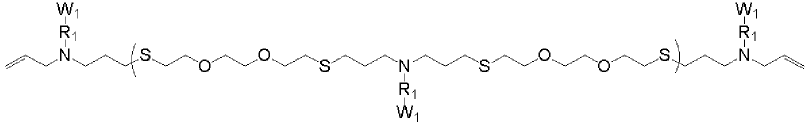

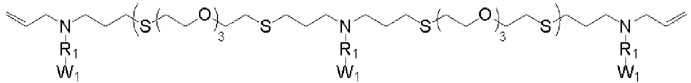

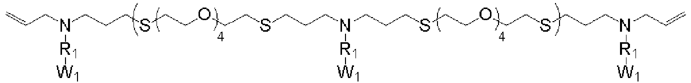

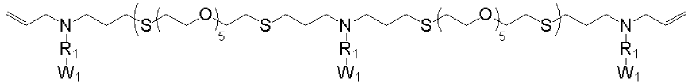

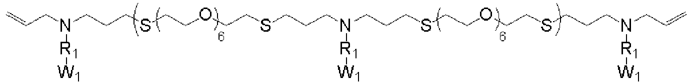

Specific examples of the repeating unit represented by the general formula (B6) include the following units, but the repeating unit is not limited thereto. In the following examples, R₁ represents a single bond or one or two or more types of the divalent organic group having 1 to 6 carbon atoms. W1 represents one or two or more types of the fluorine-containing group represented by the formula (B2).

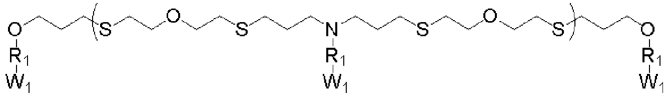

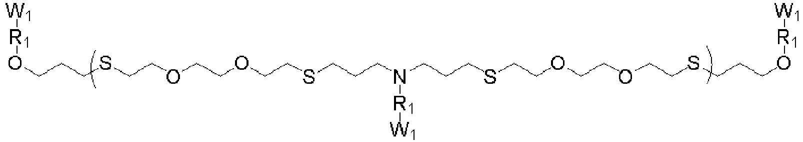

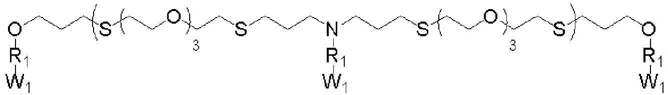

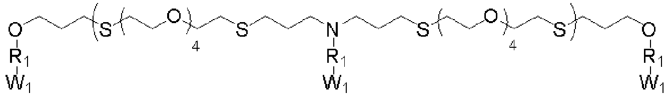

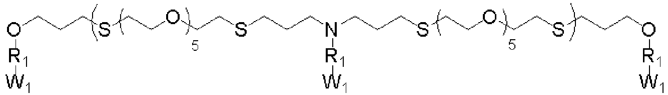

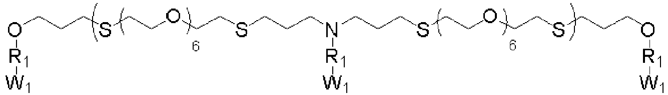

The structures as above can regulate thermal decomposability, the surface-active effect, and flowability of the polymer, and yield the compound that more certainly achieves all of film formability, filling properties, etc.

The weight-average molecular weight of (B) the polymer is preferably 1,000 to 30,000, and more preferably 1,500 to 25,000. The weight-average molecular weight of 1,000 or more can inhibit decrease in the blending effect due to volatilization, resulting in a sufficient blending effect. The weight-average molecular weight of 30,000 or less yields excellent filling properties without deterioration of flowability, etc.

In the present invention, the weight-average molecular weight (Mw) and a number-average molecular weight (Mn) are values in terms of polystyrene by gel permeation chromatography (GPC) with tetrahydrofuran as an eluent (a solvent) under a condition of a measurement temperature at 40°C. A dispersion degree (Mw/Mn) is determined from Mw and Mn.

### Method for Producing (B) Polymer

A means for obtaining (B) the polymer of the present invention is not limited. For example, (B) the polymer can be synthesized by a thiol-ene reaction, etc. between a dithiol compound and a diallyl compound as described below. The dithiol compound and the diallyl compound used for the synthesis may be used singly, or two or more types thereof may be used. These may be appropriately selected and combined depending on the required properties.

Although the diallyl compound is used in the following example, a compound having a vinyl group, a compound having a butenyl group, a compound having a plurality of types of these groups, etc. may be used instead of or in addition to the diallyl compound. R₁, R₃, and W₁ in the following formula are the same as above.

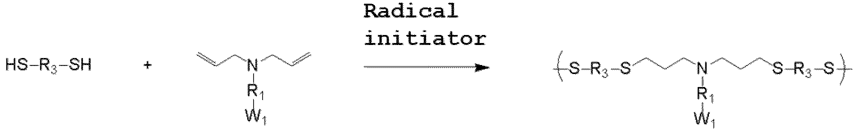

Examples of the radical initiator used in this case include 2,2'-azobisisobutyronitrile (AIBN), 2,2'-azobis(2,4-dimethylvaleronitrile), dimethyl 2,2-azobis(2-methylpropionate), 1,1'-azobis(1-acetoxy-1-phenylmethane), benzoyl peroxide, and lauroyl peroxide. These may be used singly or in combination of two or more thereof. An addition amount of these radical initiators is preferably 0.01 to 25 mol% relative to a total amount of the monomers to react.

A solvent used in this case is not particularly limited as long as the solvent is inert to the above reaction. For example, ether solvents such as diethyl ether, tetrahydrofuran, and dioxane; aromatic solvents such as benzene, toluene, and xylene; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; etc., may be used singly or mixed for use. These solvents may be used within a range of, for example, 0 to 2000 parts by mass relative to 100 parts by mass of the reaction raw materials, and the reaction temperature is preferably 50 to 150°C, and more preferably 60 to 100°C. The reaction time is appropriately selected from 0.1 to 100 hours.

Examples of the reaction method include: a method of collectively feeding the dithiol compound and the diallyl compound into the solvent; a method of separately dispersing or dissolving each of the dithiol compound and the diallyl compound in the solvents, and dropping these dispersions or solutions for feeding; and a method of dispersing or dissolving any one of the dithiol compound and the diallyl compound in the solvent, and then dropping the other compound dispersed or dissolved in the solvent into the above for feeding. When a plurality of types of the dithiol compound and the diallyl compound are fed, these compounds may be mixed to react in advance, or may be allowed to react separately and subsequently. Methods for using the radical initiator include: a method of collectively feeding the dithiol compound and the diallyl compound; a method of dispersing or dissolving the dithiol compound and the diallyl compound in the solvent, and then adding or dropping the radical initiator; and a method of dispersing or dissolving the radical initiator in advance, and then dropping the dithiol compound and the diallyl compound.

To remove an unreacted raw material, catalyst, etc. present in the system, the reaction liquid obtained by the method described with the examples is diluted with an organic solvent, and then liquid-separation washing may be performed to recover (B) the polymer.

The organic solvent used for the liquid-separation washing is not particularly limited as long as the organic solvent can dissolve the compounds and form separated two layers when mixed with water. Examples thereof include: hydrocarbons such as hexane, heptane, benzene, toluene, and xylene; esters such as ethyl acetate, n-butyl acetate, and propylene glycol methyl ether acetate; ketones such as methyl ethyl ketone, methyl amyl ketone, cyclohexanone, and methyl isobutyl ketone; ethers such as diethyl ether, diisopropyl ether, methyl tert-butyl ether, and ethylcyclopentyl methyl ether; chlorine solvents such as methylene chloride, chloroform, dichloroethane, and trichloroethylene; and a mixture thereof. As the washing water used in this time, so-called deionized water or ultrapure water is typically used. The number of times of the washing is one or more, and preferably approximately one to five because an expected effect is not always obtained even when the washing is performed ten times or more.

To remove the unreacted raw materials and an acidic component in the system during the liquid-separation washing, the washing may be performed with a basic aqueous solution. Specific examples of the base include a hydroxide of an alkali metal, a carbonate salt of an alkali metal, a hydroxide of an alkali earth metal, a carbonate salt of an alkali earth metal, ammonia, and an organic ammonium.

To remove the unreacted raw materials, a metal impurity, or a base component in the system during the liquid-separation washing, the washing may be further performed with an acidic aqueous solution. Specific examples of the acid include: inorganic acids such as hydrochloric acid, hydrobromic acid, sulfuric acid, nitric acid, phosphoric acid, and heteropoly acid; and organic acids such as oxalic acid, fumaric acid, maleic acid, trifluoroacetic acid, methanesulfonic acid, benzenesulfonic acid, p-toluenesulfonic acid, and trifluoromethanesulfonic acid.

The liquid-separation washing may be performed with only any one of the basic aqueous solution and the acidic aqueous solution, or may be performed in combination thereof. The phase-separation washing is preferably performed with the basic aqueous solution and the acidic aqueous solution in this order from the viewpoint of removal of a metal impurity.

After the liquid-separation washing with the basic aqueous solution and the acidic aqueous solution, washing with neutral water may be subsequently performed. A number of times of the washing is one or more, and preferably appropriately one to five. As the neutral water, deionized water, ultrapure water, etc., as described above, are used. A number of times of the washing is one or more, but a few times may fail to remove the basic component and the acidic component. The number of times of the washing is preferably about one to five because an expected effect is not always obtained even when the washing is performed ten times or more.

The reaction product after the phase-separation procedure can be recovered as a powder by concentrating the solvent and solidifying the product under a reduced pressure or a normal pressure, or by performing a crystallization procedure. Alternatively, the reaction product can be in a solution state at an appropriate concentration in order to improve handling in preparing the material for forming an organic film. The concentration in this case is preferably 0.1 to 50 mass%, and more preferably 0.5 to 30 mass%. Such a concentration, which hardly increases the viscosity, can prevent impairing the handling, and is economical because the solvent amount is not excessively large.

The solvent in this case is not particularly limited as long as the solvent can dissolve the compound. Specific examples thereof include: ketones such as cyclohexanone and methyl 2-amyl ketone; alcohols such as 3-methoxylbutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. These solvents may be used singly, or two or more thereof may be mixed for use.

For the above reaction, the dithiol compound and the diallyl compound can be combined for meeting required performance. For example, a fluorine-containing substituent, etc. for modifying surface-active performance by regulating surface tension, etc. may be appropriately combined. Therefore, use of the composition for forming an organic film using these compounds for the organic film can achieve performance such as film formability and filling properties at a high level.

The polymer represented by the above general formula (B4) or (B5) can be easily produced by regulating the ratio between the dithiol compound and the diallyl compound when these compounds are fed. Specifically, when a number of moles of the feeding amount of the dithiol compound is defined as "x" and a number of moles of the feeding amount of the diallyl compound is defined as "y", the feeding ratio of the dithiol compound is set to be larger than the diallyl compound in the case of (B4). That is, the feeding ratio is set to satisfy x > y, and in this case, the excess amount of the dithiol component can leave an unreacted thiol at the end. Similarly, in the case of (B5), the feeding ratio of the diallyl compound is set to be larger than the dithiol compound. That is, the feeding ratio is set to satisfy x < y, and this case allows the end to be blocked with the diallyl compound.

### Method for Producing (B4): Case of Feeding Ratio of x > Y

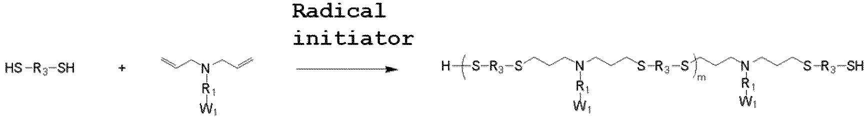

In the formula R₁, R₃, and W₁ are the same as above.

### Method for Producing (B5): Case of Feeding Ratio of x < y

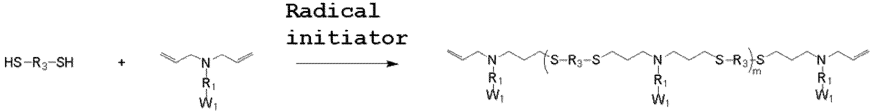

In the formula R₁, R₃, and W₁ are the same as above.

In the case of the above general formula (B6), examples of the producing method include: a method of further blocking the end with a monoallyl compound by using the polymer represented by the above general formula (B4); or a method of collectively reacting the dithiol compound, the diallyl compound, and the monoallyl compound. When the compounds are collectively fed, the feeding ratio needs to be strictly regulated, and the method in which the polymer represented by (B4) is produced and then the end is blocked with the monoallyl compound is industrially preferable.

### End Blocking of Polymer (B4)

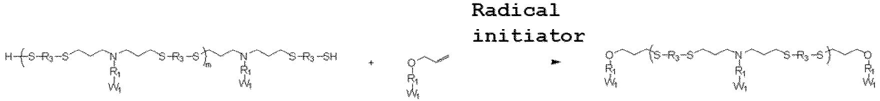

In the formula R₁, R₃, and W₁ are the same as above.

### Collective Feeding

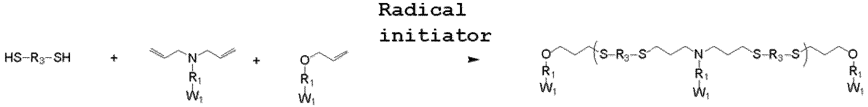

In the formula R₁, R₃, and W₁ are the same as above.

The producing method for (B4) and (B5) can be performed according to the method described in the above producing method for (B1) only by regulating the feeding ratio between the dithiol compound and the diallyl compound according to the desired structure to be obtained. The reaction method and the recovering method of the polymer can be performed by the above method described in the method for producing the polymer of the general formula (B1).

In the case of the collective feeding, the method for producing (B6) can be performed according to the producing method for (B1), the reaction method and the recovering method of the polymer only by simultaneously using the dithiol compound, the diallyl compound, and the monoallyl compound. In the case of end blocking of the polymer (B4), examples of methods therefor include: a method of recovering the polymer (B4) once, and performing the reaction with the monoallyl compound again similarly to the method for producing the polymer (B1); and a method for completing the reaction between the dithiol compound and the diallyl compound in the reaction for producing the polymer (B4), and then feeding the monoallyl compound for using the end blocking for a one-pot reaction. The reaction methods in both the cases can be performed according to the producing method for (B1), the reacting method, and the recovering method of the polymer only with change in the substrate.

### (A) Material for Forming Organic Film

(A) the material for forming an organic film (the resin or the compound) used in the composition for forming an organic film of the present invention is not particularly limited as long as the material is the resin or the compound that satisfies the film formability with spin-coating and curing properties. From the viewpoints of etching resistance, optical properties, heat resistance, etc., a resin or a compound containing an aromatic skeleton (different from (B) the polymer) is more preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, and carbazole. Among these, benzene, naphthalene, fluorene, and carbazole are particularly preferable.

Hereinafter, (A) the material for forming an organic film will be described with specific examples, but these are merely examples, and not limited thereto. The numbers in the formulae represented in the following examples are applied only for the description in the following formula.

Examples of (A) the material for forming an organic film (the resin or the compound) used in the present invention include resins having the following structure, described in JP 2012-001687 A and JP 2012-077295 A. 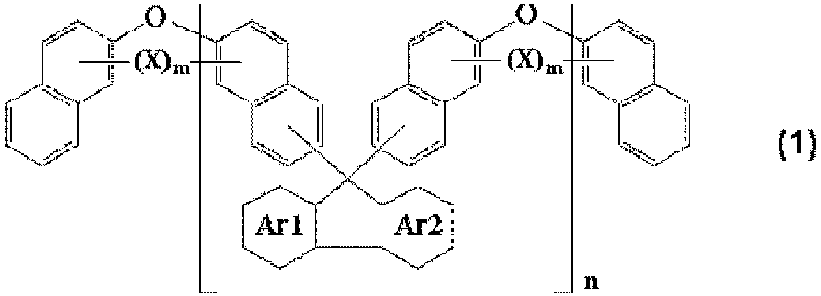 In the formula (1), the cyclic structures Ar1 and Ar2 each independently represent a benzene ring or a naphthalene ring. X represents a single bond or an alkylene group having 1 to 20 carbon atoms. "m" represents 0 or 1. "n" represents a given natural number so that the molecular weight is 100,000 or less. Note that the definitions of the signs in the formula are applied only in this formula. 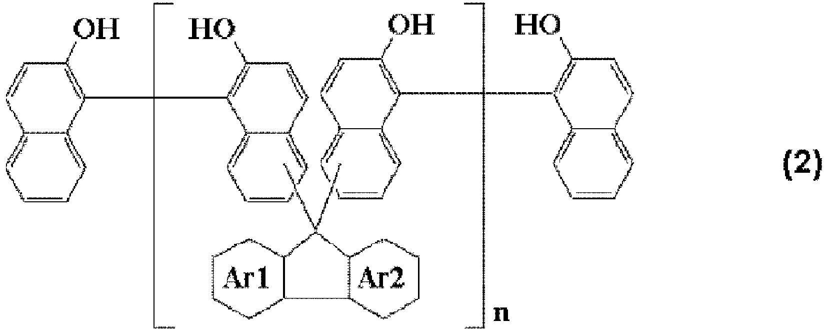 In the formula (2), the cyclic structures Ar1 and Ar2 each independently represent a benzene ring or a naphthalene ring. "n" represents a given natural number so that the weight-average molecular weight by gel permeation chromatography in terms of polystyrene is 100,000 or less. Note that the definitions of the signs in the formula are applied only in this formula.

Examples of (A) the material for forming an organic film used in the present invention further include resins having the following structure, described in JP 2004-264710 A, JP 2005-043471 A, JP 2005-250434 A, JP 2007-293294 A, and JP 2008-065303 A. 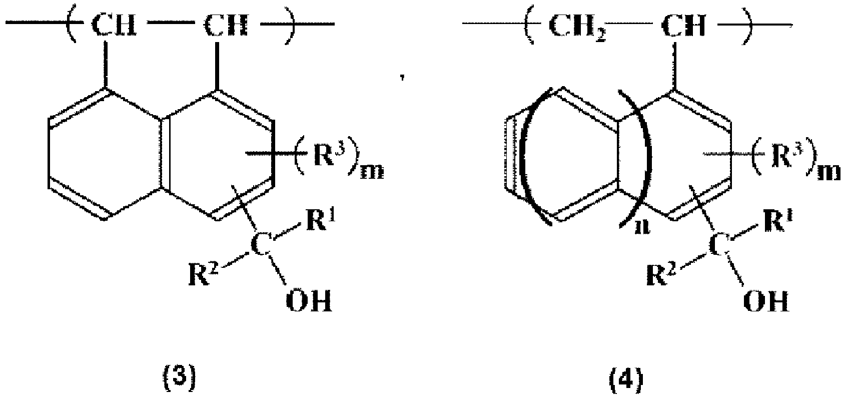 In the formula (3) and the formula (4), R¹ and R² each independently represent a hydrogen atom, an alkyl group having 1 to 3 carbon atoms, or an aryl group; R³ represents an alkyl group having 1 to 3 carbon atoms, a vinyl group, an allyl group, or an aryl group optionally substituted; "n" represents 0 or 1; and "m" represents 0, 1, or 2. Note that the definitions of the signs in the formula are applied only in this formula. 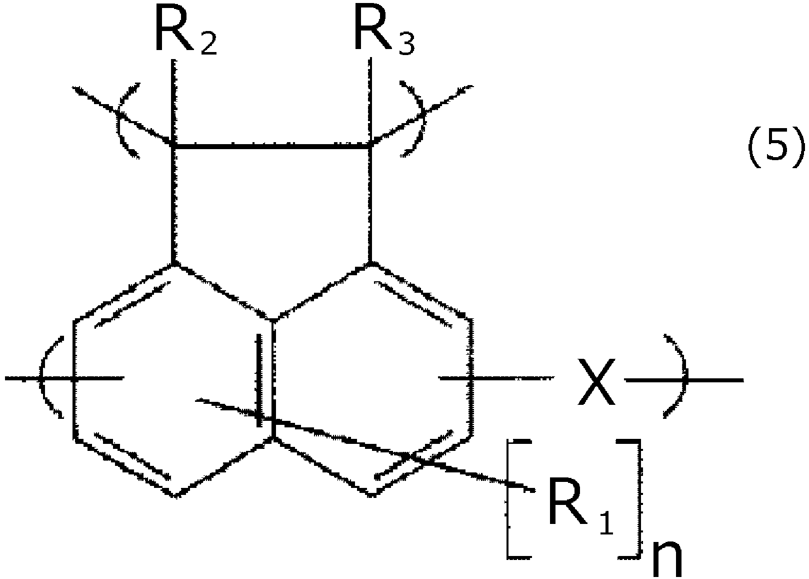 In the formula (5), R₁ represents a monovalent atom or group other than a hydrogen atom; and "n" represents an integer of 0 to 4. Note that, when "n" represents 2 to 4, a plurality of R₁ may be same as or different from each other. R₂ and R₃ each independently represent a monovalent atom or group. X represents a divalent group. Note that the definitions of the signs in the formula are applied only in this formula. 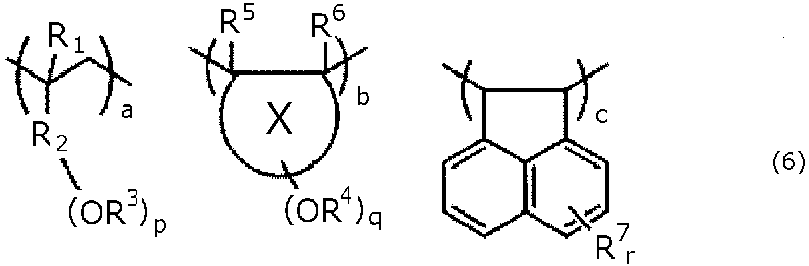 In the formula (6), R₁ represents a hydrogen atom or a methyl group. R₂ represents any one of a single bond, a linear, branched, or cyclic alkylene group having 1 to 20 carbon atoms, and an arylene group having 6 to 10 carbon atoms, and R² optionally has any one of an ether, an ester, a lactone, and an amide. R³ and R⁴ each independently represents a hydrogen atom or a glycidyl group. X represents a polymer of any one of a hydrocarbon having an indene skeleton, a cycloolefin having 3 to 10 carbon atoms, and a maleimide, and X optionally has any one of an ether, an ester, a lactone, and a carboxylic anhydride. R⁵ and R⁶ each independently represent any one of a hydrogen atom, a fluorine atom, a methyl group, and a trifluoromethyl group. R⁷ represents any one of a hydrogen atom, a linear, branched, or cyclic alkyl group having 1 to 6 carbon atoms, a hydroxy group, and an alkoxycarbonyl group. "p" and "q" each represent an integer of 1 to 4. "r" represents an integer of 0 to 4. "a", "b", and "c" are each within ranges of 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the definitions of the signs in the formula are applied only in this formula. 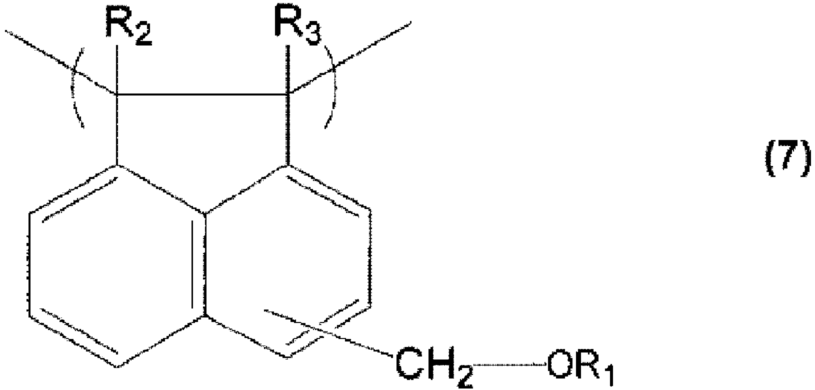 In the formula (7), R₁ represents a hydrogen atom or a monovalent organic group; and R₂ and R₃ each independently represent a monovalent atom or a monovalent organic group. Note that the definitions of the signs in the formula are applied only in this formula.

Specific examples of (A) the material for forming an organic film used in the present invention further include resins having the following structure, described in JP 2004-205685 A, JP 2007-171895 A, and JP 2009-014816 A. 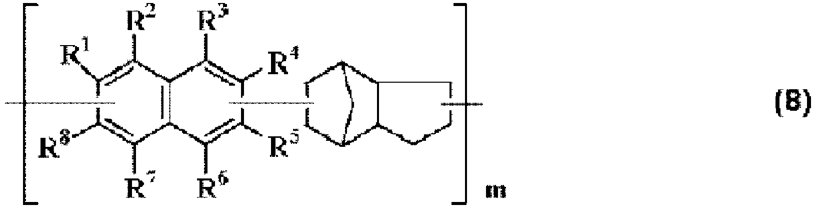 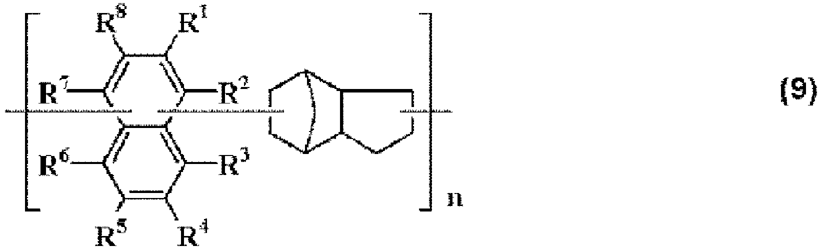 In the formula (8) and the formula (9), R₁ to R⁸ each independently represent a hydrogen atom, a hydroxy group, an optionally substituted alkyl group having 1 to 6 carbon atoms, an optionally substituted alkoxy group having 1 to 6 carbon atoms, an optionally substituted alkoxycarboxyl group having 2 to 6 carbon atoms, an optionally substituted aryl group having 6 to 10 carbon atoms, a hydroxyalkyl group having 1 to 6 carbon atoms, an isocyanate group, or a glycidyl group. "m" and "n" represent a positive integer. Note that the definitions of the signs in the formulae are applied only in this formulae. 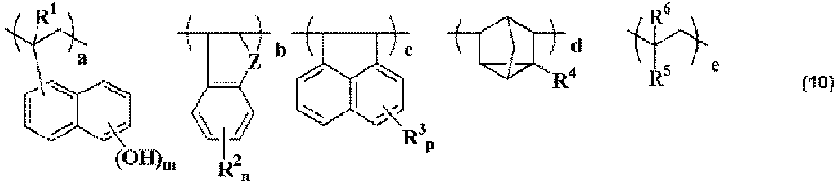 In the formula (10), R¹ and R⁶ each independently represent a hydrogen atom or a methyl group. R², R³, and R⁴ each independently represent a hydrogen atom, an alkyl group having 1 to 4 carbon atoms, an alkoxy group, a hydroxy group, an acetoxy group, an alkoxycarbonyl group, or an aryl group having 6 to 10 carbon atoms, R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷, "m" represents 1 or 2, "n" represents an integer of 0 to 4, and "p" represents an integer of 0 to 6. R⁷ represents an organic group having 7 to 30 carbon atoms, and R⁸ represents a hydrogen atom or a hydrocarbon group having 1 to 6 carbon atoms. Z represents any one of a methylene group, -O-, -S-, and-NH-. "a", "b", "c", "d", and "e" are each within ranges of 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the definitions of the signs in the formula are applied only in this formula. 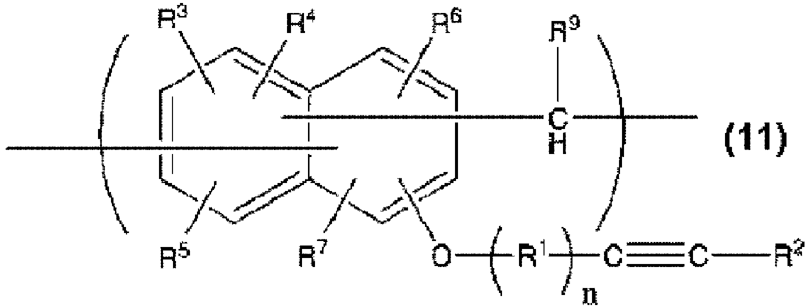 In the formula (11), "n" represents 0 or 1. R¹ represents an optionally substituted methylene group, an optionally substituted alkylene group having 2 to 20 atoms, or an optionally substituted arylene group having 6 to 20 carbon atoms. R² represents a hydrogen atom, an optionally substituted alkyl group having 1 to 20 carbon atoms, or an optionally substituted aryl group having 6 to 20 carbon atoms. R³ to R⁷ each independently represent a hydroxy group, an optionally substituted alkyl group having 1 to 6 carbon atoms, an optionally substituted alkoxy group having 1 to 6 carbon atoms, an optionally substituted alkoxycarbonyl group having 2 to 10 carbon atoms, an optionally substituted aryl group having 6 to 14 carbon atoms, or an optionally substituted glycidyl ether group having 2 to 6 carbon atoms. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the definitions of the signs in the formula are applied only in this formula.

Examples of the resin represented by the formula (11) include the following resins.

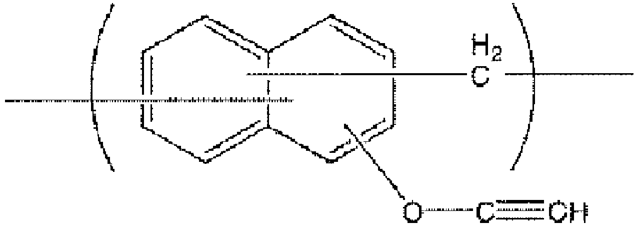

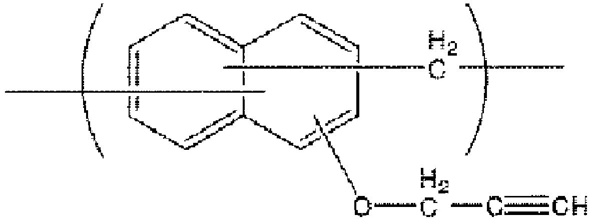

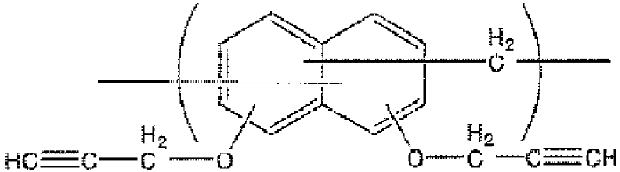

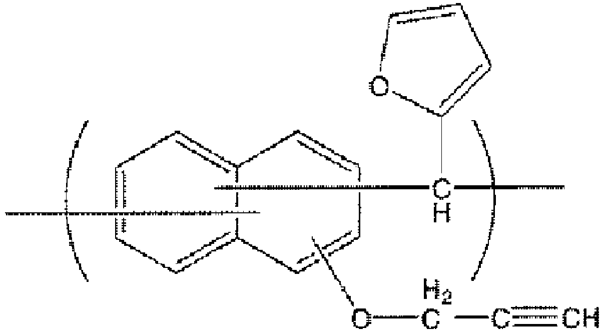

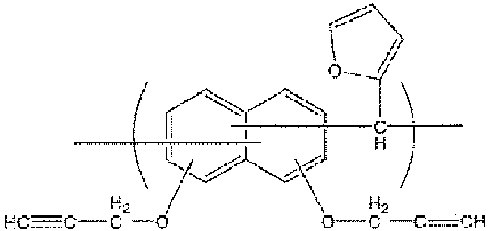

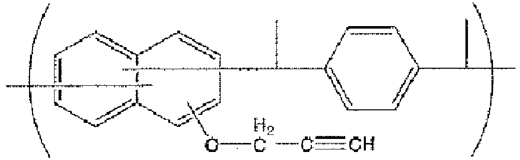

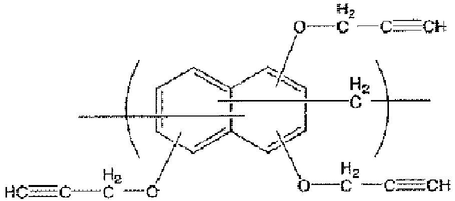

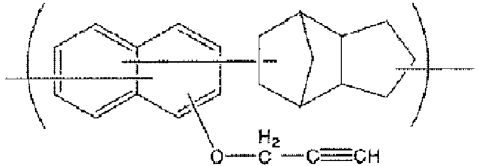

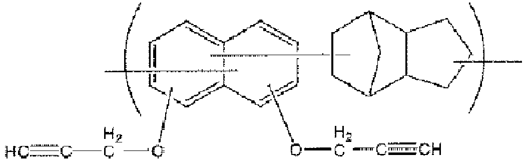

Examples of (A) the material for forming an organic film used in the present invention further include resins having the following structure, described in JP 2007-199653 A, JP 2008-274250 A, and JP 2010-122656 A. 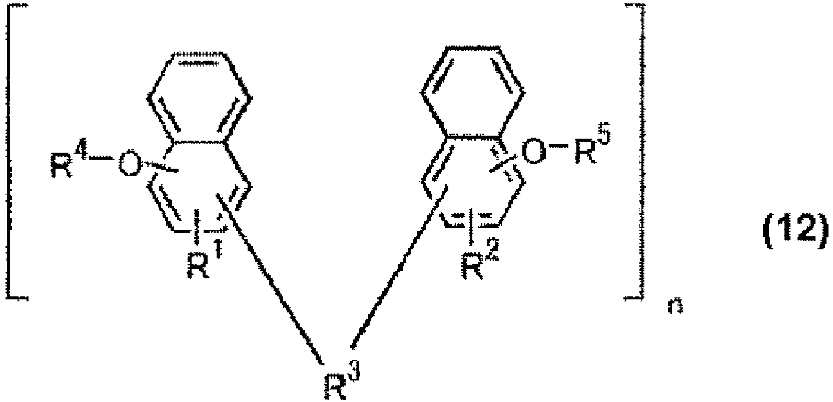 In the formula (12), R¹ and R² each independently represent a same type or different types of a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or an alkenyl group having a linear, branched, or cyclic structure, having 1 to 30 carbon atoms, and optionally having a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the definitions of the signs in the formula are applied only in this formula. 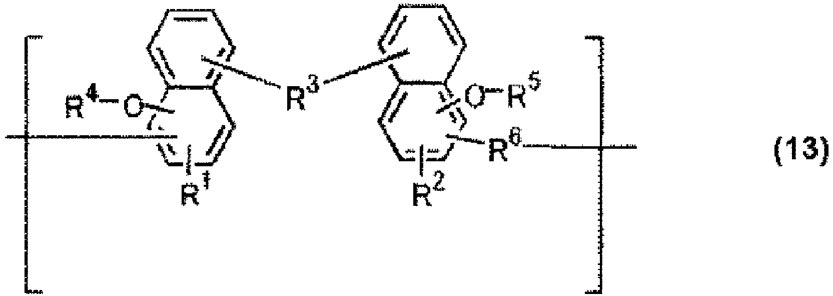 In the formula (13), R¹ and R² each independently represent a same type or different types of a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or an alkenyl group having a linear, branched, or cyclic structure having 1 to 30 carbon atoms, and optionally having a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the definitions of the signs in the formula are applied only in this formula. 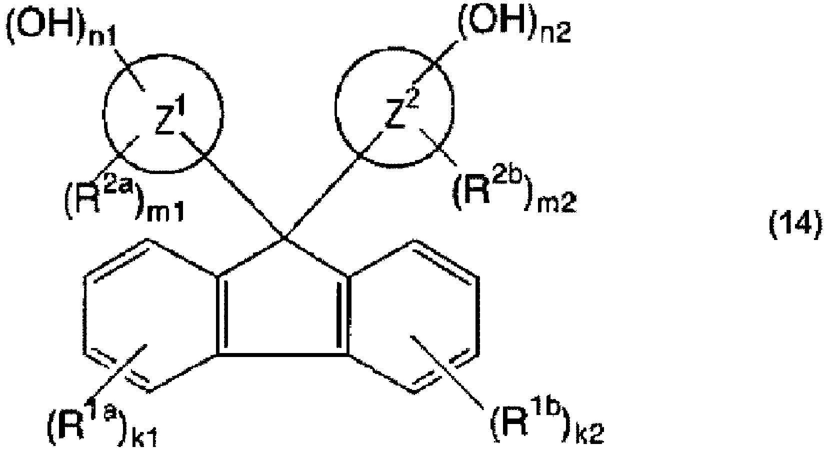 In the formula (14), the ring Z¹ and the ring Z² represent a condensed polycyclic aromatic hydrocarbon ring; and R^{1a}, R^{1b}, R^{2a}, and R^{2b} represent a substituent that may be same as or different from each other. k1 and k2 each represent an integer of 0 or 1 to 4, which may be the same as or different from each other; m1 and m2 each represent an integer of 0 or 1 or more; and n1 and n2 each represent an integer of 0 or 1 or more. Provided that n1 + n2 ≥ 1. Note that the definitions of the signs in the formula are applied only in this formula. 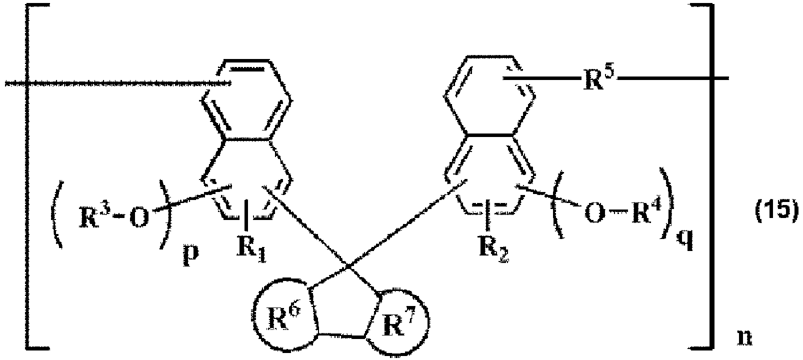 In the formula (15), R¹ and R² represent a same type or different types of a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each independently represent a hydrogen atom or a glycidyl group, R⁵ represents a single bond or a linear or branched alkylene group having 1 to 10 carbon atoms; and R⁶ and R⁷ each independently represent a benzene ring or a naphthalene ring. "p" and "q" each represent 1 or 2. "n" satisfies 0 < n ≤ 1. Note that the definitions of the signs in the formula are applied only in this formula.

Examples of the resin represented by the formula (15) include the following resins.

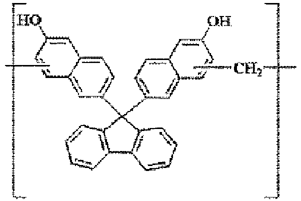

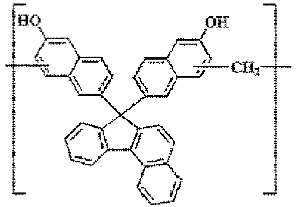

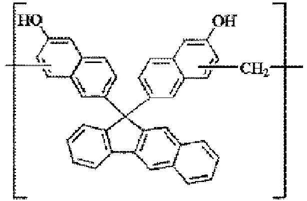

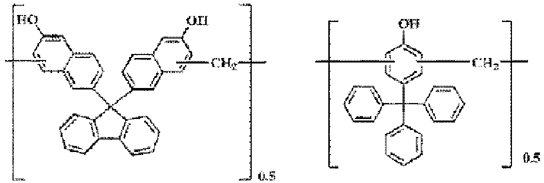

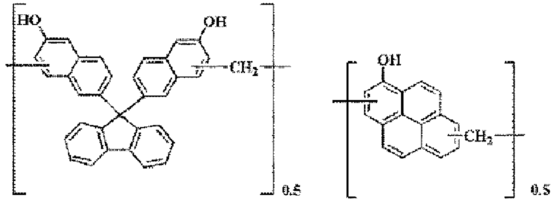

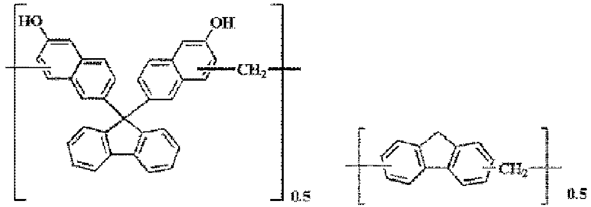

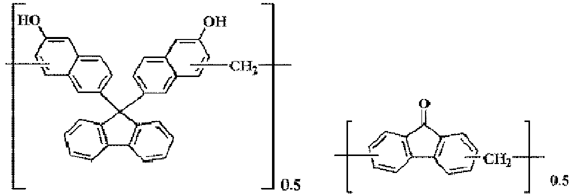

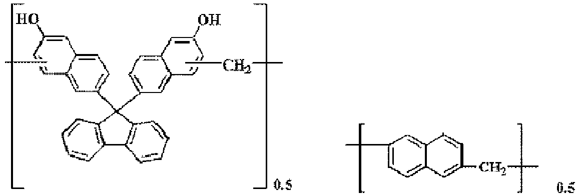

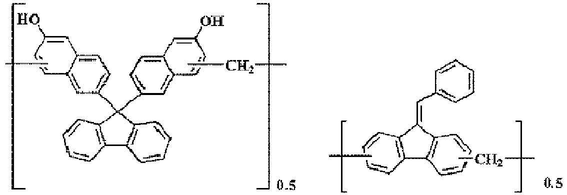

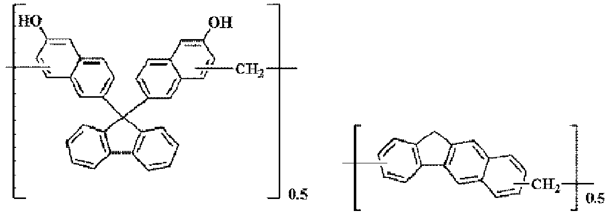

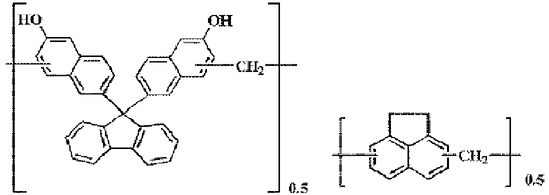

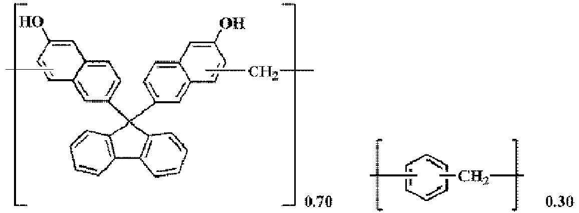

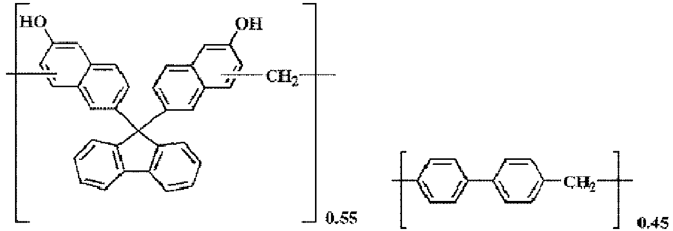

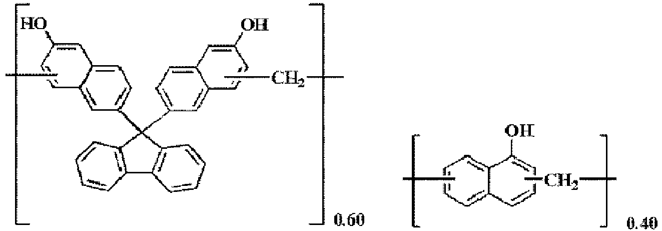

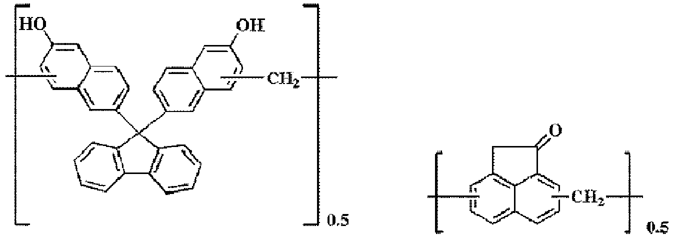

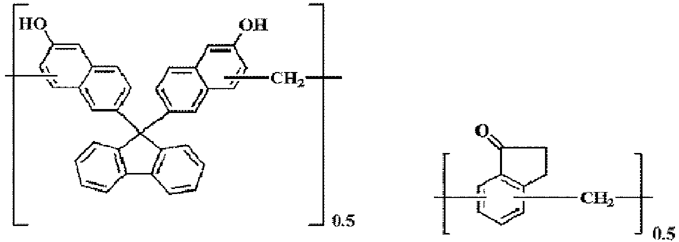

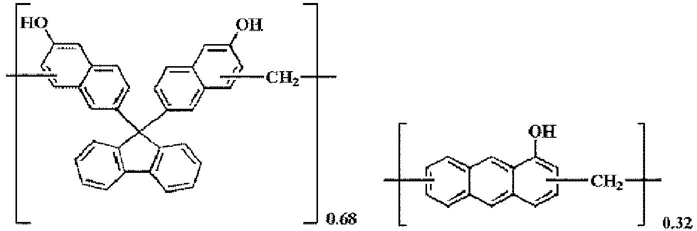

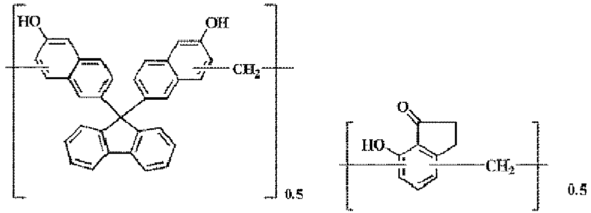

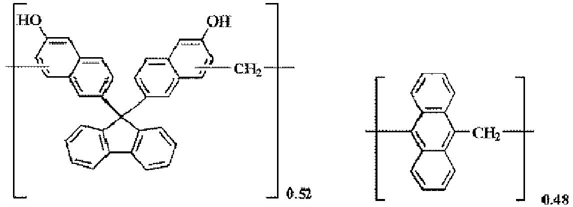

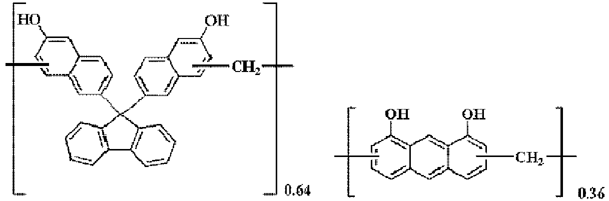

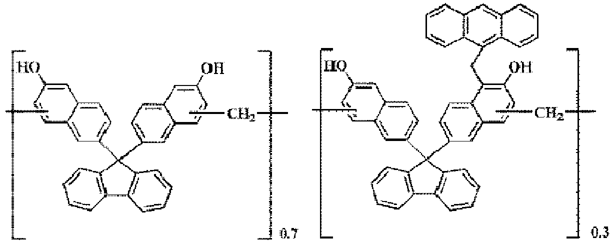

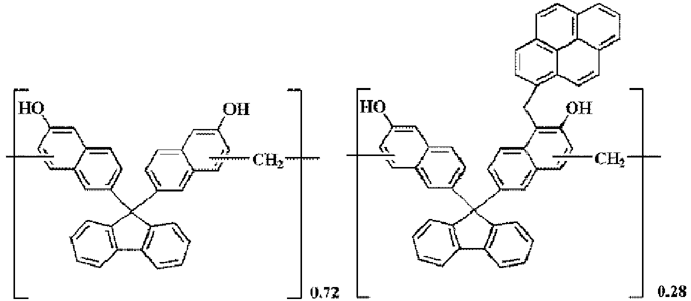

Examples of (A) the material for forming an organic film used in the present invention further include resins having the following structure, described in JP 2012-214720 A. 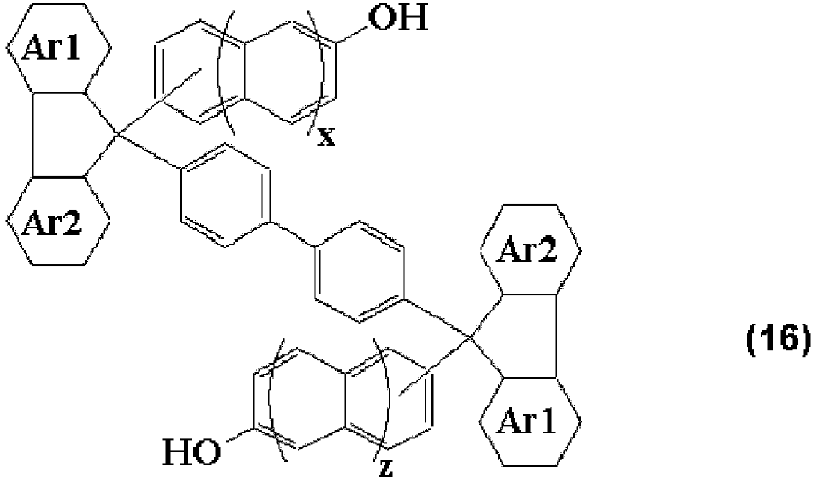 In the formula (16), the ring structures Ar1 and Ar2 each independently represent a benzene ring or a naphthalene ring. "x" and "z" each independently represent 0 or 1. Note that the definitions of the signs in the formula are applied only in this formula.

Examples of (A) the material for forming an organic film used in the present invention further include resins having the following structure, described in JP 2014-29435 A. 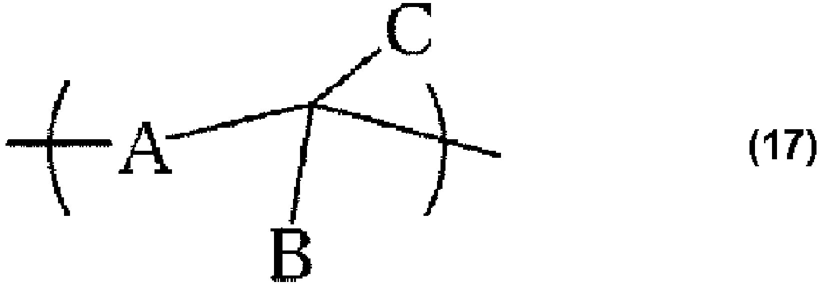 In the formula (17), A represents a structure having a carbazole; B represents a structure having an aromatic ring; C represents a structure having a hydrogen atom, an alkyl group, or an aromatic ring, and B and C optionally constitute a ring with each other. The structures of A, B, and C have one to four carboxy groups or a salt thereof or carboxylate ester groups. Note that the definitions of the signs in the formula are applied only in this formula.

Examples of (A) the material for forming an organic film used in the present invention further include a polymer having a unit structure represented by the following formula (18) and a unit structure represented by the following formula (19), described in WO 2012/077640, wherein a ratio between the unit structure represented by the following formula (18) and the unit structure represented by the following formula (19) is 3 to 97 : 97 to 3. 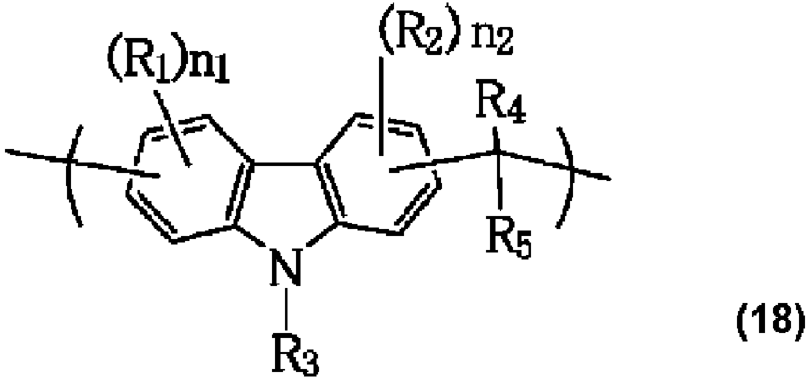 In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of these group optionally having an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of these group optionally having an ether bond, a ketone bond, or an ester bond. R₄ represents a hydrogen atom, an aryl group having 6 to 40 carbon atoms or a heterocyclic group, and the groups are optionally substituted with a halogen atom, a nitro group, an amino group, or a hydroxy group; R₅ represents a hydrogen atom, or an alkyl group having 1 to 10 carbon atoms, an aryl group having 6 to 40 carbon atoms, or a heterocyclic group, and the groups are optionally substituted with a halogen atom, a nitro group, an amino group, or a hydroxy group, and R₄ and R₅ optionally form a ring with each other. n₁ and n₂ each represent an integer of 1 to 3. Note that the definitions of the signs in the formula are applied only in this formula. 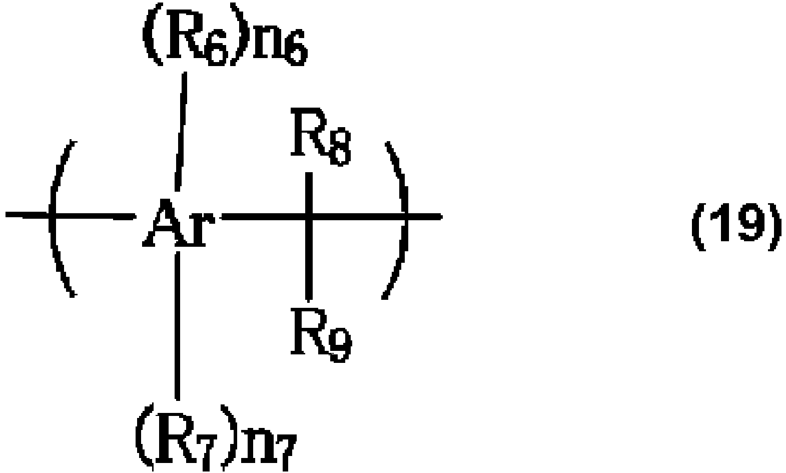 In the formula (19), Ar represents an aromatic ring group having 6 to 20 carbon atoms; R₆ represents a hydroxy group; R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of these groups and optionally having an ether bond, a ketone bond, or an ester bond; R₈ represents a hydrogen atom, an aryl group having 6 to 40 carbon atoms, or a heterocyclic group, and the aryl group is optionally substituted with a halogen atom, a nitro group, an amino group, or a hydroxy group; R₉ represents a hydrogen atom, an alkyl group having 1 to 10 carbon atoms, an aryl group having 6 to 40 carbon atoms, or a heterocyclic group, and the alkyl group is optionally substituted with a halogen atom, a nitro group, an amino group, or a hydroxy group; R₈ and R₉ optionally form a ring with each other; n6 represents an integer of 1 to "p"; and n7 represents an integer of p-n6, and "p" here represents a maximum number of substituents that the aromatic ring group Ar can have. Note that the definitions of the signs in the formula are applied only in this formula.

Examples of (A) the material for forming an organic film used in the present invention further include resins having a unit structure represented by the following formula (20), described in WO 2010/147155. 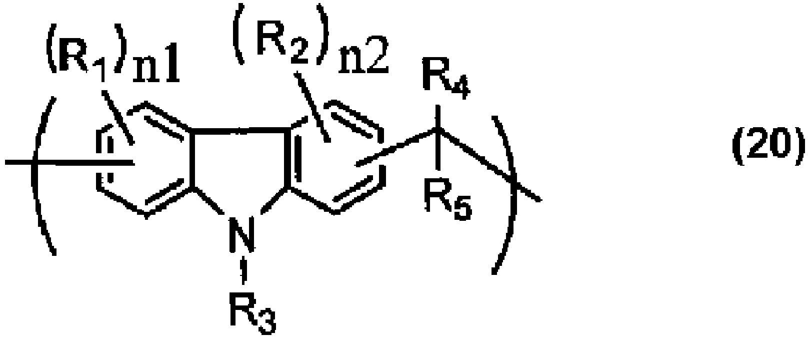 In the formula (20), R₁ and R₂ are each independently selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination of these groups, and the alkyl group, the alkenyl group, or the aryl group optionally has an ether bond, a ketone bond, or an ester bond; R₃ is selected from the group consisting of a hydrogen atom, an alkyl group having 1 to 10 carbon atoms, an alkenyl group having 2 to 10 carbon atoms, an aryl group having 6 to 40 carbon atoms, and a combination of these groups, and the alkyl group, the alkenyl group, or the aryl group optionally has an ether bond, a ketone bond, or an ester bond; R₄ represents an aryl group or heterocyclic group having 6 to 40 carbon atoms, and the aryl group and the heterocyclic group are optionally substituted with a halogen group, a nitro group, an amino group, or a hydroxy group; R₅ represents a hydrogen atom, an alkyl group having 1 to 10 carbon atoms, an aryl group having 6 to 40 carbon atoms, or a heterocyclic group, and the alkyl group are optionally substituted with a halogen group, a nitro group, an amino group, or a hydroxy group; R₄ and R₅ optionally form a ring together with the carbon atom to which R₄ and R₅ are bonded; and n1 and n2 each represent an integer of 1 to 3. Note that the definitions of the signs in the formula are applied only in this formula.

Examples of (A) the material for forming an organic film used in the present invention further include novolac resins and resins having a repeating unit structure represented by the following formula (21), described in WO 2012/176767. The novolac resins are obtained by a reaction of: one or two or more kinds of phenols, such as phenol, cresol, xylenol, catechol, resorcinol, hydroquinone, pyrogallol, hydroxyquinol, and phloroglucinol; and one or two or more kinds of aldehyde sources, such as formaldehyde, paraformaldehyde, and trioxane, using an acidic catalyst. 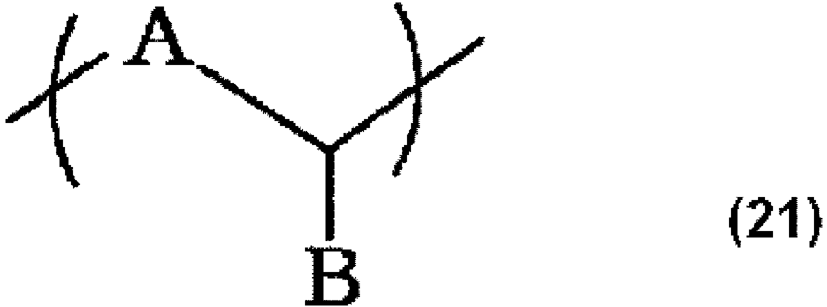 In the formula (21), A represents a hydroxyl-group-substituted phenylene group derived from a polyhydroxybenzene; and B represents a monovalent condensed aromatic hydrocarbon ring group in which two to six benzene rings are condensed. Note that the definitions of the signs in the formula are applied only in this formula.

Examples of (A) the material for forming an organic film used in the present invention further include resins described in JP 2005-128509 A, JP 2006-259249 A, JP 2006-259482 A, JP 2006-293298 A, and JP 2007-316282 A. In the resins, a novolac resin having a fluorene or tetrahydrospirobiindene structure has a repeating unit structure represented by the following formula (22-1) or (22-2). 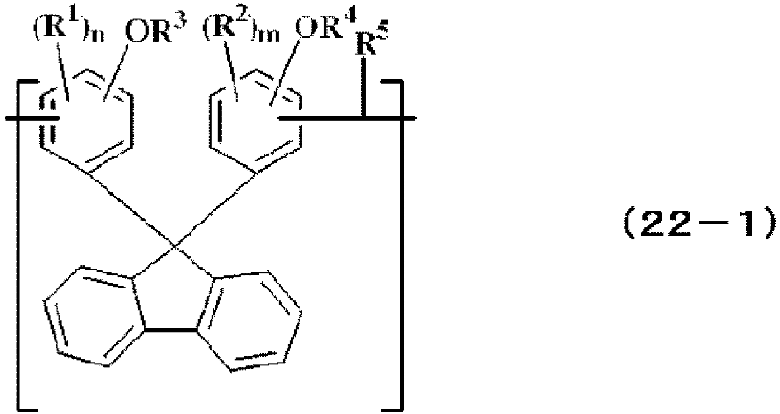 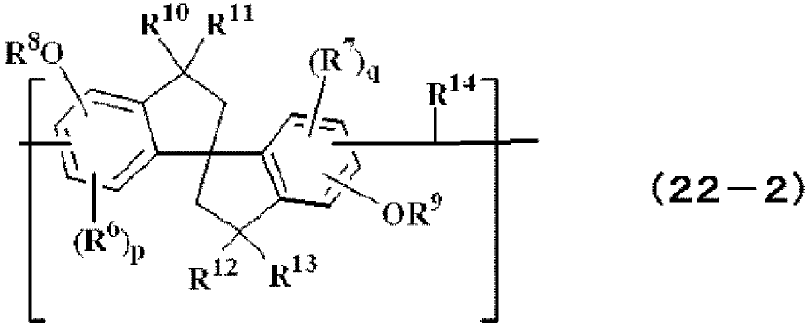 In the formulae (22-1) and (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; R⁵ and R¹⁴ each independently represent a hydrogen atom, a linear, branched, or cyclic alkyl group having 1 to 10 carbon atoms, or an aryl group having 6 to 10 carbon atoms; "n", "mm", "p", and "q" represent an integer of 1 to 3; and R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the definitions of the signs in the formulae are applied only in this formulae.

Examples of (A) the material for forming an organic film used in the present invention further include reaction products obtained by a method described in JP 2012-145897 A. More specifically, a polymer obtained by condensing: one or more kinds of compounds represented by the following general formulae (23-1) and/or (23-2); and one or more kinds of compounds represented by the following general formulae (24-1) and/or (24-2), and/or equivalents thereof can be exemplified. 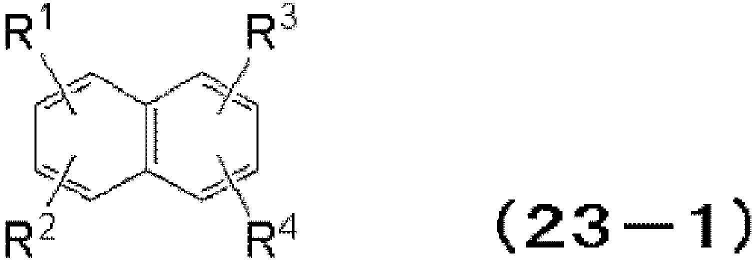 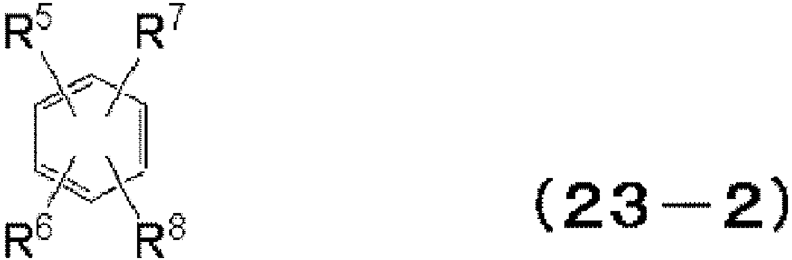 In the general formula (23-1) and the general formula (23-2), R¹ to R⁸ each independently represent a hydrogen atom, a halogen atom, a hydroxy group, an isocyanate group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or an optionally substituted saturated or unsaturated organic group having 1 to 30 carbon atoms. Furthermore, any two substituents freely selected from each of R¹ to R⁴ or R⁵ to R⁸ in the molecule are optionally bonded to form an additional cyclic substituent. Note that the definitions of the signs in the formulae are applied only in this formulae. 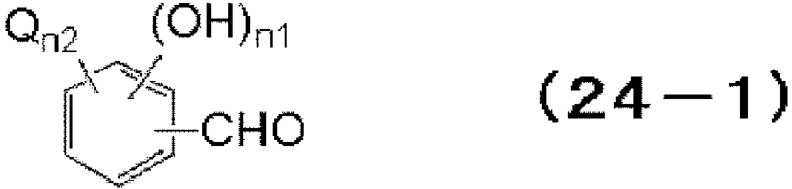 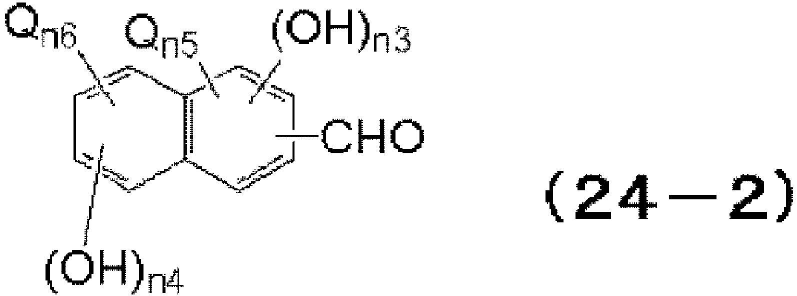 In the general formula (24-1) and the general formula (24-2), Q represents an optionally substituted organic group having 1 to 30 carbon atoms, furthermore, any two Q freely selected in the molecule are optionally bonded to form a cyclic substituent. n1 to n6 represent a number of each substituent, and n1 to n6 = 0, 1, or 2. The formula (24-1) excludes hydroxybenzaldehyde. The formula (24-2) satisfies relationships of 0 ≤ n3+n5 ≤ 3, 0 ≤ n4+n6 ≤ 4, and 1 ≤ n3+n4 ≤ 4. Note that the definitions of the signs in the formulae are applied only in this formulae.

Polymers obtained by condensing: one or more kinds of compounds represented by the general formulae (23-1) and/or (23-2); one or more kinds of compounds represented by the general formulae (24-1) and/or (24-2), and/or equivalents thereof; and one or more kinds of compounds represented by the general formula (25) and/or equivalents thereof can be exemplified.

Y-CHO (25)

In the formula (25), Y represents a hydrogen atom or an optionally substituted monovalent organic group having 30 or less carbon atoms. The formula (25) differs from the general formula (24-1) and the general formula (24-2). Note that the definitions of the signs in the formula are applied only in this formula.

Examples of (A) the material for forming an organic film used in the present invention further include resins having the following structure, described in JP 2017-119671 A. 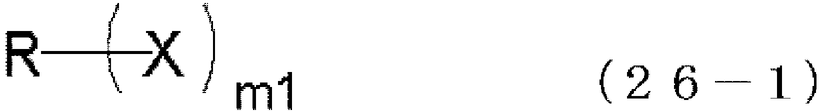 In the formula (26-1), R represents a single bond or an organic group having 1 to 50 carbon atoms; X represents a group represented by the following general formula (26-2); and m1 represents an integer satisfying 2 ≤ m1 ≤ 10. Note that the definitions of the signs in the formula are applied only in this formula. 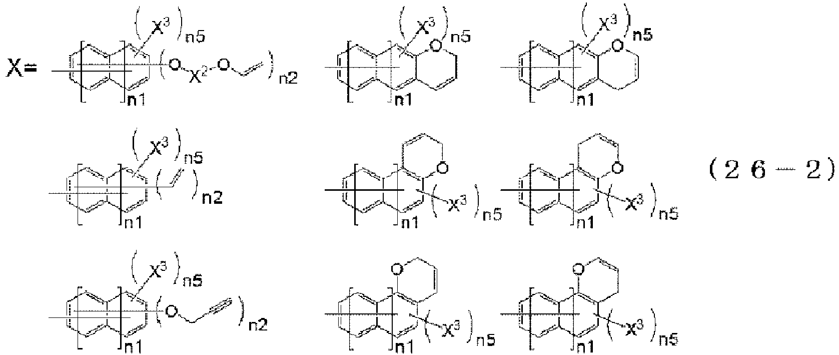 In the formula, X² represents a divalent organic group having 1 to 10 carbon atoms; n1 represents 0 or 1; n2 represents 1 or 2; X³ represents a group represented by the following general formula (26-3); and n5 represents 0, 1, or 2. Note that the definitions of the signs in the formula are applied only in this formula. 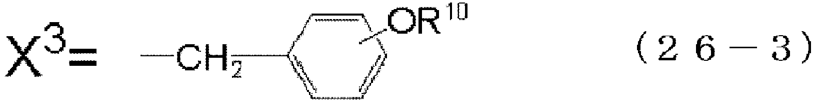 In the formula, R¹⁰ represents a hydrogen atom or a saturated or unsaturated hydrocarbon group having 1 to 10 carbon atoms. In the formula, a hydrogen atom on the benzene ring is optionally substituted with a methyl group or a methoxy group. Note that the definitions of the signs in the formula are applied only in this formula.

Examples of the compounds having the above structure include the following compounds.

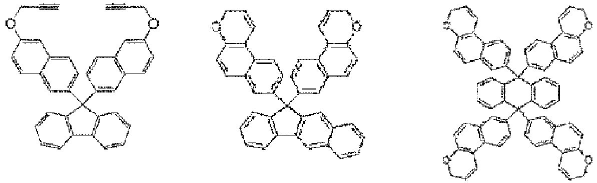

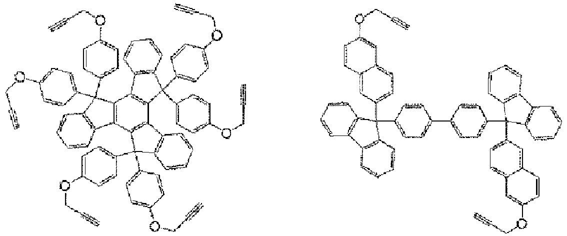

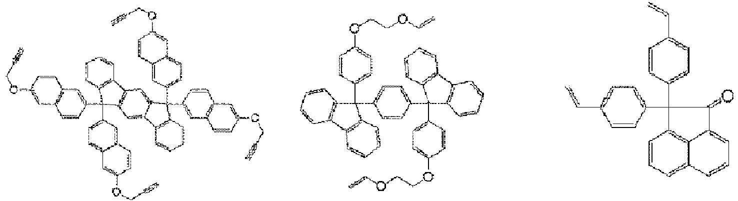

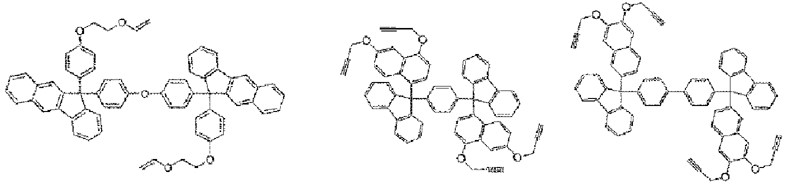

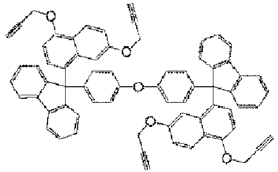

Examples of (A) the material for forming an organic film used in the present invention further include polymers having a repeating unit represented by the following general formula (27-1), described in JP 2019-44022 A. 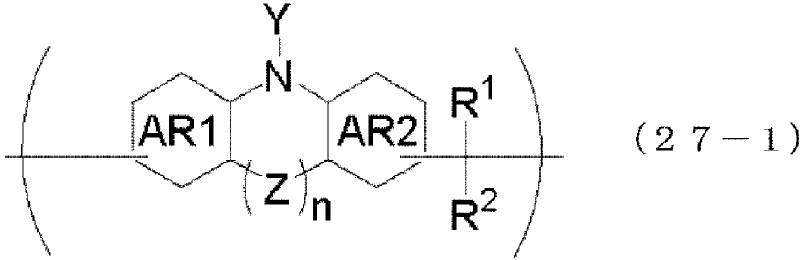 In the formula (27-1), AR1 and AR2 represent an optionally substituted benzene ring or naphthalene ring; R¹ and R² each independently represent a hydrogen atom or an organic group having 1 to 30 carbon atoms, and when R¹ and R² represent the organic groups, R¹ and R² are optionally bonded in the molecule to form a cyclic organic group. "n" represents 0 or 1, when n=0, AR1 and AR2 do not form a bridged structure of the aromatic rings of AR1 and AR2 via Z, and when n=1, AR1 and AR2 form a bridged structure of the aromatic rings of AR1 and AR2 via Z; and Z represents a single bond or any one group represented by the following formula (27-2). Y represents a group represented by the following formula (27-3). Note that the definitions of the signs in the formula are applied only in this formula. 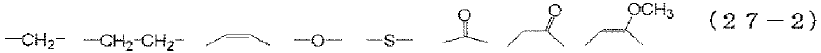 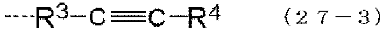 In the formula (27-3), R³ represents a single bond or a divalent organic group having 1 to 20 carbon atoms; R⁴ represents a hydrogen atom or a monovalent organic group having 1 to 20 carbon atoms; and a broken line represents an attachment point. Note that the definitions of the signs in the formula are applied only in this formula.

Examples of the polymers having the repeating unit represented by the above general formula (27-1) include the following polymers.

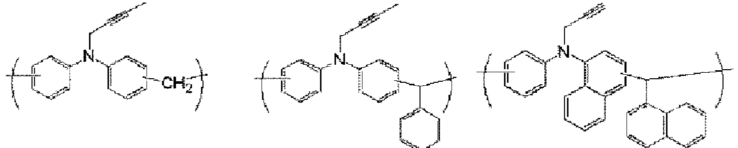

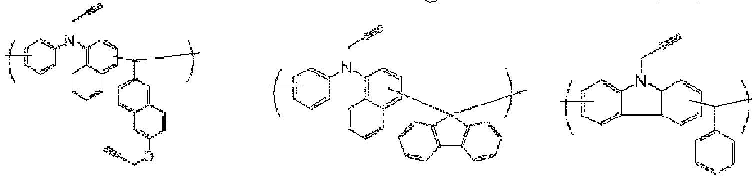

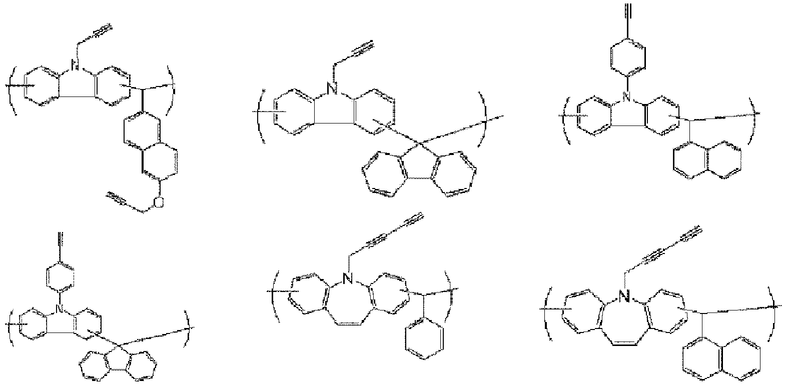

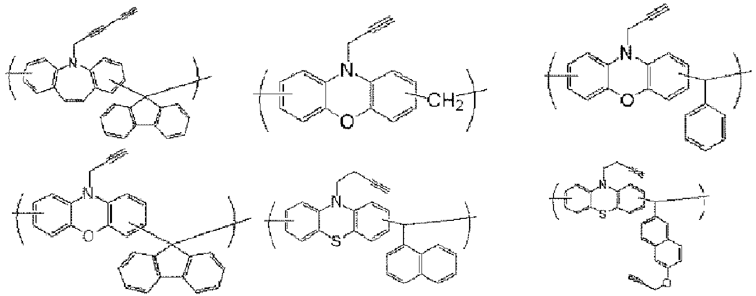

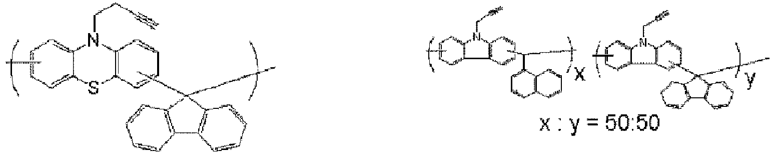

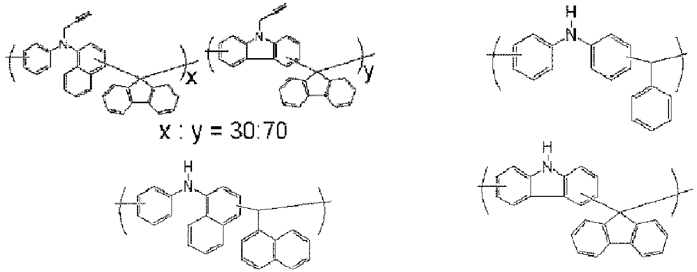

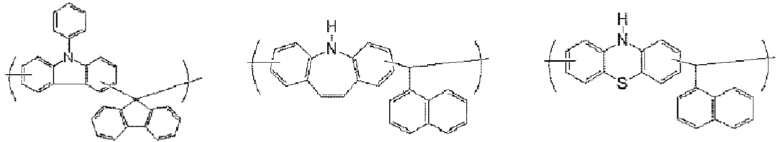

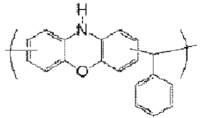

(A) the material for forming an organic film may be synthesized by known methods, or commercially available products may be used.

A blending amount of (A) the material for forming an organic film is not particularly limited as long as the film formability with spin-coating of the composition for forming an organic film is satisfied. The content of (A) the material for forming an organic film is preferably 10 to 40 parts by mass, more preferably 10 to 30 parts by mass, and further preferably 10 to 25 parts by mass relative to 100 parts by mass of the composition for forming an organic film. For example, when holes or trenches with an extremely high aspect ratio for 3D NAND memory architecture are filled with the composition for forming an organic film, the blending amount of the material for forming an organic film needs to be increased. Meanwhile, such a composition for forming an organic film has high viscosity to deteriorate in-plane uniformity and filling properties after spin-coating. The composition for forming an organic film of the present invention can be suitably applied because the composition can form the organic film having excellent in-plane uniformity and filling properties even with the above blending proportion of (A) the material for forming an organic film.

A content of (B) the polymer is preferably 0.01 part by mass to 5 parts by mass relative to 100 parts by mass of (A) the material for forming an organic film. The composition for forming an organic film containing the polymer at the above content yields the formed organic film having more excellent in-plane uniformity.

### (C) Solvent

(C) the solvent usable in the material for forming an organic film of the present invention is not particularly limited as long as it can dissolve (A) the material for forming an organic film and (B) the polymer. Favorably, the solvent can also dissolve an acid generator, a crosslinking agent, a surfactant, etc., described later. Specifically, solvents having a boiling point of lower than 180°C such as solvents described in paragraphs (0091) to (0092) in JP 2007-199653 A may be used, for example. Among these, propylene glycol monomethyl ether acetate, propylene glycol monomethyl ether, 2-heptanone, cyclopentanone, cyclohexanone, and a mixture of two or more thereof are preferably used.

A content of (C) the solvent is 200 to 10,000 parts by mass, and more preferably 300 to 5,000 parts relative to 100 parts by mass of (A) the material for forming an organic film. The content within the above range can regulate the concentration according to the desired film thickness.

As the organic solvent being (C) the solvent for the material for forming an organic film of the present invention, a high-boiling-point solvent having a boiling point of 180°C or higher may be added into the solvent having a boiling point of lower than 180°C (a mixture of the solvent having a boiling point of lower than 180°C and a solvent having a boiling point of 180°C or higher). The high-boiling-point solvent is not particularly limited to hydrocarbons, alcohols, ketones, esters, ethers, and chlorine solvents as long as the solvent can dissolve (A) the material for forming an organic film and (B) the polymer. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, and dibutyl adipate. These solvents may be used singly, or may be mixed for use.

The boiling point of the high-boiling-point solvent is appropriately selected depending on a temperature at which (A) the material for forming an organic film is thermally treated. The boiling point of the added high-boiling-point solvent is preferably 180°C to 300°C, and further preferably 200°C to 300°C. Such a boiling point has no risk of excessively fast evaporation during baking (the thermal treatment) due to an excessively low boiling point, and yields the sufficient thermal flowability. In addition, such a boiling point eliminates evaporation failure and remaining of the solvent in the film due to an excessively high boiling point even after the baking, and thereby has no risk of an adverse effect on the film properties such as etching resistance.

When the above high-boiling-point solvent is used, a blending amount of the high-boiling-point solvent is preferably 1 to 30 parts by mass relative to 100 parts by mass of the solvent having a boiling point of lower than 180°C. Such a blending amount is an appropriate blending amount that can impart sufficient thermal flowability during the baking, and has no risk of remaining of the solvent in the film, which lead to cause deterioration of the film properties such as etching resistance.

The composition for forming an organic film as above imparts the thermal flowability with adding the high-boiling-point solvent to (A) the material for forming an organic film, resulting in the composition for forming an organic film having both of high filling properties and excellent planarization properties.

### Other Components

With the composition for forming an organic film of the present invention, an acid generator and a crosslinking agent to further promote the crosslinking reaction may be added. The acid generator includes an acid generator to generate an acid by pyrolysis and an acid generator to generate an acid by light irradiation, and any of them may be added. Specific examples of the acid generator include acid generators described in paragraphs (0061) to (0085) of JP 2007-199653 A**.** The acid generator may be used singly or in combination of two or more thereof. An addition amount of the acid generator, if added, is preferably 0.05 to 50 parts by mass, and more preferably 0.1 to 10 parts by mass relative to 100 parts by mass of (A) the material for forming an organic film. The amount as above can enhance the crosslinking reaction to form the dense film.

Specific examples of the crosslinking agent include crosslinking agents described in paragraphs (0055) to (0060) of JP 2007-199653 A. The crosslinking agent may be used singly or in combination of two or more thereof. An addition amount of the crosslinking agent is preferably 1 to 100 parts by mass, and more preferably 5 to 50 parts by mass relative to 100 parts by mass of (A) the material for forming an organic film. The amount as above can enhance the curability to further inhibit intermixing with the upper layer film.

With the composition for forming an organic film of the present invention, an additional surfactant other than (B) the polymer of the present invention may be added to further improve the in-plane uniformity with spin-coating. Specific examples of the additional surfactant include surfactants described in paragraphs

(0142) to (0147) in JP 2009-269953 A. The additional surfactant may be used singly or in combination of two or more thereof. An addition amount of the additional surfactant, if added, is preferably 0.01 to 10 parts by mass, and more preferably 0.05 to 5 parts by mass relative to 100 parts by mass of the material for forming an organic film. The amount as above can form the organic film having excellent in-plane uniformity.

With the composition for forming an organic film of the present invention, a basic compound to improve storage stability may be further added. The basic compound prevents proceeding of the crosslinking reaction due to a small amount of an acid generated from the acid generator, and plays a role of a quencher against the acid. Specific examples of such a basic compound include compounds described in paragraphs

(0086) to (0090) of JP 2007-199653 A. The basic compound may be used singly or in combination of two or more thereof. An addition amount of the basic compound, if added, is preferably 0.05 to 50 parts by mass, and more preferably 0.1 to 10 parts by mass relative to 100 parts by mass of (A) the material for forming an organic film. The amount as above can improve storage stability of the composition for forming an organic film.

As above, the composition for forming an organic film of the present invention is the composition for forming an organic film having excellent hump-reducing properties in the EBR process. Therefore, the composition for forming an organic film of the present invention is extremely useful as a resist underlayer film material (an organic film material) for a multilayer resist process such as: a two-layer resist process; a three-layer resist process using a silicon-containing resist middle film or a silicon-containing inorganic hard mask middle film; and a four-layer resist process using a silicon-containing resist middle film or a silicon-containing inorganic hard mask middle film, and an organic anti-reflective film or an adhesion film.

### Method for Forming Organic Film

The present invention provides a method for forming an organic film used in a production process of a semiconductor apparatus, the method including steps of: applying the composition for forming an organic film of the present invention on a substrate to be processed by spin-coating to obtain a coating film; and subjecting the coating film to a thermal treatment within a range of a temperature of 100°C or higher and 600°C or lower for 10 to 600 seconds for curing to form an organic film. For example, the substrate on which the above composition for forming an organic film is applied is subjected to the thermal treatment within the temperature and the time within the ranges for curing to form the organic film.

In this method for forming an organic film, the above composition for forming an organic film of the present invention is firstly applied rotationally on the substrate to be processed (spin-coating). Use of the spin-coating method can yield good filling properties. After the coating on the edge is removed in the EBR process, baking (a thermal treatment) is performed in order to promote the crosslinking reaction. This baking can evaporate the solvent in the composition, and thereby can prevent mixing even when the resist upper layer film or the silicon-containing resist middle film is formed on the organic film.

The baking is preferably performed at a temperature of 100°C or higher and 600°C or lower within a range of 10 to 600 seconds, and more preferably performed at a temperature of 200°C or higher and 500°C or lower within a range of 10 to 300 seconds. With considering effects on device damage and wafer deformation, an upper limit of the heating temperature in the wafer process with lithography is preferably 600°C or lower, and more preferably 500°C or lower. The thermal treatment under such conditions can promote the crosslinking reaction to form an organic film without mixing with the film to be formed above.

### Patterning Process

Hereinafter, a patterning process using the composition for forming an organic film of the present invention will be described.

### Three-Layer Resist Process Using Silicon-Containing Resist Middle Film

The present invention provides a patterning process including steps of:
forming an organic film on a body to be processed by using the composition for forming an organic film of the present invention;
forming a silicon-containing resist middle film on the organic film by using a silicon-containing resist middle film material;
forming a resist upper layer film on the silicon-containing resist middle film by using a resist upper layer film material including a photoresist composition;
forming a circuit pattern in the resist upper layer film, and transferring the pattern to the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

As the body to be processed, for example, a semiconductor apparatus substrate, or a substrate in which any of a metal film, a metal carbide film, a metal oxide film, a metal nitride film, a metal oxycarbide film, and a metal oxynitride film is formed on the semiconductor apparatus substrate is preferably used. More specifically, a substrate such as Si, α-Si, p-Si, SiO₂, SiN, SiON, W, TiN, and Al; a substrate in which the above metal film, etc. is formed on the substrate as a layer to be processed; etc. are used, but the body to be processed is not particularly limited thereto.

As the layer to be processed, for example, various low-k films such as Si, SiO₂, SiON, SiN, p-Si, α-Si, W, W-Si, Al, Cu, and Al-Si, and stopper films thereof are used. The layer to be processed can be formed to have a thickness of typically 50 to 10,000 nm, and particularly 100 to 5,000 nm. When the layer to be processed is formed, the substrate and the layer to be processed having different materials are used.

A body to be processed in which a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof is preferably used.

When the organic film is formed on the body to be processed by using the composition for forming an organic film of the present invention, the above method for forming an organic film of the present invention is applied, for example. The method is not limited thereto.

Then, the resist middle film (the silicon-containing resist middle film) is formed on the organic film by using the resist middle film material containing a silicon atom. As the resist middle film material containing a silicon atom, a polysiloxane-based middle film material is preferable. Imparting an anti-reflective effect to the silicon-containing resist middle film can inhibit reflection. In particular, using a material for 193-nm exposure containing a large amount of aromatic groups and having high etching selectivity to the substrate as the composition for forming an organic film increases the k-value to increase the substrate reflection. However, the silicon-containing resist middle film having the absorption so as to have an appropriate k-value can inhibit the reflection, resulting in the substrate reflection of 0.5% or less. Preferably used for the silicon-containing resist middle film having the anti-reflective effect are an anthryl group for 248-nm or 157-nm exposure, and a polysiloxane crosslinkable with an acid or heat for 193-nm exposure. The polysiloxane has a light absorption group having a phenyl group or a silicon-silicon bond as the pendant structure.

Then, the resist upper layer film is formed on the silicon-containing resist middle film by using the resist upper layer film material composed of the photoresist composition. The resist upper layer film material may be any of positive-type or negative-type, and a material same as commonly used photoresist compositions may be used. After the resist upper layer film material is applied by spin-coating, the pre-baking is preferably performed within a range at 60 to 180°C for 10 to 300 seconds. Thereafter, the exposure, then post exposure baking (PEB), and development are performed in accordance with common methods to obtain the resist upper layer film pattern. A thickness of the resist upper layer film is not particularly limited, and preferably 30 to 500 nm, particularly preferably 50 to 400 nm.

Then, the circuit pattern (the resist upper layer film pattern) is formed in the resist upper layer film. The circuit pattern is preferably formed by lithography using light having a wavelength of 10 nm or longer and 300 nm or shorter, direct writing with electron beam, nanoimprinting, or a combination thereof.

Examples of the exposure light include high-energy ray having a wavelength of 300 nm or shorter, and specifically, far ultraviolet ray, KrF excimer laser light (248 nm), ArF excimer laser light (193 nm), F₂ laser light (157 nm), Kr₂ laser light (146 nm), Ar₂ laser light (126 nm), soft X-ray (EUV) with 3 to 20 nm, electron beam (EB), ion beam, and X-ray.

The circuit pattern is preferably developed with alkaline development or an organic solvent.

Then, the pattern is transferred to the silicon-containing resist middle film by etching while using the resist upper layer film having the formed circuit pattern as a mask. The etching of the silicon-containing resist middle film while using the resist upper layer film pattern as a mask is preferably performed by using a fluorocarbon-type gas. This etching transfers the pattern (the silicon-containing resist middle film pattern) to the silicon-containing resist middle film.

Then, the pattern is transferred to the organic film by etching while using the silicon-containing resist middle film having the transferred pattern (the silicon-containing resist middle film pattern) as a mask. Since the silicon-containing resist middle film has etching resistance against oxygen gas or hydrogen gas, the etching of the organic film while using the silicon-containing resist middle film pattern as a mask is preferably performed by using an etching gas mainly composed of oxygen gas or hydrogen gas. This etching transfers the pattern to the organic film (the organic film pattern).

Then, the pattern is formed on the body to be processed by etching while using the organic film having the transferred pattern (the organic film pattern) as a mask.

The subsequent etching of the body to be processed (the layer to be processed) may be performed by a common method. For example, when the body to be processed is a SiO₂-type, SiN-type, or silica-type low dielectric-constant insulative film, the etching is performed mainly using a fluorocarbon-type gas. When the body to be processed is p-Si, Al, or W, the etching is performed mainly using a chlorine-type or bromine-type gas. When the substrate is processed by etching with the fluorocarbon-type gas, the silicon-containing resist middle film pattern is simultaneously removed with processing of the body to be processed. Meanwhile, when the body to be processed is processed by etching with the chlorine-type or bromine-type gas, dry-etching removal with the fluorocarbon-type gas is required to be separately performed after processing of the body to be processed in order to remove the silicon-containing resist middle film pattern.

The organic film obtained by using the composition for forming an organic film of the present invention has excellent etching resistance during the etching of the body to be processed as above.

### Four-Layer Resist Method Using Silicon-Containing Resist Middle Film and Organic Anti-Reflective Film or Adhesion Film

The present invention provides a patterning process including steps of:
forming an organic film on a body to be processed by using the composition for forming an organic film of the present invention;
forming a silicon-containing resist middle film on the organic film by using a silicon-containing resist middle film material, and forming an organic anti-reflective film or an adhesion film on the silicon-containing resist middle film;
forming a resist upper layer film on the organic anti-reflective film or the adhesion film by using a resist upper layer film material including a photoresist composition, and forming a circuit pattern in the resist upper layer film;
transferring the pattern to the organic anti-reflective film or the adhesion film and the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

This method can be performed in the same manner as the above three-layer resist method using the silicon-containing resist middle film except that the organic anti-reflective film (BARC) or the adhesion film is formed between the silicon-containing resist middle film and the resist upper layer film.

The organic anti-reflective film and the adhesion film may be formed with spin-coating by using a known organic anti-reflective film material.

### Three-Layer Resist Process Using Inorganic Hard Mask Middle Film

The present invention provides a patterning process including steps of:
forming an organic film on a body to be processed by using the composition for forming an organic film of the present invention;
forming an inorganic hard mask middle film selected from the group consisting of a silicon oxide film, a silicon nitride film, and a silicon oxynitride film on the organic film;
forming a resist upper layer film on the inorganic hard mask middle film by using a resist upper layer film material including a photoresist composition;
forming a circuit pattern in the resist upper layer film;
transferring the pattern to the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask.

This method can be performed in the same manner as the above three-layer resist method using the silicon-containing resist middle film except that the inorganic hard mask middle film is formed instead of the silicon-containing resist middle film on the organic film.

The inorganic hard mask middle film selected from the group consisting of a silicon oxide film, a silicon nitride film, and a silicon oxynitride film (a SiON film) can be formed by a CVD method, an ALD method, etc. The method for forming the silicon nitride film is described in, for example, JP 2002-334869 A, WO 2004/066377, etc. A film thickness of the inorganic hard mask middle film is preferably 5 to 200 nm, and more preferably 10 to 100 nm. As the inorganic hard mask middle film, the SiON film, which is highly effective as the anti-reflective film, is most preferably used.

### Four-Layer Resist Process Using Inorganic Hard Mask Middle Film and Organic Anti-Reflective Film or Adhesion Film

The present invention provides a patterning process including steps of:
forming an organic film on a body to be processed by using the composition for forming an organic film of the present invention;
forming an inorganic hard mask middle film selected from the group consisting of a silicon oxide film, a silicon nitride film, and a silicon oxynitride film on the organic film;
forming an organic anti-reflective film or an adhesion film on the inorganic hard mask middle film, and forming a resist upper layer film on the organic anti-reflective film or the adhesion film by using a resist upper layer film material including a photoresist composition;
forming a circuit pattern in the resist upper layer film;
transferring the pattern to the organic anti-reflective film or the adhesion film and the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask.

This method can be performed in the same manner as the above three-layer resist method using the inorganic hard mask middle film except that the organic anti-reflective film (BARC) or the adhesion film is formed between the inorganic hard mask middle film and the resist upper layer film.

In particular, when the SiON film is used as the inorganic hard mask middle film, the reflection can be inhibited by the two anti-reflective films of the SiON film and the BARC even with immersion exposure having a high NA of more than 1.0. Another merit of forming the BARC is an effect of reducing bottom footing of the resist upper layer film pattern just on the SiON film.

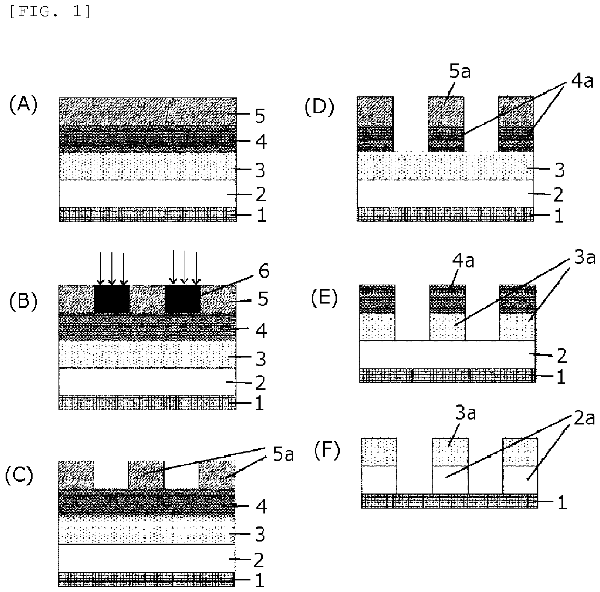

Here, an example of the patterning process of the present invention with the three-layer resist process is described in FIGS. 1(A) to (F). In the three-layer resist process, as illustrated in FIG. 1(A), an organic film 3 is formed by using the composition for forming an organic film of the present invention on a layer 2 to be processed (a body 2 to be processed) formed on a substrate 1, then a silicon-containing resist middle film 4 is formed on the organic film 3, and a resist upper layer film 5 is formed thereon. Then, as illustrated in FIG. 1(B), an exposure portion 6 in the resist upper layer film 5 is exposed, and then post exposure baking (PEB) is performed. Thereafter, as illustrated in FIG. 1(C), development is performed to form a resist upper layer film pattern 5a. Subsequently, as illustrated in FIG. 1(D), the silicon-containing resist middle film 4 is processed by dry etching using a fluorocarbon-type gas while using the resist upper layer film pattern 5a as a mask to form a silicon-containing resist middle film pattern 4a. Then, the resist upper layer film pattern 5a is removed, and then, as illustrated in FIG. 1(E), the organic film 3 is etched with oxygen plasma while using the silicon-containing resist middle film pattern 4a as a mask to form an organic film pattern 3a. Further, as illustrated FIG. 1(F), the silicon-containing resist middle film pattern 4a is removed, and then the layer 2 to be processed is processed by etching while using the organic film pattern 3a as a mask to form a pattern 2a.

In the patterning process of this example, humps during the formation of the organic film 3 can be reduced to reduce defects generated during the dry-etching processing in FIGS. 1(D), (E), and (F) derived from the humps on the organic film.

When the inorganic hard mask middle film is formed, the silicon-containing resist middle film 4 is replace with the inorganic hard mask middle film. When the BARC or the adhesive film is formed, the BARC or the adhesive film is formed between the silicon-containing resist middle film 4 and the resist upper layer film 5. The BARC or the adhesion film may be subsequently etched prior to the etching of the silicon-containing resist middle film 4. Alternatively, only the BARC or the adhesion film may be etched, and then the etching apparatus may be changed, etc. to etch the silicon-containing resist middle film 4.

As above, the patterning process of the present invention can form a fine pattern in the body to be processed with high accuracy using the multilayer resist process, and can reduce formation of humps on the organic film to reduce defects derived from the humps on the organic film.

### EXAMPLE

Hereinafter, the present invention will be described further specifically with showing Synthesis Examples, Comparative Synthesis Examples, Examples, and Comparative Examples, but the present invention is not limited by these examples. Molecular weights were measured by the following specific method. Determined were a weight-average molecular weight (Mw) and a number-average molecular weight (Mn) in terms of polystyrene by gel permeation chromatography (GPC) under a condition at a temperature of 40°C with tetrahydrofuran as an eluent (a solvent), and a dispersion degree (Mw/Mn) was determined.

### Synthesis of Polymers (B-1) to (B-12)

For synthesizing compounds (B-1) to (B-12) used for preparing compositions for forming an organic film (UDL-1 to 77) of Examples, the following dithiol compounds (a1) to (a3) and diallyl compounds (b1) to (b8) were used.

### (Dithiol Compounds)

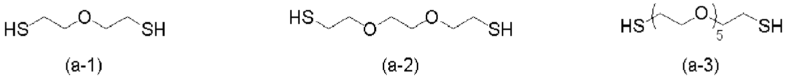

### (Diallyl Compounds and Monoallyl Compounds)

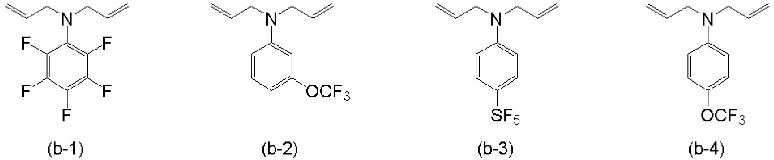

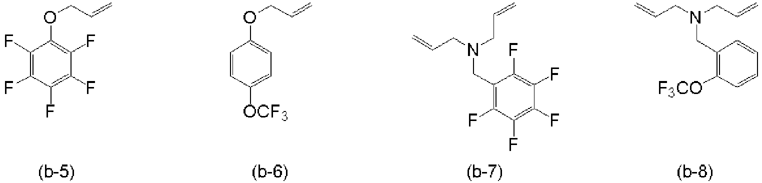

### Synthesis Example 1: Synthesis of Polymer (B-1)

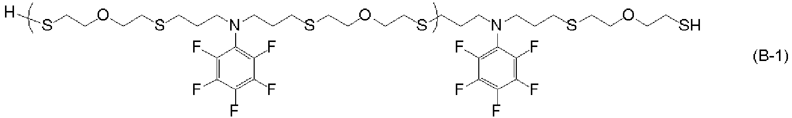

Into 2.76 g of the dithiol compound (a1) and 3.51 g of the diallyl compound (b1), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 41.8 g of a PGMEA solution of a polymer (B-1) (compound concentration: 15%).

The weight-average molecular weight (Mw) and the dispersion degree (Mw/Mn) were determined by GPC. The results were as follows.
(B-1): Mw = 1710, Mw/Mn = 2.09

### Synthesis Example 2: Synthesis of Polymer (B-2)

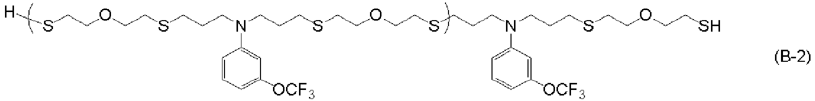

Into 2.76 g of the dithiol compound (a1) and 3.43 g of the diallyl compound (b2), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 41.3 g of a PGMEA solution of a polymer (B-2) (compound concentration: 15%).

The weight-average molecular weight (Mw) and the dispersion degree (Mw/Mn) were determined by GPC. The results were as follows.
(B-2): Mw = 1650, Mw/Mn = 2.14

### Synthesis Example 3: Synthesis of Polymer (B-3)

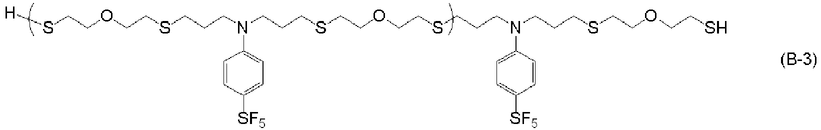

Into 2.76 g of the dithiol compound (a1) and 3.99 g of the diallyl compound (b3), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 45.0 g of a PGMEA solution of a polymer (B-3) (compound concentration: 15%).

The weight-average molecular weight (Mw) and the dispersion degree (Mw/Mn) were determined by GPC. The results were as follows.
(B-3): Mw = 1750, Mw/Mn = 2.15

### Synthesis Example 4: Synthesis of Polymer (B-4)

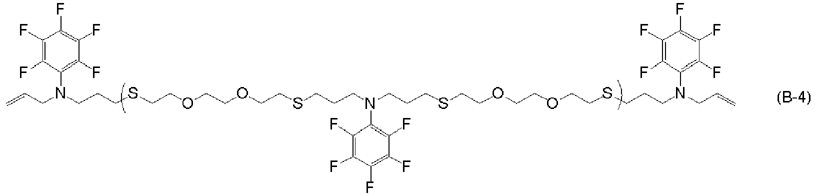

Into 2.43 g of the dithiol compound (a2) and 5.26 g of the diallyl compound (b1), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 51.3 g of a PGMEA solution of a polymer (B-4) (compound concentration: 15%).

The weight-average molecular weight (Mw) and the dispersion degree (Mw/Mn) were determined by GPC. The results were as follows.
(B-4): Mw = 1920, Mw/Mn = 2.39

### Synthesis Example 5: Synthesis of Polymer (B-5)

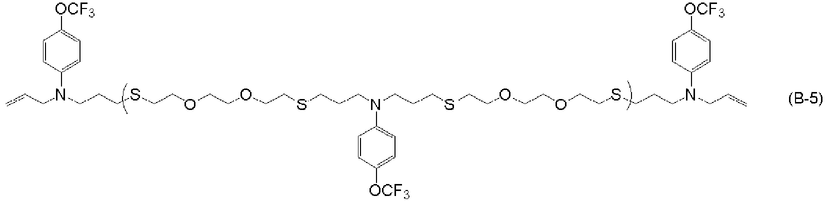

Into 2.43 g of the dithiol compound (a2) and 5.14 g of the diallyl compound (b4), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 50.5 g of a PGMEA solution of a polymer (B-5) (compound concentration: 15%).

The weight-average molecular weight (Mw) and the dispersion degree (Mw/Mn) were determined by GPC. The results were as follows.
(B-5): Mw = 1870, Mw/Mn = 2.21

### Synthesis Example 6: Synthesis of Polymer (B-6)

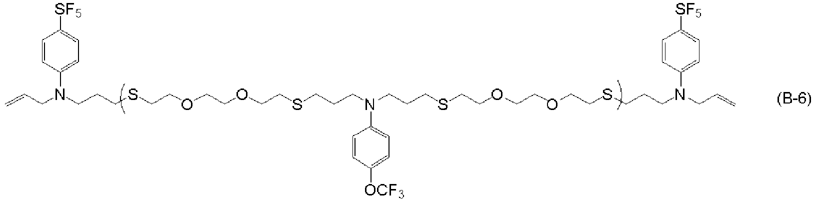

Into 2.43 g of the dithiol compound (a2) and 5.99 g of the diallyl compound (b3), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 56.1 g of a PGMEA solution of a polymer (B-6) (compound concentration: 15%).

The weight-average molecular weight (Mw) and the dispersion degree (Mw/Mn) were determined by GPC. The results were as follows.
(B-6): Mw = 1970, Mw/Mn = 2.41

### Synthesis Example 7: Synthesis of Polymer (B-7)

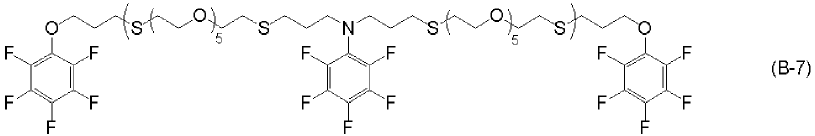

Into 6.29 g of the dithiol compound (a3), 3.51 g of the diallyl compound (b1), and 2.99 g of the monoallyl compound (b5), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 61.7 g of a PGMEA solution of a polymer (B-7) (compound concentration: 15%).

The weight-average molecular weight (Mw) and the dispersion degree (Mw/Mn) were determined by GPC. The results were as follows.
(B-7): Mw = 2420, Mw/Mn = 2.74

### Synthesis Example 8: Synthesis of Polymer (B-8)

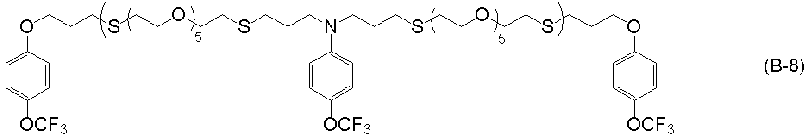

Into 6.29 g of the dithiol compound (a3), 3.43 g of the diallyl compound (b4), and 2.91 g of the diallyl compound (b6), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 60.7 g of a PGMEA solution of a polymer (B-8) (compound concentration: 15%).

The weight-average molecular weight (Mw) and the dispersion degree (Mw/Mn) were determined by GPC. The results were as follows.
(B-8): Mw = 2390, Mw/Mn = 2.78

### Synthesis Example 9: Synthesis of Polymer (B-9)

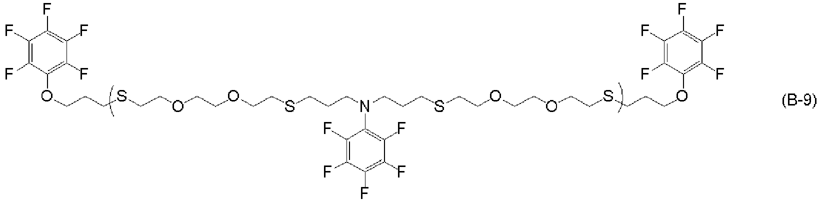

Into 3.65 g of the dithiol compound (a2), 3.51 g of the diallyl compound (b1), and 2.99 g of the diallyl compound (b5), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 67.7 g of a PGMEA solution of a polymer (B-9) (compound concentration: 15%).

The weight-average molecular weight (Mw) and the dispersion degree (Mw/Mn) were determined by GPC. The results were as follows.
(B-9): Mw = 1470, Mw/Mn = 2.44

### Synthesis Example 10: Synthesis of Polymer (B-10)

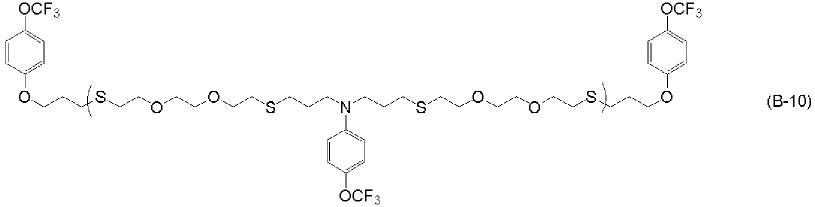

Into 3.65 g of the dithiol compound (a2), 3.43 g of the diallyl compound (b4), and 2.91 g of the monoallyl compound (b6), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 66.6 g of a PGMEA solution of a polymer (B-10) (compound concentration: 15%).

The weight-average molecular weight (Mw) and the dispersion degree (Mw/Mn) were determined by GPC. The results were as follows.
(B-10): Mw = 1520, Mw/Mn = 2.39

### Synthesis Example 11: Synthesis of Polymer (B-11)

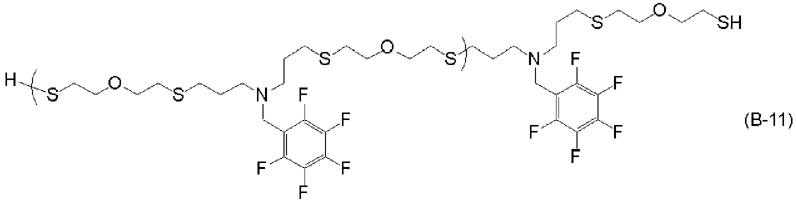

Into 3.65 g of the dithiol compound (a1) and 3.70 g of the diallyl compound (b7), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 49.0 g of a PGMEA solution of a polymer (B-11) (compound concentration: 15%).

The weight-average molecular weight (Mw) and the dispersion degree (Mw/Mn) were determined by GPC. The results were as follows.
(B-11): Mw = 1730, Mw/Mn = 2.11

### Synthesis Example 12: Synthesis of Polymer (B-12)

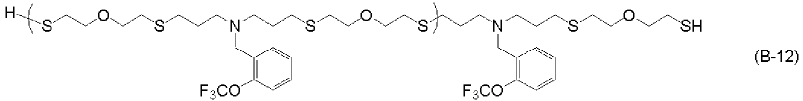

Into 3.65 g of the dithiol compound (a1) and 3.62 g of the diallyl compound (b8), 30.0 g of propylene glycol monoethyl ether acetate (PGMEA) was added, the mixture was stirred to prepare a uniform solution, and then nitrogen bubbling was performed for 15 minutes. Thereafter, 0.22 g of azobisisobutyronitrile (AIBN) was added into this uniform solution, the temperature was raised to 85°C under a nitrogen atmosphere, and the reaction was performed at an internal temperature of 85°C for 24 hours. The reaction liquid was cooled to room temperature, and then diluted with PGMEA to obtain 48.5 g of a PGMEA solution of a polymer (B-12) (compound concentration: 15%).

The weight-average molecular weight (Mw) and the dispersion degree (Mw/Mn) were determined by GPC. The results were as follows.
(B-12): Mw = 1670, Mw/Mn = 2.16

### Synthesis of Comparative Polymers (R1) to (R5)

For synthesizing comparative polymers (R1) to (R5) used for preparing compositions for forming an organic film, the following monomers (r1) to (r6) were used.

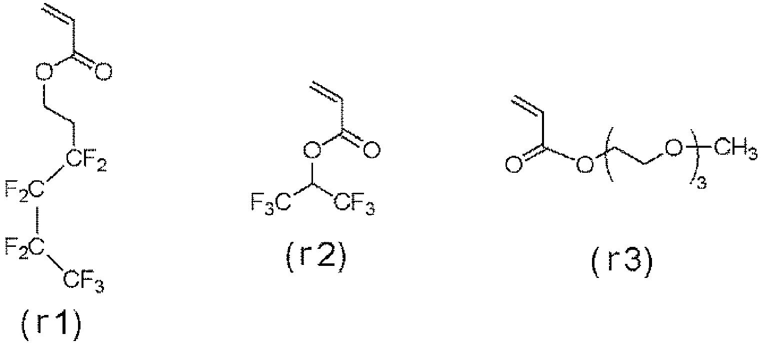

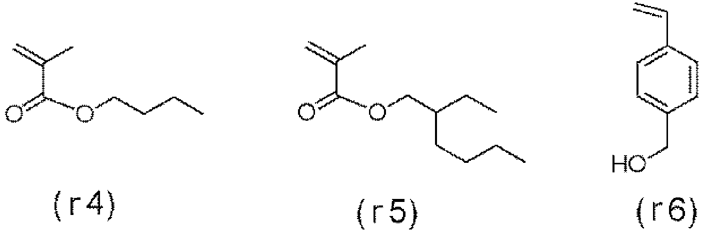

### Comparative Synthesis Example 1: Synthesis of Comparative Polymer (R1)

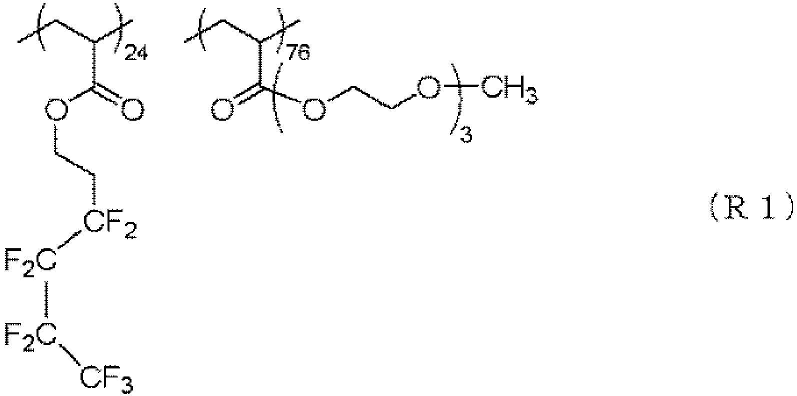

Under a nitrogen atmosphere, 6.0 g of propylene glycol monomethyl ether acetate (PGMEA) was heated and stirred at 80°C. Into this, 3.44 g (0.011 mol) of the monomer (r1), 7.46 g (0.034 mol) of the monomer (r3), and a mixture of 0.473 g of dimethyl 2,2-azobis(2-methylpropionate) and 34 g of PGMEA were dropped over 4 hours. The resultant was further heated and stirred for 16 hours, and then cooled to room temperature to obtain a PGMEA solution of a target comparative polymer (R1).

The weight-average molecular weight (Mw) and the dispersion degree (Mw/Mn) were determined by GPC. The results were as follows.
(R1): Mw = 9,500, Mw/Mn = 1.20

### Comparative Synthesis Example 2: Synthesis of Comparative Polymer (R2)

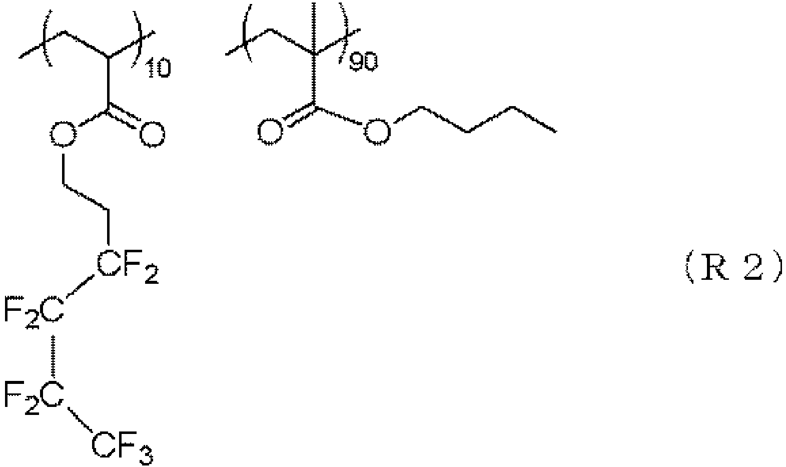

Under a nitrogen atmosphere, 6.0 g of propylene glycol monomethyl ether acetate (PGMEA) was heated and stirred at 80°C. Into this, 1.43 g (0.005 mol) of the monomer (r1), 5.76 g (0.041 mol) of the monomer (r4), and a mixture of 0.473 g of dimethyl 2,2-azobis(2-methylpropionate) and 34 g of PGMEA were dropped over 4 hours. The resultant was further heated and stirred for 16 hours, and then cooled to room temperature to obtain a PGMEA solution of a target comparative polymer (R2).

The weight-average molecular weight (Mw) and the dispersion degree (Mw/Mn) were determined by GPC. The results were as follows.
(R2): Mw = 5,800, Mw/Mn = 1.42

### Comparative Synthesis Example 3: Synthesis of Comparative Polymer (R3)

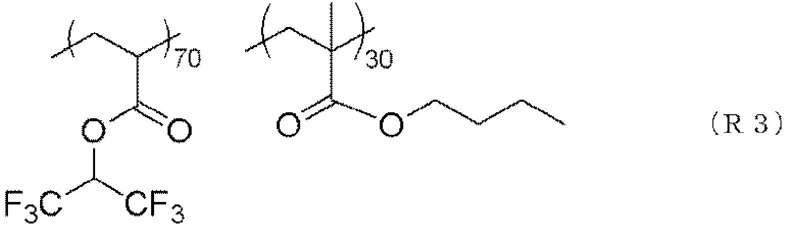

Under a nitrogen atmosphere, 6.0 g of propylene glycol monomethyl ether acetate (PGMEA) was heated and stirred at 80°C. Into this, 7.00 g (0.032 mol) of the monomer (r2), 1.92 g (0.014 mol) of the monomer (r4), and a mixture of 0.473 g of dimethyl 2,2-azobis(2-methylpropionate) and 34 g of PGMEA were dropped over 4 hours. The resultant was further heated and stirred for 16 hours, and then cooled to room temperature to obtain a PGMEA solution of a target comparative polymer (R3).

The weight-average molecular weight (Mw) and the dispersion degree (Mw/Mn) were determined by GPC. The results were as follows.
(R3): Mw = 6,200, Mw/Mn = 1.33

### Comparative Synthesis Example 4: Synthesis of Comparative Polymer (R4)

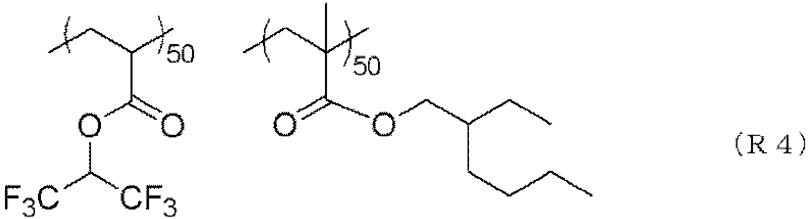

Under a nitrogen atmosphere, 6.0 g of propylene glycol monomethyl ether acetate (PGMEA) was heated and stirred at 80°C. Into this, 5.00 g (0.023 mol) of the monomer (r2), 3.20 g (0.023 mol) of the monomer (r5), and a mixture of 0.473 g of dimethyl 2,2-azobis(2-methylpropionate) and 34 g of PGMEA were dropped over 4 hours. The resultant was further heated and stirred for 16 hours, and then cooled to room temperature to obtain a PGMEA solution of a target comparative polymer (R4).

The weight-average molecular weight (Mw) and the dispersion degree (Mw/Mn) were determined by GPC. The results were as follows.
(R4): Mw = 8,300, Mw/Mn = 1.33

### Comparative Synthesis Example 5: Synthesis of Comparative Polymer (R5)

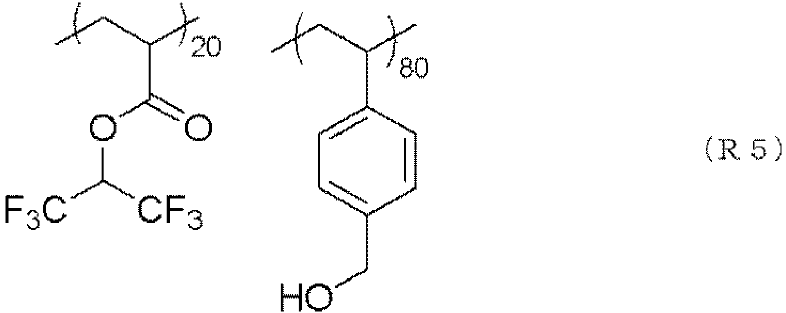

Under a nitrogen atmosphere, 6.0 g of propylene glycol monomethyl ether acetate (PGMEA) was heated and stirred at 80°C. Into this, 2.00 g (0.009 mol) of the monomer (r2), 5.41 g (0.036 mol) of the monomer (r6), and a mixture of 0.473 g of dimethyl 2,2-azobis(2-methylpropionate) and 34 g of PGMEA were dropped over 4 hours. The resultant was further heated and stirred for 16 hours, and then cooled to room temperature to obtain a PGMEA solution of a target comparative polymer (R5).

The weight-average molecular weight (Mw) and the dispersion degree (Mw/Mn) were determined by GPC. The results were as follows.
(R5): Mw = 3,800, Mw/Mn = 1.44

### (A) Material for Forming Organic Film (Resin or Compound)

For preparing compositions for forming an organic film of Examples and Comparative Examples (UDL-1 to 77 and Comparative UDL-1 to 16), the following resins or compounds were used as (A) the material for forming an organic film.
M1: A resin represented by the following formula (M1)
M2: A resin represented by the following formula (M2)
M3: A compound represented by the following formula (M3)
M4: A compound represented by the following formula (M4)
M5: A resin represented by the following formula (M5)
M6: A resin represented by the following formula (M6)

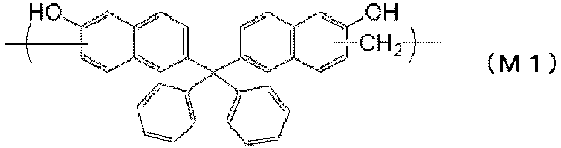

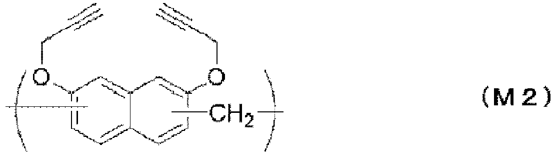

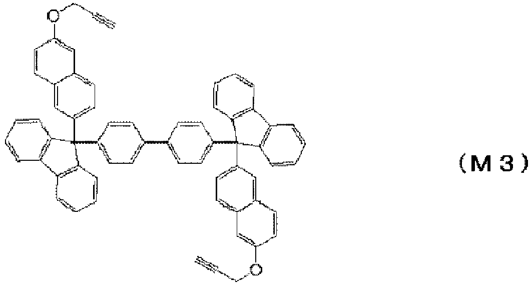

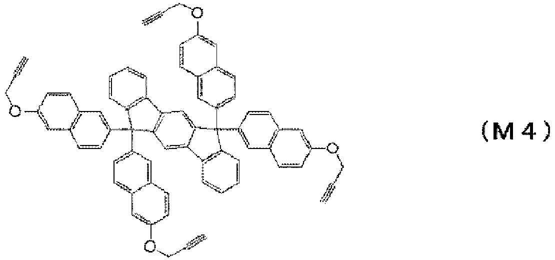

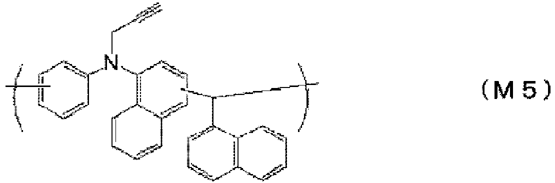

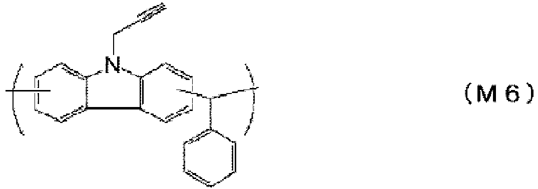

### (C) Solvent

For preparing the compositions for forming an organic film of Examples and Comparative Examples (UDL-1 to 77 and Comparative UDL-1 to 16), the following solvents were each used as (C) the solvent.
(S1): Propylene glycol monomethyl ether acetate
(S2): Propylene glycol monoethyl ether

### Preparation of Composition for Forming Organic Film (UDL-1 to 77 and Comparative UDL-1 to 16)

Any one of the compounds (B-1) to (B-12) and (R1) to (R5) as the polymer, any one of the materials for forming an organic film (M1) to (M6) as the resin for forming an organic film, and one or both of (C) the solvent were dissolved at ratios shown in Table 1 to Table 5. The mixtures obtained as above were filtered with a 0.1-µm filter made of a fluororesin to each prepare organic film materials (resist underlayer film materials: UDL-1 to 77 and Comparative UDL-1 to 10). In addition, any one of the materials for forming an organic film (M1) to (M6) as the material for forming an organic film and the solvent (S1) were dissolved at ratios shown in Table 5. The mixtures obtained as above were filtered with a 0.1-µm filter made of a fluororesin to each prepare compositions for forming an organic film (resist underlayer film materials: Comparative UDL-11 to 16). Table 1 to Table 5 show the results.

**[Table 1]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-1 | (M 1) | 10.00 | (B 1) | 0.10 | (S 1) | 89.90 | | |
| UDL-2 | (M 1) | 10.00 | (B 2) | 0.10 | (S 1) | 89.90 | | |
| UDL-3 | (M 1) | 10.00 | (B 3) | 0.10 | (S 1) | 89.90 | | |
| UDL-4 | (M 1) | 10.00 | (B 4) | 0.10 | (S 1) | 89.90 | | |
| UDL-5 | (M 1) | 10.00 | (B 5) | 0.10 | (S 1) | 89.90 | | |
| UDL-6 | (M 1) | 10.00 | (B 6) | 0.10 | (S 1) | 89.90 | | |
| UDL-7 | (M 1) | 10.00 | (B 7) | 0.10 | (S 1) | 89.90 | | |
| UDL-8 | (M 1) | 10.00 | (B 8) | 0.10 | (S 1) | 89.90 | | |
| UDL-9 | (M 1) | 10.00 | (B 9) | 0.10 | (S 1) | 89.90 | | |
| UDL-10 | (M 1) | 10.00 | (B 10) | 0.10 | (S 1) | 89.90 | | |
| UDL-11 | (M 1) | 10.00 | (B 11) | 0.10 | (S 1) | 89.90 | | |
| UDL-12 | (M 1) | 10.00 | (B 12) | 0.10 | (S 1) | 89.90 | | |
| UDL-13 | (M 1) | 10.00 | (B 1) | 0.10 | (S 1) | 62.93 | (S 2) | 26.97 |
| UDL-14 | (M 1) | 10.00 | (B 6) | 0.10 | (S 1) | 62.93 | (S 2) | 26.97 |
| UDL-15 | (M 1) | 10.00 | (B 12) | 0.10 | (S 1) | 62.93 | (S 2) | 26.97 |
| UDL-16 | (M 1) | 10.00 | (B 5) | 1.00 | (S 1) | 89.00 | | |
| UDL-17 | (M 1) | 10.00 | (B 5) | 0.001 | (S 1) | 90.00 | | |
| UDL-18 | (M 2) | 10.00 | (B 1) | 0.10 | (S 1) | 89.90 | | |
| UDL-19 | (M 2) | 10.00 | (B 2) | 0.10 | (S 1) | 89.90 | | |
| UDL-20 | (M 2) | 10.00 | (B 3) | 0.10 | (S 1) | 89.90 | | |

**[Table 2]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-21 | (M 2) | 10.00 | (B 4) | 0.10 | (S 1) | 89.90 | | |
| UDL-22 | (M 2) | 10.00 | (B 5) | 0.10 | (S 1) | 89.90 | | |
| UDL-23 | (M 2) | 10.00 | (B 6) | 0.10 | (S 1) | 89.90 | | |
| UDL-24 | (M 2) | 10.00 | (B 7) | 0.10 | (S 1) | 89.90 | | |
| UDL-25 | (M 2) | 10.00 | (B 8) | 0.10 | (S 1) | 89.90 | | |
| UDL-26 | (M 2) | 10.00 | (B 9) | 0.10 | (S 1) | 89.90 | | |
| UDL-27 | (M 2) | 10.00 | (B 10) | 0.10 | (S 1) | 89.90 | | |
| UDL-28 | (M 2) | 10.00 | (B 11) | 0.10 | (S 1) | 89.90 | | |
| UDL-29 | (M 2) | 10.00 | (B 12) | 0.10 | (S 1) | 89.90 | | |
| UDL-30 | (M 3) | 10.00 | (B 1) | 0.10 | (S 1) | 89.90 | | |
| UDL-31 | (M 3) | 10.00 | (B 2) | 0.10 | (S 1) | 89.90 | | |
| UDL-32 | (M 3) | 10.00 | (B 3) | 0.10 | (S 1) | 89.90 | | |
| UDL-33 | (M 3) | 10.00 | (B 4) | 0.10 | (S 1) | 89.90 | | |
| UDL-34 | (M 3) | 10.00 | (B 5) | 0.10 | (S 1) | 89.90 | | |
| UDL-35 | (M 3) | 10.00 | (B 6) | 0.10 | (S 1) | 89.90 | | |
| UDL-36 | (M 3) | 10.00 | (B 7) | 0.10 | (S 1) | 89.90 | | |

**[Table 3]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-37 | (M 3) | 10.00 | (B 8) | 0.10 | (S 1) | 89.90 | | |
| UDL-38 | (M 3) | 10.00 | (B 9) | 0.10 | (S 1) | 89.90 | | |
| UDL-39 | (M 3) | 10.00 | (B 10) | 0.10 | (S 1) | 89.90 | | |
| UDL-40 | (M 3) | 10.00 | (B 11) | 0.10 | (S 1) | 89.90 | | |
| UDL-41 | (M 3) | 10.00 | (B 12) | 0.10 | (S 1) | 89.90 | | |
| UDL-42 | (M 4) | 10.00 | (B 1) | 0.10 | (S 1) | 89.90 | | |
| UDL-43 | (M 4) | 10.00 | (B 2) | 0.10 | (S 1) | 89.90 | | |
| UDL-44 | (M 4) | 10.00 | (B 3) | 0.10 | (S 1) | 89.90 | | |
| UDL-45 | (M 4) | 10.00 | (B 4) | 0.10 | (S 1) | 89.90 | | |
| UDL-46 | (M 4) | 10.00 | (B 5) | 0.10 | (S 1) | 89.90 | | |
| UDL-47 | (M 4) | 10.00 | (B 6) | 0.10 | (S 1) | 89.90 | | |
| UDL-48 | (M 4) | 10.00 | (B 7) | 0.10 | (S 1) | 89.90 | | |
| UDL-49 | (M 4) | 10.00 | (B 8) | 0.10 | (S 1) | 89.90 | | |
| UDL-50 | (M 4) | 10.00 | (B 9) | 0.10 | (S 1) | 89.90 | | |
| UDL-51 | (M 4) | 10.00 | (B 10) | 0.10 | (S 1) | 89.90 | | |
| UDL-52 | (M 4) | 10.00 | (B 11) | 0.10 | (S 1) | 89.90 | | |
| UDL-53 | (M 4) | 10.00 | (B 12) | 0.10 | (S 1) | 89.90 | | |

**[Table 4]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-54 | (M 5) | 10.00 | (B 1) | 0.10 | (S 1) | 89.90 | | |
| UDL-55 | (M 5) | 10.00 | (B 2) | 0.10 | (S 1) | 89.90 | | |
| UDL-56 | (M 5) | 10.00 | (B 3) | 0.10 | (S 1) | 89.90 | | |
| UDL-57 | (M 5) | 10.00 | (B 4) | 0.10 | (S 1) | 89.90 | | |
| UDL-58 | (M 5) | 10.00 | (B 5) | 0.10 | (S 1) | 89.90 | | |
| UDL-59 | (M 5) | 10.00 | (B 6) | 0.10 | (S 1) | 89.90 | | |
| UDL-60 | (M 5) | 10.00 | (B 7) | 0.10 | (S 1) | 89.90 | | |
| UDL-61 | (M 5) | 10.00 | (B 8) | 0.10 | (S 1) | 89.90 | | |
| UDL-62 | (M 5) | 10.00 | (B 9) | 0.10 | (S 1) | 89.90 | | |
| UDL-63 | (M 5) | 10.00 | (B 10) | 0.10 | (S 1) | 89.90 | | |
| UDL-64 | (M 5) | 10.00 | (B 11) | 0.10 | (S 1) | 89.90 | | |
| UDL-65 | (M 5) | 10.00 | (B 12) | 0.10 | (S 1) | 89.90 | | |
| UDL-66 | (M 6) | 10.00 | (B 1) | 0.10 | (S 1) | 89.90 | | |
| UDL-67 | (M 6) | 10.00 | (B 2) | 0.10 | (S 1) | 89.90 | | |
| UDL-68 | (M 6) | 10.00 | (B 3) | 0.10 | (S 1) | 89.90 | | |
| UDL-69 | (M 6) | 10.00 | (B 4) | 0.10 | (S 1) | 89.90 | | |
| UDL-70 | (M 6) | 10.00 | (B 5) | 0.10 | (S 1) | 89.90 | | |
| UDL-71 | (M 6) | 10.00 | (B 6) | 0.10 | (S 1) | 89.90 | | |
| UDL-72 | (M 6) | 10.00 | (B 7) | 0.10 | (S 1) | 89.90 | | |

**[Table 5]**

| Composition for forming organic film | Resin for forming organic film | | Polymer | | Solvent 1 | | Solvent 2 | |
|---|---|---|---|---|---|---|---|---|
| | Type | parts by mass | Type | parts by mass | Type | parts by mass | Type | parts by mass |
| UDL-73 | (M 6) | 10.00 | (B 8) | 0.10 | (S 1) | 89.9 | | |
| UDL-74 | (M 6) | 10.00 | (B 9) | 0.10 | (S 1) | 89.9 | | |
| UDL-75 | (M 6) | 10.00 | (B 10) | 0.10 | (S 1) | 89.9 | | |
| UDL-76 | (M 6) | 10.00 | (B 11) | 0.10 | (S 1) | 89.9 | | |
| UDL-77 | (M 6) | 10.00 | (B 12) | 0.10 | (S 1) | 89.9 | | |
| Comparative UDL-1 | (M 1) | 10.00 | (R 1) | 0.10 | (S 1) | 89.9 | | |
| Comparative UDL-2 | (M 2) | 10.00 | (R 1) | 0.10 | (S 1) | 89.9 | | |
| Comparative UDL-3 | (M 3) | 10.00 | (R 1) | 0.10 | (S 1) | 89.9 | | |
| Comparative UDL-4 | (M 4) | 10.00 | (R 1) | 0.10 | (S 1) | 89.9 | | |
| Comparative UDL-5 | (M 5) | 10.00 | (R 1) | 0.10 | (S 1) | 89.9 | | |
| Comparative UDL-6 | (M 6) | 10.00 | (R 1) | 0.10 | (S 1) | 89.9 | | |
| Comparative UDL-7 | (M 1) | 10.00 | (R 2) | 0.10 | (S 1) | 89.9 | | |
| Comparative UDL-8 | (M 1) | 10.00 | (R 3) | 0.10 | (S 1) | 89.9 | | |
| Comparative UDL-9 | (M 1) | 10.00 | (R 4) | 0.10 | (S 1) | 89.9 | | |
| Comparative UDL-10 | (M 1) | 10.00 | (R 5) | 0.10 | (S 1) | 89.9 | | |
| Comparative UDL-11 | (M 1) | 10.00 | | | (S 1) | 90.0 | | |
| Comparative UDL-12 | (M 2) | 10.00 | | | (S 1) | 90.0 | | |
| Comparative UDL-13 | (M 3) | 10.00 | | | (S 1) | 90.0 | | |
| Comparative UDL-14 | (M 4) | 10.00 | | | (S 1) | 90.0 | | |
| Comparative UDL-15 | (M 5) | 10.00 | | | (S 1) | 90.0 | | |
| Comparative UDL-16 | (M 6) | 10.00 | | | (S 1) | 90.0 | | |

### Production of Silicon Wafer with Formed Organic Cured Film Using Compositions for Forming Organic Film (UDL-1 to 77 and Comparative UDL-1 to 16)

By using a coater/developer "CLEAN TRACK LITHIUS Pro AP", available from Tokyo Electron Ltd., 2 mL of the composition for forming an organic film (UDL-1 to 77 and Comparative UDL-1 to 16) prepared above was discharged at a center of a silicon wafer, spread by rotating the wafer at a rotation speed for the average film thickness shown in Tables 6 to 10, and then baked at 350°C to form a coating film of the composition for forming an organic film. While this silicon wafer was rotated at a speed of 1000 rpm and while a removing liquid (a mixed liquid of propylene glycol monomethyl ether acetate and propylene glycol monomethyl ether (30:70 at a mass ratio)) was discharged at a discharge amount of 2 mL/s, a removing-liquid-discharging nozzle was moved from an outer periphery toward the center portion of the silicon wafer to a position with 3 mm at a speed of 5 mm/s, and the removing liquid was further discharged at this position at a discharge amount of 2 mL/s for 5 seconds. Thereafter, discharge of the discharging liquid was stopped, and the silicon wafer was further rotated at a speed of 1000 rpm for 30 seconds. Then, this silicon wafer was heated at 350°C for 60 seconds to obtain a silicon wafer on which the organic film (the organic cured film) of each Example was formed.

### Evaluation of Solvent Resistance: Examples 1-1 to 1-77 and Comparative Examples 1-1 to 1-16

An organic film was formed by the above method by using each of the compositions for forming an organic film (UDL-1 to 77 and Comparative UDL 1-1 to 1-16) on a silicon wafer, and the film thickness was measured. Then, PGMEA solvent was dispensed on each of the organic films, left for 30 seconds, spin-dried, baked at 100°C for 60 seconds to evaporate PGMEA, and the film thickness was measured. The film thickness before dispensing the PGMEA solvent was defined as X and the film thickness after dispensing the PGMEA solvent was defined as X₁, and an absolute value of a value determined by {(X₁-X)/X}×100 was specified as a film thickness changing rate (%). A case where the film thickness change rate was less than 0.5% was evaluated as "Good", and a case of 0.5% or more was evaluated as "Poor". The following Tables 6 to 10 show the results.

### Evaluation of In-Plane Uniformity: Examples 1-1 to 1-77 and Comparative Examples 1-1 to 1-16

An organic film was formed by the above method by using each of the compositions for forming an organic film (UDL-1 to 77 and Comparative UDL 1-1 to 1-16) on a silicon wafer. Film thicknesses within a range from a center to 145 mm in diameter of the organic film were measured, and a value determined by {(Xₘₐₓ-Xₘᵢₙ)/X_{average}}×100, wherein Xₘₐₓ represented a maximum value of the film thickness, Xₘᵢₙ represented a minimum value of the film thickness, and X_{average} represented an average of the film thicknesses, was specified as the in-plane uniformity (%). A case where the in-plane uniformity was less than 2% was evaluated as A (Good), a case of 2% or more and less than 3% was evaluated as **B,** and a case of 3% or more was evaluated as C (Poor). Tables 6 to 10 show the results.

**[Table 6]**

| | Composition for forming organic film | Average film thickness | Solvent resistance | In-plane uniformity |
|---|---|---|---|---|
| Example 1-1 | UDL-1 | 500 nm | Good | A |
| Example 1-2 | UDL-2 | 500 nm | Good | A |
| Example 1-3 | UDL-3 | 500 nm | Good | A |
| Example 1-4 | UDL-4 | 500 nm | Good | A |
| Example 1-5 | UDL-5 | 500 nm | Good | A |
| Example 1-6 | UDL-6 | 500 nm | Good | A |
| Example 1-7 | UDL-7 | 500 nm | Good | A |
| Example 1-8 | UDL-8 | 500 nm | Good | A |
| Example 1-9 | UDL-9 | 500 nm | Good | A |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | B |
| Example 1-17 | UDL-17 | 500 nm | Good | B |
| Example 1-18 | UDL-18 | 500 nm | Good | A |
| Example 1-19 | UDL-19 | 500 nm | Good | A |
| Example 1-20 | UDL-20 | 500 nm | Good | A |

**[Table 7]**

| | Composition for forming organic film | Average film thickness | Solvent resistance | In-plane uniformity |
|---|---|---|---|---|
| Example 1-21 | UDL-21 | 500 nm | Good | A |
| Example 1-22 | UDL-22 | 500 nm | Good | A |
| Example 1-23 | UDL-23 | 500 nm | Good | A |
| Example 1-24 | UDL-24 | 500 nm | Good | A |
| Example 1-25 | UDL-25 | 500 nm | Good | A |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | A |
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |
| Example 1-36 | UDL-36 | 500 nm | Good | A |

**[Table 8]**

| | Composition for forming organic film | Average film thickness | Solvent resistance | In-plane uniformity |
|---|---|---|---|---|
| Example 1-37 | UDL-37 | 500 nm | Good | A |
| Example 1-38 | UDL-38 | 500 nm | Good | A |
| Example 1-39 | UDL-39 | 500 nm | Good | A |
| Example 1-40 | UDL-40 | 500 nm | Good | A |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Example 1-47 | UDL-47 | 500 nm | Good | A |
| Example 1-48 | UDL-48 | 500 nm | Good | A |
| Example 1-49 | UDL-49 | 500 nm | Good | A |
| Example 1-50 | UDL-50 | 500 nm | Good | A |
| Example 1-51 | UDL-51 | 500 nm | Good | A |
| Example 1-52 | UDL-52 | 500 nm | Good | A |
| Example 1-53 | UDL-53 | 500 nm | Good | A |

**[Table 9]**

| | Composition for forming organic film | Average film thickness | Solvent resistance | In-plane uniformity |
|---|---|---|---|---|
| Example 1-54 | UDL-54 | 500 nm | Good | A |
| Example 1-55 | UDL-55 | 500 nm | Good | A |
| Example 1-56 | UDL-56 | 500 nm | Good | A |
| Example 1-57 | UDL-57 | 500 nm | Good | A |
| Example 1-58 | UDL-58 | 500 nm | Good | A |
| Example 1-59 | UDL-59 | 500 nm | Good | A |
| Example 1-60 | UDL-60 | 500 nm | Good | A |
| Example 1-61 | UDL-61 | 500 nm | Good | A |
| Example 1-62 | UDL-62 | 500 nm | Good | A |
| Example 1-63 | UDL-63 | 500 nm | Good | A |
| Example 1-64 | UDL-64 | 500 nm | Good | A |
| Example 1-65 | UDL-65 | 500 nm | Good | A |
| Example 1-66 | UDL-66 | 500 nm | Good | A |
| Example 1-67 | UDL-67 | 500 nm | Good | A |
| Example 1-68 | UDL-68 | 500 nm | Good | A |
| Example 1-69 | UDL-69 | 500 nm | Good | A |
| Example 1-70 | UDL-70 | 500 nm | Good | A |
| Example 1-71 | UDL-71 | 500 nm | Good | A |
| Example 1-72 | UDL-72 | 500 nm | Good | A |

**[Table 10]**

| | Composition for forming organic film | Average film thickness | Solvent resistance | In-plane uniformity |
|---|---|---|---|---|
| Example 1-73 | UDL-73 | 500 nm | Good | A |
| Example 1-74 | UDL-74 | 500 nm | Good | A |
| Example 1-75 | UDL-75 | 500 nm | Good | A |
| Example 1-76 | UDL-76 | 500 nm | Good | A |
| Example 1-77 | UDL-77 | 500 nm | Good | A |
| Comparative Example 1-1 | Comparative UDL-1 | 500 nm | Good | A |
| Comparative Example 1-2 | Comparative UDL-2 | 500 nm | Good | A |
| Comparative Example 1-3 | Comparative UDL-3 | 500 nm | Good | A |
| Comparative Example 1-4 | Comparative UDL-4 | 500 nm | Good | A |
| Comparative Example 1-5 | Comparative UDL-5 | 500 nm | Good | A |
| Comparative Example 1-6 | Comparative UDL-6 | 500 nm | Good | A |
| Comparative Example 1-7 | Comparative UDL-7 | 500 nm | Good | A |
| Comparative Example 1-8 | Comparative UDL-8 | 500 nm | Good | A |
| Comparative Example 1-9 | Comparative UDL-9 | 500 nm | Good | A |
| Comparative Example 1-10 | Comparative UDL-10 | 500 nm | Good | A |
| Comparative Example 1-11 | Comparative UDL-11 | 500 nm | Good | C |
| Comparative Example 1-12 | Comparative UDL-12 | 500 nm | Good | C |
| Comparative Example 1-13 | Comparative UDL-13 | 500 nm | Good | C |
| Comparative Example 1-14 | Comparative UDL-14 | 500 nm | Good | C |
| Comparative Example 1-15 | Comparative UDL-15 | 500 nm | Good | C |
| Comparative Example 1-16 | Comparative UDL-16 | 500 nm | Good | C |

As shown in Tables 6 to 10, Examples 1-1 to 1-77, which used the composition for forming an organic film of the present invention, yielded the organic film having both of good solvent resistance and in-plane uniformity. Meanwhile, Comparative Examples 1-11 to 1-16 (Comparative UDL-11 to 16) among Comparative Examples 1-1 to 1-16, which used the composition containing no polymer contained in the composition for forming an organic film of the present invention, exhibited poor in-plane uniformity. Thus, investigation was made on UDL-1 to 77 and Comparative UDL-1 to 10, which exhibited both of good solvent resistance and in-plane uniformity, in the following evaluation.

### Evaluation of Hump-reducing properties: Examples 2-1 to 2-77 and Comparative Examples 2-1 to 2-10

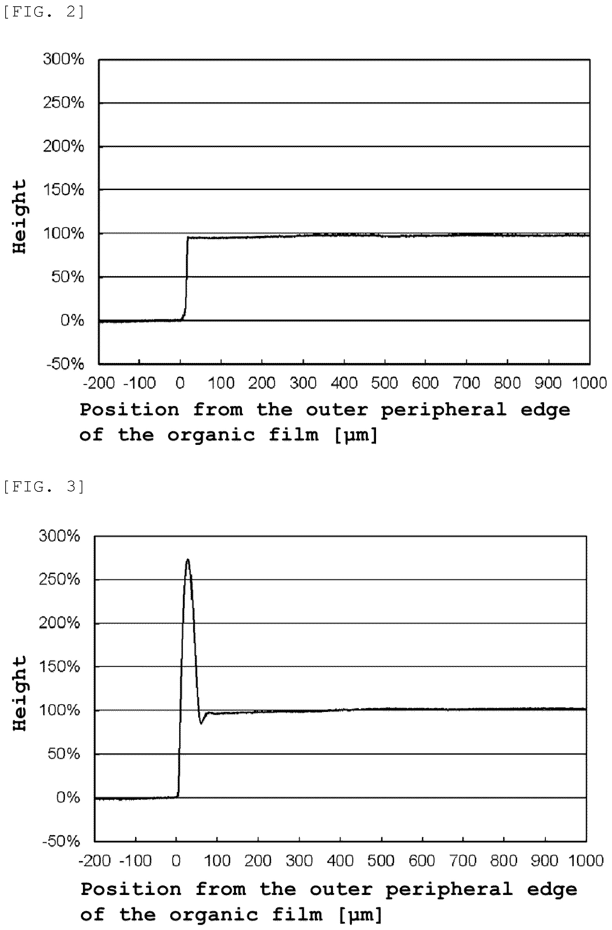

An organic film was formed by the above method by using each of the compositions for forming an organic film (UDL-1 to 77 and Comparative UDL-1 to 10) on a silicon wafer, and change in height of the organic film from an outer peripheral edge to a position of 1000 µm toward a center direction of the silicon wafer was measured by using Alpha-Step D-600 (a contact-type profiler), available form KLA-TENCOR Corporation. Based on a height of the silicon wafer being zero, a case where a maximum height was less than 110% of the film thickness as illustrated in FIG. 2 was evaluated as A (Good), a case where the maximum height was 110% or more and less than 150% was evaluated as B, and a case where a region with the height of 150% or more was generated as in FIG. 3 was evaluated as C (Poor). Tables 11 to 15 show the results.

### Filling Evaluation 1: Examples 2-1 to 2-77 and Comparative Examples 2-1 to 2-10

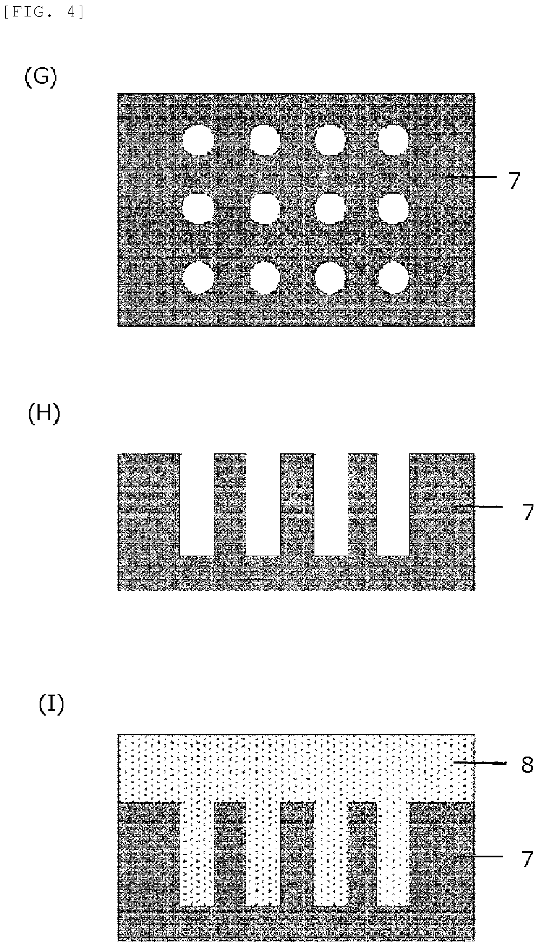

On a SiO₂ wafer substrate having a dense hole pattern (hole diameter: 0.2 µm, hole depth: 1.0 µm, and distance between centers of adjacent two holes: 0.4 µm) as illustrated in FIG. 4, a film was formed by the above method by using each of the compositions for forming an organic film (UDL-1 to 77 and Comparative UDL-1 to 10) to form an organic film 8 as illustrated in FIG. 4(I) (a sectional view). The used substrate was a base substrate (a SiO₂ wafer substrate) 7 having the dense hole pattern as illustrated in FIG. 4(G) (an overhead view) and FIG. 4(H) (a sectional view). A sectional shape of the obtained each wafer substrate was observed by using a scanning electron microscope (SEM) to check whether a gap was absent inside the holes and was filled with the organic film. If a composition for forming an organic film having poor filling properties is used, gaps are generated inside the holes. When a composition for forming an organic film having good filling properties is used, gaps are absent inside the holes as illustrated in FIG. 4(I) and filled with the organic film in this evaluation. A case where no gap was generated was evaluated as "Good", and a case where a gap was generated was evaluated as "Poor". Tables 11 to 15 show the results.

**[Table 11]**

| | Composition for forming organic film | Evaluation of hump-inhibiting properties | Evaluation of filling properties |
|---|---|---|---|
| Example 2-1 | UDL-1 | B | Good |
| Example 2-2 | UDL-2 | A | Good |
| Example 2-3 | UDL-3 | A | Good |
| Example 2-4 | UDL-4 | B | Good |
| Example 2-5 | UDL-5 | A | Good |
| Example 2-6 | UDL-6 | A | Good |
| Example 2-7 | UDL-7 | B | Good |
| Example 2-8 | UDL-8 | A | Good |
| Example 2-9 | UDL-9 | B | Good |
| Example 2-10 | UDL-10 | A | Good |
| Example 2-11 | UDL-11 | B | Good |
| Example 2-12 | UDL-12 | A | Good |
| Example 2-13 | UDL-13 | B | Good |
| Example 2-14 | UDL-14 | A | Good |
| Example 2-15 | UDL-15 | A | Good |
| Example 2-16 | UDL-16 | A | Good |
| Example 2-17 | UDL-17 | A | Good |
| Example 2-18 | UDL-18 | B | Good |
| Example 2-19 | UDL-19 | A | Good |
| Example 2-20 | UDL-20 | A | Good |

**[Table 12]**

| | Composition for forming organic film | Evaluation of hump-inhibiting properties | Evaluation of filling properties |
|---|---|---|---|
| Example 2-21 | UDL-21 | B | Good |
| Example 2-22 | UDL-22 | A | Good |
| Example 2-23 | UDL-23 | A | Good |
| Example 2-24 | UDL-24 | B | Good |
| Example 2-25 | UDL-25 | A | Good |
| Example 2-26 | UDL-26 | B | Good |
| Example 2-27 | UDL-27 | A | Good |
| Example 2-28 | UDL-28 | B | Good |
| Example 2-29 | UDL-29 | A | Good |
| Example 2-30 | UDL-30 | B | Good |
| Example 2-31 | UDL-31 | A | Good |
| Example 2-32 | UDL-32 | A | Good |
| Example 2-33 | UDL-33 | B | Good |
| Example 2-34 | UDL-34 | A | Good |
| Example 2-35 | UDL-35 | A | Good |
| Example 2-36 | UDL-36 | B | Good |

**[Table 13]**

| | Composition for forming organic film | Evaluation of hump-inhibiting properties | Evaluation of filling properties |
|---|---|---|---|
| Example 2-37 | UDL-37 | A | Good |
| Example 2-38 | UDL-38 | B | Good |
| Example 2-39 | UDL-39 | A | Good |
| Example 2-40 | UDL-40 | B | Good |
| Example 2-41 | UDL-41 | A | Good |
| Example 2-42 | UDL-42 | B | Good |
| Example 2-43 | UDL-43 | A | Good |
| Example 2-44 | UDL-44 | A | Good |
| Example 2-45 | UDL-45 | B | Good |
| Example 2-46 | UDL-46 | A | Good |
| Example 2-47 | UDL-47 | A | Good |
| Example 2-48 | UDL-48 | B | Good |
| Example 2-49 | UDL-49 | A | Good |
| Example 2-50 | UDL-50 | B | Good |
| Example 2-51 | UDL-51 | A | Good |
| Example 2-52 | UDL-52 | B | Good |
| Example 2-53 | UDL-53 | A | Good |

**[Table 14]**

| | Composition for forming organic film | Evaluation of hump-inhibiting properties | Evaluation of filling properties |
|---|---|---|---|
| Example 2-54 | UDL-54 | B | Good |
| Example 2-55 | UDL-55 | A | Good |
| Example 2-56 | UDL-56 | A | Good |
| Example 2-57 | UDL-57 | B | Good |
| Example 2-58 | UDL-58 | A | Good |
| Example 2-59 | UDL-59 | A | Good |
| Example 2-60 | UDL-60 | B | Good |
| Example 2-61 | UDL-61 | A | Good |
| Example 2-62 | UDL-62 | B | Good |
| Example 2-63 | UDL-63 | A | Good |
| Example 2-64 | UDL-64 | B | Good |
| Example 2-65 | UDL-65 | A | Good |
| Example 2-66 | UDL-66 | B | Good |
| Example 2-67 | UDL-67 | A | Good |
| Example 2-68 | UDL-68 | A | Good |
| Example 2-69 | UDL-69 | B | Good |
| Example 2-70 | UDL-70 | A | Good |
| Example 2-71 | UDL-71 | A | Good |
| Example 2-72 | UDL-72 | B | Good |

**[Table 15]**

| | Composition for forming organic film | Evaluation of hump-inhibiting properties | Evaluation of filling properties |
|---|---|---|---|
| Example 2-73 | UDL-73 | A | Good |
| Example 2-74 | UDL-74 | B | Good |
| Example 2-75 | UDL-75 | A | Good |
| Example 2-76 | UDL-76 | B | Good |
| Example 2-77 | UDL-77 | A | Good |
| Comparative Example 2-1 | Comparative UDL-1 | C | Poor |
| Comparative Example 2-2 | Comparative UDL-2 | C | Poor |
| Comparative Example 2-3 | Comparative UDL-3 | C | Poor |
| Comparative Example 2-4 | Comparative UDL-4 | C | Poor |
| Comparative Example 2-5 | Comparative UDL-5 | C | Poor |
| Comparative Example 2-6 | Comparative UDL-6 | C | Poor |
| Comparative Example 2-7 | Comparative UDL-7 | C | Poor |
| Comparative Example 2-8 | Comparative UDL-8 | C | Poor |
| Comparative Example 2-9 | Comparative UDL-9 | C | Poor |
| Comparative Example 2-10 | Comparative UDL-10 | A | Poor |

As shown in Tables 11 to 15, it was confirmed that Examples 2-1 to 2-77, which used the composition for forming an organic film (UDL-1 to 77) of the present invention, had excellent solvent resistance, in-plane uniformity, hump-reducing properties, and filling properties.

Meanwhile, Comparative Examples 2-1 to 2-9 exhibited C (Poor) in the hump-reducing properties evaluation, and also poor in the filling properties evaluation. Comparative Example 2-10 exhibited A (Good) in the hump properties, but C (Poor) in the filling properties evaluation.

### Patterning Test: Examples 3-1 to 3-77

An organic cured film was formed on a SiO₂ wafer substrate by using each of the compositions for forming an organic film (UDL-1 to 77) by the above method (baking at 350°C), the following silicon-containing resist middle film material (SOG 1) was applied thereon, and the film was baked at 200°C for 60 seconds to form a silicon-containing resist middle film with 35 nm in film thickness. The following single-layer resist for ArF was applied thereon as a resist upper layer film material, and baked at 105°C for 60 seconds to form a photoresist film with 100 nm in film thickness. The following immersion protective film material (TC-1) was applied on the photoresist film, and baked at 90°C for 60 seconds to form a protective film with 50 nm in film thickness.

A 2% solution of the following polymer in propylene glycol ethyl ether was prepared as the silicon-containing resist middle film material (SOG 1).

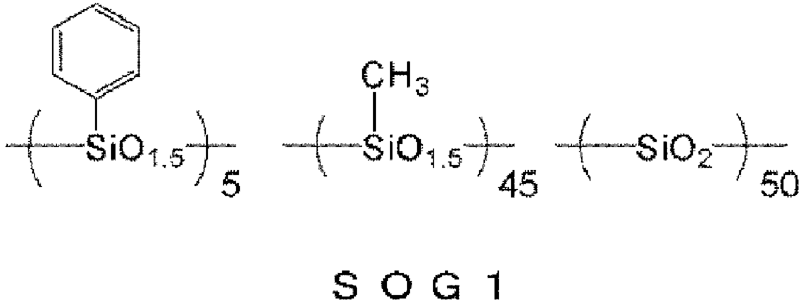

The resist upper layer film material (the single-layer resist for ArF) was prepared by: dissolving a polymer (RP 1), an acid generator (PAG 1), and a basic compound (Amine 1) in a solvent (PGMEA) containing 0.1 mass% of FC-430 (available from Sumitomo 3M Limited.) at a proportion in Table 16; and filtering the solution with a 0.1-µm filter made of a fluororesin.

**[Table 16]**

| | Polymer (parts by mass) | Acid generator (parts by mass) | Basic compound (parts by mass) | Solvent (parts by mass) |
|---|---|---|---|---|
| Single-layer resist for ArF | RP 1 (100) | PAG 1 (6.6) | Amine 1 (0.8) | PGMEA (2500) |

The polymer (RP 1), the acid generator (PAG 1), and the basic compound (Amine 1) are shown below.

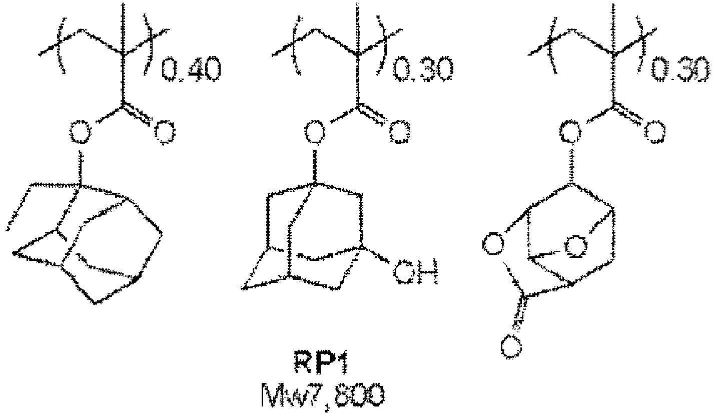

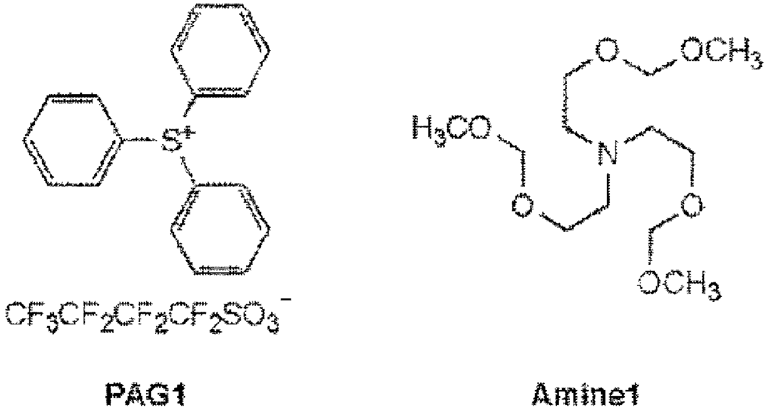

The immersion protective film material (TC-1) was prepared by: dissolving a polymer (PP 1) in an organic solvent at a proportion in Table 17; and filtering the solution with a 0.1-µm filter made of a fluororesin.

**[Table 17]**

| | Polymer (parts by mass) | Organic solvent (parts by mass) |
|---|---|---|
| TC-1 | PP 1 (100) | Diisoamyl ether (2700) |
| | | 2-Methyl-1-butanol (270) |

The polymer (PP 1) is shown below.

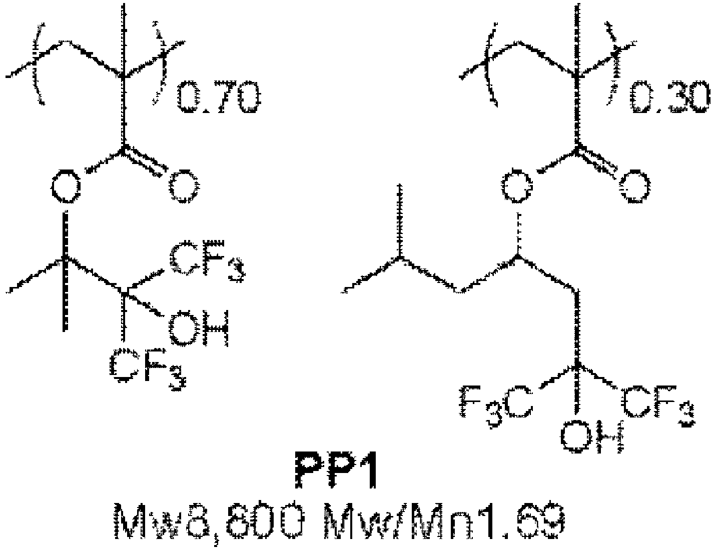

Then, the film was exposed with an ArF immersion exposure device (available from NIKON CORPORATION; NSR-S610C, NA 1.30, σ 0.98/0.65, 35°-dipole s-polarized illumination, 6% halftone phase-shifting mask), baked at 100°C for 60 seconds (PEB), and developed with a 2.38 mass% aqueous solution of tetramethylammonium hydroxide (TMAH) for 30 seconds to obtain a positive line-and-space pattern of 1:1 with 55 nm (a resist upper layer film pattern).

Then, while using the resist upper layer film pattern as a mask, the silicon-containing resist middle film was processed by dry etching (pattern-transferred) using an etching apparatus "Telius", available from Tokyo Electron Ltd., to obtain a silicon-containing resist middle film pattern. While using the obtained silicon-containing resist middle film pattern as a mask, the organic film was processed by dry etching (pattern-transferred) to obtain an organic film pattern. While using the obtained organic film pattern as a mask, the SiO₂ wafer substrate (the SiO₂ film) was processed by dry etching (pattern-transferred). The etching conditions were as follows.

### (Transferring Conditions of Resist Upper Layer Film Pattern to Silicon-Containing Resist Middle Film)

Chamber pressure: 10.0 Pa
RF power: 1,500 W
CF₄ gas flow rate: 75 mL/min.
O₂ gas flow rate: 15 mL/min.
Time: 15 sec.

### (Transferring Conditions of Silicon-Containing Resist Middle Film Pattern to Organic Film)

Chamber pressure: 2.0 Pa
RF power: 500 W
Ar gas flow rate: 75 mL/min.
O₂ gas flow rate: 45 mL/min.
Time: 120 sec.

### (Transferring Conditions of Organic Film Pattern to SiO₂ Wafer Substrate)

Chamber pressure: 2.0 Pa
RF power: 2,200 W
C₅F₁₂ gas flow rate: 20 mL/min.
C₂F₆ gas flow rate: 10 mL/min.
Ar gas flow rate: 300 mL/min.
O₂ gas flow rate: 60 mL/min.
Time: 90 sec.

Tables 18 to 22 show the results of observing a cross section of the obtained pattern with an electron microscope (S-4700), available from Hitachi, Ltd.

**[Table 18]**

| | Composition for forming organic film | Shape after transferring etching on substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |

**[Table 19]**

| | Composition for forming organic film | Shape after transferring etching on substrate |
|---|---|---|
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |

**[Table 20]**

| | Composition for forming organic film | Shape after transferring etching on substrate |
|---|---|---|
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |

**[Table 21]**

| | Composition for forming organic film | Shape after transferring etching on substrate |
|---|---|---|
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |
| Example 3-60 | UDL-60 | Good |
| Example 3-61 | UDL-61 | Good |
| Example 3-62 | UDL-62 | Good |
| Example 3-63 | UDL-63 | Good |
| Example 3-64 | UDL-64 | Good |
| Example 3-65 | UDL-65 | Good |
| Example 3-66 | UDL-66 | Good |
| Example 3-67 | UDL-67 | Good |
| Example 3-68 | UDL-68 | Good |
| Example 3-69 | UDL-69 | Good |
| Example 3-70 | UDL-70 | Good |
| Example 3-71 | UDL-71 | Good |
| Example 3-72 | UDL-72 | Good |

**[Table 22]**

| | Composition for forming organic film | Shape after transferring etching on substrate |
|---|---|---|
| Example 3-73 | UDL-73 | Good |
| Example 3-74 | UDL-74 | Good |
| Example 3-75 | UDL-75 | Good |
| Example 3-76 | UDL-76 | Good |
| Example 3-77 | UDL-77 | Good |

As shown in Tables 18 to 22, all Examples 3-1 to 3-77, which used the composition for forming an organic film of the present invention (UDL-1 to 77) favorably and finally transferred the resist upper layer film pattern to the SiO₂ wafer substrate, and it was confirmed that the composition for forming an organic film of Example of the present invention was suitably used in fine processing with the multilayer resist method.

From the above, it is understood that the composition for forming an organic film of the present invention has excellent film formability, high filling properties, and excellent hump-reducing properties, and is thereby extremely useful as the organic film material used in the multilayer resist process. In addition, the patterning process of the present invention using the composition for forming an organic film of the present invention can fill holes and trenches having an extremely high aspect ratio without a gap, can form a fine pattern with high accuracy, and can form the organic film with inhibited humps. Therefore, semiconductor devices, etc. can be efficiently produced.

The present specification includes the following aspects.
[1]: A polymer, comprising a repeating unit represented by the following formula (B1), 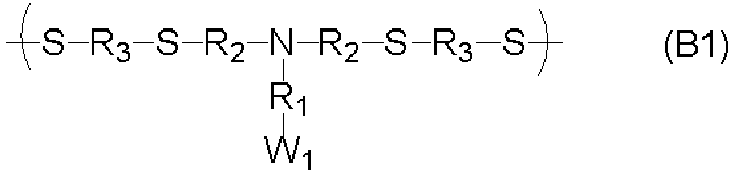 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 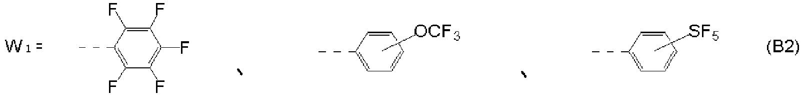 wherein a broken line represents an attachment point to R₁ in the formula (B1), and one of structures represented by the formula (B2) may be contained, or two or more of the structures may be contained.
[2]: The polymer according to [1], wherein R₃ in the (B1) represents a group represented by the following formula (B3), 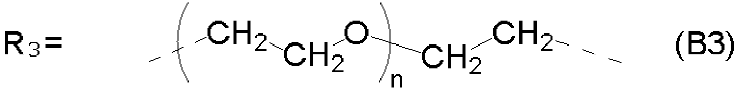 wherein a broken line represents an attachment point to a sulfur atom in the formula (B1), "n" represents 1 to 6, and one of structures represented by the formula (B3) may be contained, or two or more of the structures may be contained.
[3]: The polymer according to [1] or [2], wherein the polymer having the repeating unit represented by the formula (B1) is preferably a polymer represented by any one of the following general formulae (B4) to (B6), 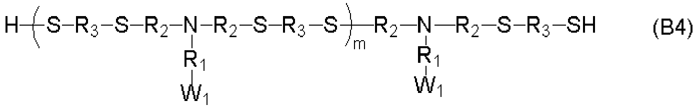 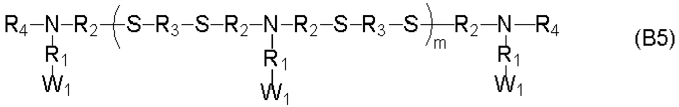 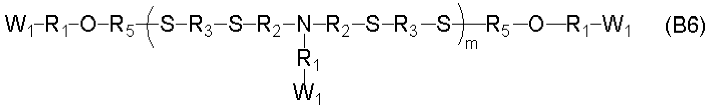 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.
[4]: The polymer according to any one of [1] to [3], wherein the polymer has a weight-average molecular weight of 1000 to 30000.
[5]: A composition for forming an organic film, comprising:
   (A) a material for forming an organic film;
   (B) a polymer comprising a repeating unit represented by the following formula (B1); and
   (C) a solvent, 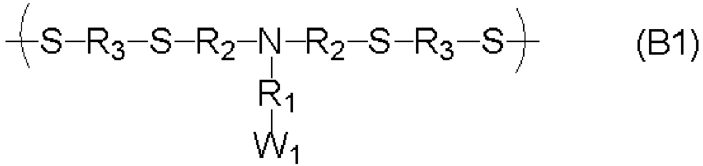 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 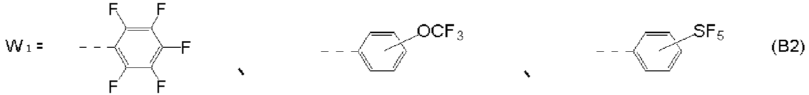 wherein a broken line represents an attachment point to R₁ in the formula (B1), and one of structures represented by the formula (B2) may be contained, or two or more of the structures may be contained.
[6]: The composition for forming an organic film according to [5], wherein R₃ in the formula (B1) represents a group represented by the following formula (B3), 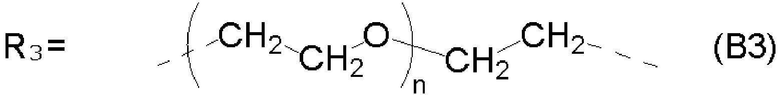 wherein a broken line represents an attachment point to a sulfur atom in the formula (B1), "n" represents 1 to 6, and one of structures represented by the formula (B3) may be contained, or two or more of the structures may be contained.
[7]: The composition for forming an organic film according to [5] or [6], wherein (B) the polymer comprises one or more compounds represented by any one of the following general formulae (B4) to (B6), 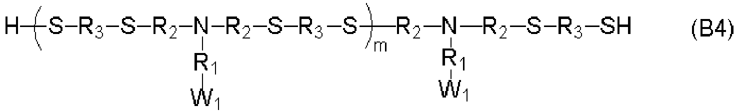 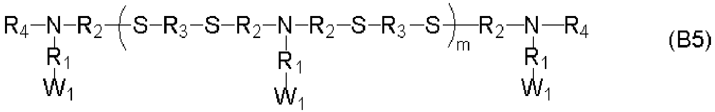 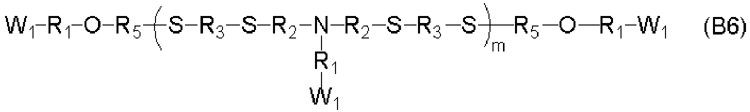 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.
[8]: The composition for forming an organic film according to any one of [5] to [7], wherein the component (B) has a weight-average molecular weight of 1000 to 30000.
[9]: The composition for forming an organic film according to any one of [5] to [8], wherein a content of the component (B) is 0.01 part by mass to 5 parts by mass relative to a content of the material for forming an organic film (A) being 100 parts by mass.
[10]: A method for forming an organic film used in a production process of a semiconductor apparatus, the method comprising steps of:
   applying the composition for forming an organic film according to any one of [5] to [9] on a substrate to be processed by spin-coating to obtain a coating film; and
   subjecting the coating film to a thermal treatment within a range of a temperature of 100°C or higher and 600°C or lower for 10 to 600 seconds for curing to form an organic film.
[11]: A patterning process, comprising steps of:
   forming an organic film on a body to be processed by using the composition for forming an organic film according to any one of [5] to [9];
   forming a silicon-containing resist middle film on the organic film by using a silicon-containing resist middle film material;
   forming a resist upper layer film on the silicon-containing resist middle film by using a resist upper layer film material comprising a photoresist composition;
   forming a circuit pattern in the resist upper layer film, and transferring the pattern to the silicon-containing resist middle film by etching while using the resist upper layer film having the formed circuit pattern as a mask;
   transferring the pattern to the organic film by etching while using the silicon-containing resist middle film having the transferred pattern as a mask; and further
   forming the pattern on the body to be processed by etching while using the organic film having the transferred pattern as a mask.
[12]: A patterning process, comprising steps of:
   forming an organic film on a body to be processed by using the composition for forming an organic film according to any one of [5] to [9];
   forming a silicon-containing resist middle film on the organic film by using a silicon-containing resist middle film material, and forming an organic anti-reflective film or an adhesion film on the silicon-containing resist middle film;
   forming a resist upper layer film on the organic anti-reflective film or the adhesion film by using a resist upper layer film material comprising a photoresist composition, and forming a circuit pattern in the resist upper layer film;
   transferring the pattern to the organic anti-reflective film or the adhesion film and the silicon-containing resist middle film by etching while using the resist upper layer film having the formed circuit pattern as a mask;
   transferring the pattern to the organic film by etching while using the silicon-containing resist middle film having the transferred pattern as a mask; and further
   forming the pattern on the body to be processed by etching while using the organic film having the transferred pattern as a mask.
[13]: A patterning process, comprising steps of:
   forming an organic film on a body to be processed by using the composition for forming an organic film according to any one of [5] to [9];
   forming an inorganic hard mask middle film selected from the group consisting of a silicon oxide film, a silicon nitride film, and a silicon oxynitride film on the organic film;
   forming a resist upper layer film on the inorganic hard mask middle film by using a resist upper layer film material comprising a photoresist composition;
   forming a circuit pattern in the resist upper layer film;
   transferring the pattern to the inorganic hard mask middle film by etching while using the resist upper layer film having the formed circuit pattern as a mask;
   transferring the pattern to the organic film by etching while using the inorganic hard mask middle film having the transferred pattern as a mask; and further
   forming the pattern on the body to be processed by etching while using the organic film having the transferred pattern as a mask.
[14]: A patterning process, comprising steps of:
   forming an organic film on a body to be processed by using the composition for forming an organic film according to any one of [5] to [9];
   forming an inorganic hard mask middle film selected from the group consisting of a silicon oxide film, a silicon nitride film, and a silicon oxynitride film on the organic film
   forming an organic anti-reflective film or an adhesion film on the inorganic hard mask middle film, and forming a resist upper layer film on the organic anti-reflective film or the adhesion film by using a resist upper layer film material comprising a photoresist composition;
   forming a circuit pattern in the resist upper layer film;
   transferring the pattern to the organic anti-reflective film or the adhesion film and the inorganic hard mask middle film by etching while using the resist upper layer film having the formed circuit pattern as a mask;
   transferring the pattern to the organic film by etching while using the inorganic hard mask middle film having the transferred pattern as a mask; and further
   forming the pattern on the body to be processed by etching while using the organic film having the transferred pattern as a mask.
[15]: The patterning process according to [13] or [14], wherein the inorganic hard mask middle film is formed by a CVD method or an ALD method.
[16]: The patterning process according to any one of [11] to [15], wherein the circuit pattern is formed by lithography using light having a wavelength of 10 nm or longer and 300 nm or shorter, direct writing with electron beam, nanoimprinting, or a combination thereof.
[17]: The patterning process according to any one of [11] to [16], wherein, in forming the circuit pattern, the circuit pattern is developed with alkaline development or an organic solvent.
[18]: The patterning process according to any one of [11] to [17], wherein the body to be processed is a semiconductor apparatus substrate, or a substrate in which any of a metal film, a metal carbide film, a metal oxide film, a metal nitride film, a metal oxycarbide film, and a metal oxynitride film is formed on the semiconductor apparatus substrate.
[19]: The patterning process according to [18], wherein a body to be processed in which a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof is used as the body to be processed.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A polymer, comprising a repeating unit represented by the following formula (B1), 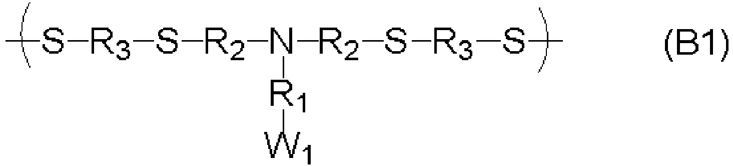 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 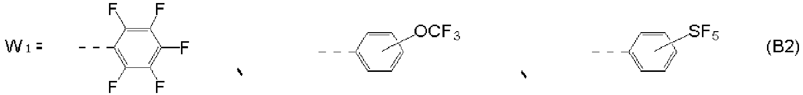 wherein a broken line represents an attachment point to R₁ in the formula (B1), and one of structures represented by the formula (B2) may be contained, or two or more of the structures may be contained.

2. The polymer according to claim 1, wherein R₃ in the (B1) represents a group represented by the following formula (B3), 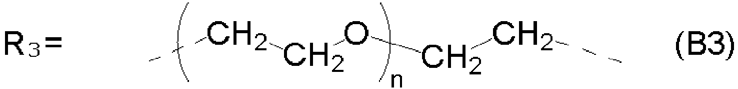 wherein a broken line represents an attachment point to a sulfur atom in the formula (B1), "n" represents 1 to 6, and one of structures represented by the formula (B3) may be contained, or two or more of the structures may be contained.

3. The polymer according to claim 1 or 2, wherein the polymer having the repeating unit represented by the formula (B1) is preferably a polymer represented by any one of the following general formulae (B4) to (B6), 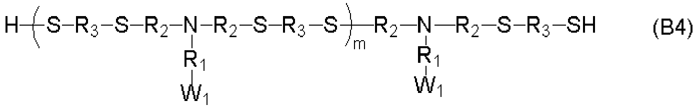 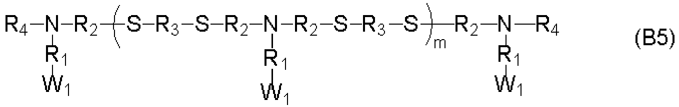 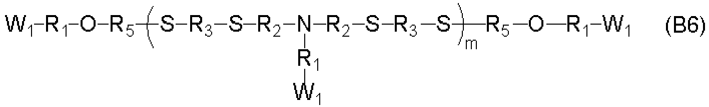 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000.

4. The polymer according to any one of claims 1 to 3, wherein the polymer has a weight-average molecular weight of 1000 to 30000.

5. A composition for forming an organic film, comprising:
(A) a material for forming an organic film;
(B) a polymer comprising a repeating unit represented by the following formula (B1); and
(C) a solvent, 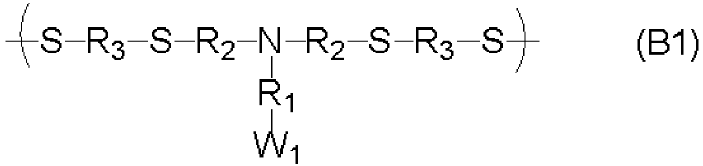 wherein R₁ represents a single bond or a divalent organic group having 1 to 6 carbon atoms, R₂ represents a divalent organic group having 1 to 6 carbon atoms, R₃ represents a divalent organic group having 1 to 30 carbon atoms and optionally having an oxygen atom, and W₁ represents a fluorine-containing group represented by the following formula (B2), 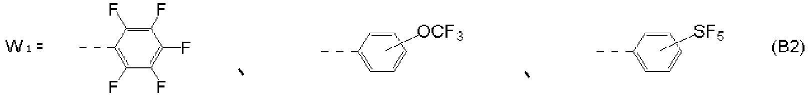 wherein a broken line represents an attachment point to R₁ in the formula (B1), and one of structures represented by the formula (B2) may be contained, or two or more of the structures may be contained,
preferably wherein the composition for forming an organic film, wherein R₃ in the formula (B1) represents a group represented by the following formula (B3), 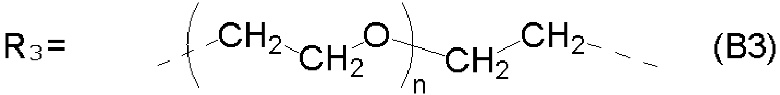 wherein a broken line represents an attachment point to a sulfur atom in the formula (B1), "n" represents 1 to 6, and one of structures represented by the formula (B3) may be contained, or two or more of the structures may be contained,
preferably wherein the composition for forming an organic film, wherein (B) the polymer comprises one or more compounds represented by any one of the following general formulae (B4) to (B6), 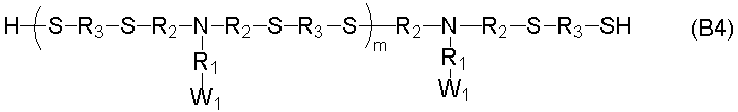 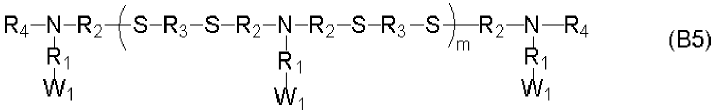 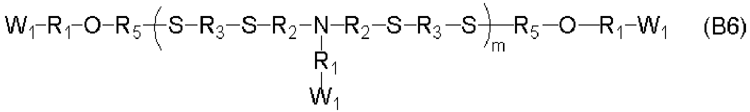 wherein R₁, R₂, and R₃ are the same as above, R₄ represents a saturated or unsaturated monovalent organic group having 1 to 30 carbon atoms, R₅ represents a divalent organic group having 1 to 6 carbon atoms, and "m" represents an average number of repeating units, and 3 to 2,000, and
preferably wherein the composition for forming an organic film, wherein the component (B) has a weight-average molecular weight of 1000 to 30000.

6. The composition for forming an organic film according to claim 5, wherein a content of the component (B) is 0.01 part by mass to 5 parts by mass relative to a content of the material for forming an organic film (A) being 100 parts by mass.

7. A method for forming an organic film used in a production process of a semiconductor apparatus, the method comprising steps of:
applying the composition for forming an organic film according to claim 5 or 6 on a substrate to be processed by spin-coating to obtain a coating film; and
subjecting the coating film to a thermal treatment within a range of a temperature of 100°C or higher and 600°C or lower for 10 to 600 seconds for curing to form an organic film.

8. A patterning process, comprising steps of:
forming an organic film on a body to be processed by using the composition for forming an organic film according to claim 5 or 6;
forming a silicon-containing resist middle film on the organic film by using a silicon-containing resist middle film material;
forming a resist upper layer film on the silicon-containing resist middle film by using a resist upper layer film material comprising a photoresist composition;
forming a circuit pattern in the resist upper layer film, and transferring the pattern to the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

9. A patterning process, comprising steps of:
forming an organic film on a body to be processed by using the composition for forming an organic film according to claim 5 or 6;
forming a silicon-containing resist middle film on the organic film by using a silicon-containing resist middle film material, and forming an organic anti-reflective film or an adhesion film on the silicon-containing resist middle film;
forming a resist upper layer film on the organic anti-reflective film or the adhesion film by using a resist upper layer film material comprising a photoresist composition, and forming a circuit pattern in the resist upper layer film;
transferring the pattern to the organic anti-reflective film or the adhesion film and the silicon-containing resist middle film by etching while using the resist upper layer film having the formed circuit pattern as a mask;
transferring the pattern to the organic film by etching while using the silicon-containing resist middle film having the transferred pattern as a mask; and further
forming the pattern on the body to be processed by etching while using the organic film having the transferred pattern as a mask.

10. A patterning process, comprising steps of:
forming an organic film on a body to be processed by using the composition for forming an organic film according to claim 5 or 6;
forming an inorganic hard mask middle film selected from the group consisting of a silicon oxide film, a silicon nitride film, and a silicon oxynitride film on the organic film;
forming a resist upper layer film on the inorganic hard mask middle film by using a resist upper layer film material comprising a photoresist composition;
forming a circuit pattern in the resist upper layer film;
transferring the pattern to the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask,
preferably wherein the patterning process, wherein the inorganic hard mask middle film is formed by a CVD method or an ALD method.

11. A patterning process, comprising steps of:
forming an organic film on a body to be processed by using the composition for forming an organic film according to any one of claims 5 to 9;
forming an inorganic hard mask middle film selected from the group consisting of a silicon oxide film, a silicon nitride film, and a silicon oxynitride film on the organic film
forming an organic anti-reflective film or an adhesion film on the inorganic hard mask middle film, and forming a resist upper layer film on the organic anti-reflective film or the adhesion film by using a resist upper layer film material comprising a photoresist composition;
forming a circuit pattern in the resist upper layer film;
transferring the pattern to the organic anti-reflective film or the adhesion film and the inorganic hard mask middle film by etching while using the resist upper layer film having the formed circuit pattern as a mask;
transferring the pattern to the organic film by etching while using the inorganic hard mask middle film having the transferred pattern as a mask; and further
forming the pattern on the body to be processed by etching while using the organic film having the transferred pattern as a mask,
preferably wherein the patterning process, wherein the inorganic hard mask middle film is formed by a CVD method or an ALD method.

12. The patterning process according to any one of claims 8 to 11, wherein the circuit pattern is formed by lithography using light having a wavelength of 10 nm or longer and 300 nm or shorter, direct writing with electron beam, nanoimprinting, or a combination thereof.

13. The patterning process according to any one of claims 8 to 12, wherein, in forming the circuit pattern, the circuit pattern is developed with alkaline development or an organic solvent.

14. The patterning process according to any one of claims 8 to 13, wherein the body to be processed is a semiconductor apparatus substrate, or a substrate in which any of a metal film, a metal carbide film, a metal oxide film, a metal nitride film, a metal oxycarbide film, and a metal oxynitride film is formed on the semiconductor apparatus substrate.

15. The patterning process according to claim 14, wherein a body to be processed in which a metal to constitute the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof is used as the body to be processed.
